# EUROPÄISCHE PATENTSCHRIFT

(11) **EP 2 785 521 B1**
(45) Veröffentlichungstag und Bekanntmachung des Hinweises auf die Patenterteilung: **01.09.2021**
(21) Anmeldenummer: 12778612.7
(22) Anmeldetag: 28.09.2012
(51) Int. Cl.: B30B 7/02, B81B 7/00, G02B 5/02, G02B 26/08, B81C 1/00, B29D 11/00

(54) **VERFAHREN ZUR HERSTELLUNG STRUKTURIERTER OPTISCHER KOMPONENTEN**
METHOD FOR PRODUCING STRUCTURED OPTICAL COMPONENTS
PROCÉDÉ POUR LA PRODUCTION DE COMPOSANTS OPTIQUES STRUCTURÉS

(30) Priorität: 29.11.2011 DE 102011119610
(43) Veröffentlichungstag der Anmeldung: 08.10.2014
(73) Patentinhaber: Fraunhofer Gesellschaft zur Förderung der angewandten Forschung e.V., 80686 München (DE)
(72) Erfinder: QUENZER, Hans Joachim, 25524 Itzehoe (DE); HOFMANN, Ulrich, 25524 Itzehoe (DE); STENCHLY, Vanessa, 25704 Meldorf (DE)
(86) Internationale Anmeldenummer: PCT/EP2012/004105
(87) Internationale Veröffentlichungsnummer: WO 2013/079131

(56) Entgegenhaltungen:
- EP-A2- 1 748 029
- DE-A1- 4 026 046
- DE-A1-102008 012 384
- DE-A1-102008 042 106
- US-A1- 2003 036 249
- US-A1- 2008 174 907

## Beschreibung

### Technisches Gebiet

Die Erfindung betrifft ein Verfahren zur Herstellung von strukturierten optischen Komponenten, insbesondere Deckeln zur Verkapselung von Mikro-Systemen, die insbesondere eine optische Funktion zu erfüllen haben.

Ein Deckel zur Verkapselung von Mikro-Systemen (z.B. MOEMS, MEMS), die üblicherweise auf einem Trägersubstrat angeordnet sind, soll in der Regel mindestens einen Schutz gegen Verunreinigungen bieten und gleichzeitig die mechanische und/oder optische Funktionalität der Mikro-Systeme nicht beeinträchtigen. Sollte die Funktionalität der Mikro-Systeme nicht nur auf Bewegungen in der beziehungsweise parallel zur Trägersubstratebene beschränkt sein, sondern auch Bewegungen senkrecht zur Trägersubstratebene vorsehen, muss ein Deckel den Mikro-Systemen üblicherweise entsprechende Bewegungsfreiheit gewährleisten. Dies erfordert Strukturierungsverfahren, die z.B. eine hohe Oberflächenqualität der optisch funktionalen Bereiche ermöglicht.

### Stand der Technik

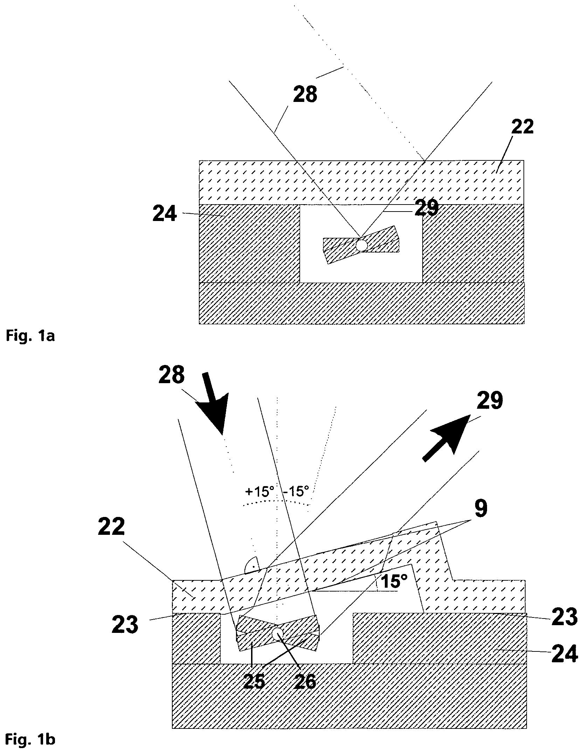

Sollen die Mikro-Systeme eine optische Funktion ausüben oder sollen bestimmte Parameter oder physikalische Größen der Mikro-Systeme optisch gemessen werden - beispielsweise Bestimmung der Auslenkung mittels Interferometer oder durch Auswertung von Videosequenzen - dann bedarf es in der Regel eines optisch transparenten Deckels. (Fig. 1a)

In der WO 2004/1068665 wird ein Wafer-Level-Packaging-Verfahren für MOEMS beschrieben, welches einen Deckel aus Glas vorsieht. Vor dem Verkapselungsprozess wird der Trägerwafer mit den MOEMS allerdings vereinzelt. Die daraus resultierenden separaten ungekapselten Chips (DIEs) werden auf einem neuen Substrat platziert, montiert, kontaktiert und erst anschließend gekapselt. Vertiefungen im Deckel können mit bekannten Präge- und Ätzverfahren und/oder durch den Einsatz von Abstandshaltern, zum Beispiel aus Silizium, erzeugt werden.

In der US6146917 wird ein Wafer-Level-Packaging-Verfahren für MEMS/MOEMS beschrieben, bei dem ein mit Vertiefungen versehener Deckelwafer aus Silizium oder Glas durch Fusions-Bonden oder Anodisches Bonden mit dem Trägerwafer verbunden wird, woraus ein hermetisch dichtes Gehäuse resultiert. Die Herstellung der erforderlichen 50 bis 150 µm tiefen Vertiefungen im Deckelwafer aus Silizium kann durch naßchemisches Ätzen mittels KOH-Lösung erfolgen.

In der US2005/0184304 wird ein Wafer-Level-Packaging-Verfahren zur Verkapselung von oberflächenmikromechanisch gefertigten Mikrospiegel-Arrays vorgestellt. Ein Deckelwafer aus Glas besitzt Vertiefungen, die als optische Fenster dienen und auch über entsprechende Vergütungsschichten verfügen können. Die Vertiefungen im Deckelwafer können Tiefen von über 100 µm aufweisen und werden mit gängigen Formgebungsverfahren, wie zum Beispiel Ätzen, Gießen oder Prägen, oder durch den Einsatz von Abstandshaltern erzeugt.

Allen aufgeführten Schriften ist gemein, dass die optischen Fenster des Deckels parallel zur Substratebene des Trägersubstrats (Trägersubstratebene), insbesondere Trägerwafers, und damit zu den darauf angeordneten MEMS/MOEMS ausgeführt sind. Im Stand der Technik werden des Weiteren Deckel mit Vertiefungen, die durch zur Trägersubstratebene geneigt ausgeführte optische Fenster begrenzt sind, beschrieben.

Wie in der WO2007/069165 und in der US 7,948,667 beschrieben, kann durch geneigte optische Fenster eine Reflexionsausblendung (Fig. 1b) erreicht werden.

Nach der US2007/0024549A1 können auch Deckel mit geneigten optischen Fenstern gefertigt werden, die eine Verkapselung auf Wafer-Ebene ermöglichen. Die Formgebung des Deckels beziehungsweise die Realisierung der erforderlichen Vertiefungen erfolgt mit bekannten Präge- und Formgebungsverfahren.

Zu solchen Formgebungsverfahren zählen beispielsweise das Glastiefziehen und das Blankpressen. Insbesondere das Bankpressen wird auch zur Herstellung optischer Komponenten, wie zum Beispiel Linsen, eingesetzt; (siehe Bernd Bresseler, "Mikroproduktion - Der Werkzeugbau als Maß der Dinge" auf der Internetseite http://www.aixtooling.de/index.html?content=/deutsch/aktuelles/aktuelles.html sowie John Deegan Rochester Precision Optics "Precision Glass Molding Technical Brief" auf der Internetseite http:/lwww.rpoptics.com/Precision%20Glass%20Molding%20Technical%20Brief_2.pdf)*.*

Optische Komponenten, die ebene beziehungsweise planparallelen Flächen aufweisen, wie zum Beispiel Spiegel beziehungsweise teildurchlässige Spiegel sowie Strahlteiler (Druckschriften Chuan Pu, Zuhua Zhu and Yu-Hwa Lo "Surface Micromachined Integrated Optic Polarization Beam Splitter"; IEEE PHOTONICS TECHNOLOGY LETTERS, Vol. 10, NO. 7, JULY 1998 sowie Lih Y. Lin and Evan L. Goldstein "Micro-Electro-Mechanical Systems (MEMS) for WDM Optical-Crossconnect Networks", IEEE 1999) werden in der Mikrosystemtechnik üblicherweise aus Silizium hergestellt. So lassen sich beispielsweise durch anisotrope nasschemische Ätzprozesse, zum Beispiel mittels KOH, geneigte Spiegel realisieren (Druckschrift Jenq-Yang Chang, Chih-Ming Wang, Chien-Chieh Lee, Hsi-Fu Shih and Mount-Learn Wu "Realization of Free-Space Optical Pickup Head With Stacked Si-Based Phase Elements"; IEEE PHOTONICS TECHNOLOGY LETTERS).

In der Druckschrift Kyounggsik Yu, Daesung Lee, Uma Krishnamoorthy, Namkyoo Park and Olav Solgaard "Micromachined Fourier transform spectrometer on silicon optical bench platform"; Sensors and Actuators A130-131 (2006) 523-530 werden mikrooptische Strahlteiler und geneigte Spiegel ebenfalls mittels verschiedener Ätzverfahren hergestellt, wobei auf eine hohe Qualität, insbesondere auf eine geringe Rauigkeit, der optisch funktionalen Oberflächen verwiesen wird. Mittels nasschemischer KOH-Ätzung lassen sich in Silizium Oberflächen mit einer quadratischen Oberflächenrauigkeit kleiner 20 nm erreichen. Allerdings können solche Oberflächen in Standardsiliziumwafern nur mit bestimmten Neigungswinkeln, die durch die Kristallstuktur von Silizium vorgegeben sind, realisiert werden.

Die Herstellung entsprechender optischer Komponenten auf Basis von Glas, wie zum Beispiel Borsilikatglas, mittels Ätzverfahren führt in der Regel zu Oberflächen, deren Rauigkeit für optische Anwendungen nicht zufriedenstellend ist (siehe Druckschriften Xinghua Li, Takashi Abe, Masayoshi Esashi "Deep reactive ion etching of Pyrex glass using SF6 plasma", Sensors and Actuators A87, 2001, pp. 139-145 sowie Ciprian Iliescu, Kwong Luck Tan, Francis E. H. Tay, Jianmin Miao "Deep Wet and Dry Etching of Pyrex Glass: A Review").

Ein Verfahren zur Herstellung von optischenKomponenten, insbesondere von Deckeln mit geneigten optischen Fenstern, wird zudem in der DE102008012384 beschrieben. Durch den Einsatz von Verstärkungselementen und mittels Glasfließens lassen sich die als optische Fenster fungierenden Bereiche geschützt und stabilisiert neigen, wodurch sich qualitativ hochwertige geneigte bzw. verschobene optische Fenster realisieren lassen. Ein Nachteil des Verfahrens besteht darin, dass die Realisierung der Verstärkungselemente mit einem relativ hohen Materialaufwand verbunden ist, da große Bereiche der Ausgangsschicht durch Ätzprozesse entfernt werden müssen.

### Beschreibung

Der vorliegenden Erfindung liegt daher die Aufgabe zugrunde, die Nachteile des Standes der Technik zu überwinden und ein kostengünstiges und flexibleres Verfahren zur Herstellung optischer Komponenten, insbesondere Deckeln, mit verschobenen und/oder geneigten Bereichen und hoher Oberflächenqualität bereitzustellen.

Gemäß der vorliegenden Erfindung wird die Aufgabe durch ein Verfahren nach Anspruch 1 beziehungsweise ein Verfahren nach Anspruch 2 zur Herstellung optischer Komponenten, insbesondere eines Deckels, gelöst.
Die Unteransprüche lehren vorteilhafte Weiterbildungen.

Die erfindungsgemäßen Verfahren nach Anspruch 1 und Anspruch 2 dienen der Herstellung optischer Komponenten, bei denen ein bestimmte/r Bereich/e beziehungsweise Flächen, insbesondere Oberflächen, geneigt und/oder verschoben in Bezug auf mindestens eine Substratebene des ersten Substrats ausgeführt sind. Die optische Komponente weist mindestens ein optisches Element wie zum Beispiel ein optisches Fenster, einen Spiegel beziehungsweise teildurchlässigen Spiegel, einen Strahlteiler, ein Prisma und/oder einen Interferenzfiltern auf, oder die optische Komponente besteht aus mindestens einem optischen Element. Die Oberfläche/n eines optischen Fensters, durch die die in der Anwendung eingesetzte Strahlung in das optische Fenster einfällt und/oder wieder ausgekoppelt wird, stellen die Transmissionsfläche/n eines optischen Fensters dar.

Die erfindungsgemäßen Verfahren können beispielsweise zur Herstellung eines Deckels mit einem oder mehreren optischen Fenstern zur Verkapselung von Mikro-Systemen, die insbesondere eine optische Funktion zu erfüllen haben und üblicherweise auf einem Trägersubstrat aufgebracht oder angeordnet sind, verwendet werden. Häufig findet als Trägersubstrat ein Siliziumwafer Anwendung, auf dem durch oberflächenmikromechanische oder volumenmikromechanische Prozesse die zu verkapselnden Mikro-Systeme (z.B. MEMS, MOEMS) erzeugt werden.

Das erfindungsgemäße Verfahren nach Anspruch 1 zur Herstellung optischer Komponenten, weist die folgenden Verfahrensschritte auf:
- Bereitstellen eines ersten Substrats und eines zweiten Substrats,
- Bereitstellen mehrerer Verstärkungselemente durch Abtrennen von einem oder mehreren Verstärkungssubstraten,
- Erzeugen eines Stapels durch Anordnen der Verstärkungselemente auf dem ersten Substrat, wodurch jedes Verstärkungselement einen Bereich des ersten Substrats abdeckt, wobei das Anordnen eines Verstärkungselements nach dem Bereitstellen des jeweiligen Verstärkungselements erfolgt,
- in Kontakt bringen des zweiten Substrats mit dem Stapel,
- Erwärmen und Verformen des ersten Substrats derart, dass sich zumindest ein Teil des durch das jeweilige Verstärkungselement abgedeckten Bereichs des ersten Substrats verschiebt und/oder neigt.

Eine an das erfindungsgemäße Verfahren nach Anspruch 1 angelehnte Alternative stellt das erfindungsgemäße Verfahren nach Anspruch 19 dar, welches ebenfalls zur Herstellung optischer Komponenten dient und die folgenden Vefahrensschritte aufweist:
- Bereitstellen eines ersten Substrats und eines zweiten Substrats,
- Bereitstellen mindestens eines Verstärkungselements durch Abtrennen von einem Verstärkungssubstrat,
- Erzeugen eines Stapels durch Anordnen des mindestens einen Verstärkungselements auf dem ersten Substrat derart, dass das Verstärkungselement einen Bereich des ersten Substrats abdeckt und dass zumindest ein Teil des Verstärkungselements beabstandet zum ersten Substrat angeordnet wird,
- in Kontakt bringen des zweiten Substrats mit dem Stapel,
- Erwärmen und Verformen des ersten Substrats derart, dass ein Bereich des ersten Substrats mit dem beabstandet angeordneten Teil des mindestens einen Verstärkungselements in Kontakt gebracht wird.

Das erste Substrat stellt das Ausgangs- beziehungsweise Basissubstrat für die optische Komponente dar. Um eine hohe Qualität der optischen Komponente, insbesondere der Oberflächen, zu gewährleisten, sind die beiden Substratseiten des ersten Substrats bzw. deren Oberflächen, die die Ausgangsflächen z.B. für ein optisches Fenster bzw. dessen Transmissionsflächen darstellen, bevorzugt poliert ausgeführt. Entsprechend weisen die beiden Substratseiten bevorzugt eine quadratische Oberflächenrauigkeit kleiner gleich 25nm, bevorzugt kleiner gleich 15nm, besonders bevorzugt kleiner gleich 5nm auf.

Vorzugsweise sind die beiden Substratseiten des ersten Substrats eben (planar) und/oder zueinander planparallel ausgeführt.

Um optischen Qualitätsansprüchen gerecht zu werden, weisen die beiden Substratseiten des ersten Substrats bevorzugt eine Ebenheitsabweichung kleiner einem Viertel der Wellenlänge der in der Anwendung eingesetzten elektromagnetischen Strahlung auf, wobei besonders bevorzugt Wellenlängen vom ultravioletten bis in den infraroten Wellenlängenbereich (zum Beispiel zwischen etwa 200 nm und etwa 15 µm) Anwendung finden. Demzufolge sind bei längerwelligem Licht, zum Beispiel mit einer Wellenlänge von 720 nm, Werte für die Ebenheitsabweichung kleiner 180 nm von Vorteil. Bei Verwendung von kürzerwelligem Licht mit Wellenlängen unter 440 nm steigen die Anforderungen an die Substratseiten, so dass Werte für die Ebenheitsabweichung kleiner 110 nm bevorzugt werden.

Die Planparallelitätsabweichung der beiden Substratseiten des ersten Substrats weisen bevorzugt Werte kleiner 10 µm auf.

Mit solchen Oberflächeneigenschaften bietet das erste Substrat beste Voraussetzungen für eine optische Komponente, die beispielsweise geringere Abweichungen und eine geringere Strahlaufweitung des optischen Strahlenverlaufs, was zu einer geringeren Verfälschung der optischen Signale führt, verursacht.

Die Werte für die Ebenheits- und Planparallelitätsabweichung sowie für die quadratische Oberflächenrauigkeit wurden mittels interferometrischer Messmethode bestimmt. Für die Messungen wurde das Weißlicht- und Phaseninterferometer MicroMap 512 der Firma Atos oder VEECO Wyko NT 1100 der Firma Veeco verwendet.

Des Weiteren sollte das erste Substrat vorzugsweise eine homogene Materialstruktur aufweisen, um unerwünschte Brechungen und/oder Ablenkungen der Strahlung durch die aus dem ersten Substrat hergestellte optische Komponente zu vermeiden.

Eine Vielzahl von optischen Komponenten sollte zumindest in Teilbereichen, üblicherweise in ihrer Gesamtheit, für die in der Anwendung eingesetzte elektromagnetische Strahlung durchlässig sein. Bei den meisten optischen Anwendungen wird eine möglichst hohe Transparenz dieser für die in der Anwendung eingesetzte elektromagnetische Strahlung durchlässigen Bereiche gefordert, damit beispielsweise ein Laserstrahl möglichst unbeeinflusst das Mikro-System erreicht.

Entsprechend enthält das erste Substrat bevorzugt zumindest in einem Teilbereich Glas und/oder ein glasähnliches Material oder das erste Substrat besteht aus Glas und/oder einem glasähnlichen Material. Unter glasähnlichen Materialien werden erfindungsgemäß Stoffe verstanden, die wegen ihrer thermodynamischen Eigenschaften (amorpher Aufbau, Glasübergangstemperatur) Gläsern ähneln, obwohl sich ihre chemische Zusammensetzung von der der Silikatgläser unterscheidet. Als Beispiele seien hier die in der Chemie bekannten Kunstgläser oder organischen Vitroide wie Polymethylmethacrylate (PMMA), Polycarbonat und Polystyrol genannt.

Besonders bevorzugte Gläser sind Silikatgläser, insbesondere Borsilikatgläser, da Borsilikatgläser sehr chemikalien- und temperaturbeständig sind. Die Temperaturbeständigkeit und Unempfindlichkeit der Borsilikatgläser gegen plötzliche Temperaturschwankungen sind eine Folge ihres geringen Wärmeausdehnungskoeffizienten. Zudem ist der Transmissionsgrad insbesondere im für den Menschen sichtbaren Wellenlängenbereich mit über 90% sehr hoch.

Neben ein oder mehreren ersten Substraten wird mindestens ein zweites Substrat bereitgestellt.

Bevorzugt enthält das zweite Substrat zumindest in Teilbereichen ein halbleitendes Material oder das zweite Substrat besteht aus einem halbleitenden Material. Insbesondere Halbleiterwafer, bevorzugt Siliziumwafer, finden als zweites Substrat Verwendung, wodurch die ausgereiften und gut beherrschbaren Prozesse der Halbleitertechnologie, insbesondere der Siliziumtechnologie, einsetzbar sind.

Das zweite Substrat - insbesondere der Bereich/e des zweiten Substrats, der mit dem Stapel aus erstem Substrat und Verstärkungselement direkt oder indirekt (z.B. über Auflagestrukturen) in Kontakt gebracht wird - enthält vorzugsweise hochtemperaturbeständige Materialien, insbesondere Graphit, oder besteht daraus. Auf Grund einer geringen Neigung, sich mit dem ersten Substrat, insbesondere mit Glas, zu verbinden, und einer dadurch bedingten geringen Abnutzung lassen sich solche Substrate mehrfach benutzen beziehungsweise über einen längeren Zeitraum einsetzen (längere Standzeit).

Bevorzugt weist das zweite Substrat mindestens eine dritte Vertiefung auf, die vorzugsweise auf der Seite des zweiten Substrats ausgebildet ist, die mit dem Stapel aus erstem Substrat und Verstärkungselement in Kontakt gebracht wird beziehungsweise die dem Stapel aus erstem Substrat und Verstärkungselement, insbesondere dem ersten Substrat, beim Verfahrensschritt des Inkontaktbringens (des zweiten Substrats mit dem Stapel aus erstem Substrat und Verstärkungselement) und/oder beim Verfahrensschritt des Erwärmen und Verformens zugewandt ist. Die dritte Vertiefung des zweiten Substrats ist bevorzugt zwischen etwa 100 µm und etwa 1000 µm, besonders bevorzugt einige Millimeter, tief, so dass verformungsbedingte Auslenkungen des ersten Substrats und damit insbesondere die Tiefen der ersten Vertiefungen über einen weiten Bereich variierbar sind.

In einem weiteren Verfahrensschritt wird mindestens ein Verstärkungselement durch Abtrennen von mindestens einem Verstärkungssubstrat bereitgestellt, wobei das Verstärkungssubstrat bevorzugt als Platte oder Wafer, insbesondere als Silizium- oder Glaswafer, ausgeführt ist. Dadurch lassen sich aus einem oder mehreren Verstärkungssubstraten eine Vielzahl von Verstärkungselementen herstellen und die Bearbeitungsschritte für die Gewährleistung der gewünschten Stärke bzw. Dicke der Verstärkungselemente reduzieren beziehungsweise optimieren.

In einer bevorzugten Ausführungsform enthält das Verstärkungssubstrat und/oder das mindestens eine Verstärkungselement zumindest in Teilbereichen ein halbleitendes Material oder das Verstärkungssubstrat und/oder das Verstärkungselement bestehen aus einem halbleitenden Material. Ein besonders bevorzugtes Material ist Silizium, da bei deren Verwendung die ausgereiften und gut beherrschbaren Prozesse der Halbleitertechnologie, insbesondere der Siliziumtechnologie, eingesetzt werden können. Aber auch Gläser, die einen höheren Schmelzpunkt als das erste Substrat aufweisen (z.B. hochschmelzende Gläser), sind beispielsweise als Verstärkungselement und/oder Verstärkungssubstrat geeignet. Besonders bevorzugte Materialien für das Verstärkungselement und/oder das Verstärkungssubstrat weisen einen thermischen Ausdehnungskoeffizient auf, der dem thermischen Ausdehnungskoeffizient des Materials des ersten Substrats möglichst nahe kommt beziehungsweise mit diesem möglichst identisch ist. Bevorzugt sollte die Differenz der thermischen Ausdehnungskoeffizienten kleiner gleich 5 ppm/°K, besonders bevorzugt kleiner gleich 1 ppm/°K, sein. Dadurch lassen sich mechanische Spannungen, die während des Abkühlens durch unterschiedlich starkes Zusammenziehen des ersten Substrats und des Verstärkungselements entstehen können und die zu einer Beschädigung des ersten Substrats und/oder des Verstärkungselements bzw. der optischen Komponente führen könnten, reduzieren.

Das Bereitstellen des Verstärkungselements erfolgt durch Abtrennen bzw. Heraustrennen von/aus dem Verstärkungssubstrat. Bevorzugte Trennverfahren sind Sägen, Laserschneiden beziehungsweise Laserbearbeiten, Brechen (eventuell mit vorherigem Ritzen) und/oder Ätzen. Im Vergleich zum Stand der Technik, wonach das Verstärkungselement beispielsweise durch Ätzen einer auf dem ersten Substrat abgeschiedenen Schicht und damit durch einen vergleichsweise hohen Materialabtrag erzeugt wird, kann durch einen vorzugsweise vor dem Anordnen des Verstärkungselements stattfindenden Herstellungsprozess, beispielsweise durch Sägen, Laserschneiden, Brechen oder Ätzen, das Verstärkungssubstrat und damit das Ausgangsmaterial für das Verstärkungselement wesentlich effektiver genutzt werden. Dadurch und durch die damit verbundene Einsparung von weiteren Prozessschritten, wie z.B. Lackaufbringung, Belichtung, Lackstrukturierung, Lackentfernung, lassen sich die Fertigungskosten reduzieren.

Die Herstellung der Verstärkungselemente vor dem Anordnen hat zudem den Vorteil, dass Verstärkungselemente aus verschiedenen Materialien (z.B. von mehreren Verstärkungssubstraten) und mit unterschiedlichen Größen (z.B. Dicke) bzw. Formen sowie mit verschiedenen Eigenschaften (z.B. bezüglich Transparenz, Reflektivität oder Absorptionsverhalten) für den nachfolgenden Anordnungsschritt bereitgestellt werden können. Dies ermöglicht eine optimierte und flexible Anpassung der Fertigung an die gewünschten Spezifikationen.

Des Weiteren wird bei einer Herstellung des Verstärkungselements vor dem Anordnungsschritt der Bereich des ersten Substrats, der nicht mit dem Verstärkungselement in Kontakt beziehungsweise in Verbindung gebracht wird, in geringerem Maße aggressiven Medien wie z.B. Ätzlösungen ausgesetzt, so dass dieser Bereich für spätere Kontaktierungs- und/oder Verbindungsschritte besser konserviert werden kann beziehungsweise wodurch die vorzugsweise hohen Oberflächeneigenschaften dieses Bereichs besser erhalten werden können.

In einer weiteren bevorzugten Ausführungsform weist das mindestens eine Verstärkungselement, insbesondere der/die Oberflächenbereich/e des Verstärkungselements, der mit dem ersten Substrat während des erfindungsgemäßen Verfahrens in Kontakt gebracht wird, eine quadratische Oberflächenrauigkeit kleiner gleich 25 nm, bevorzugt kleiner gleich 15 nm, besonders bevorzugt kleiner gleich 5 nm, und/oder eine Ebenheitsabweichung kleiner gleich 180 nm, insbesondere kleiner gleich 110 nm, auf.

Durch eine hohe Oberflächenqualität (z.B. geringe Rauigkeit, geringe Ebenheitsabweichung) des Verstärkungselements kann eine hohe Oberflächenqualität des ersten Substrats konserviert beziehungsweise die hohe Oberflächenqualität des Verstärkungselements im Zuge des Erwärmen und Verformens auf das erste Substrat übertragen werden, um eine hohe Oberflächenqualität der herzustellenden optischen Komponente zu gewährleisten.

Des Weiteren wird durch Anordnen, insbesondere Aufbringen, des mindestens einen Verstärkungselements auf dem ersten Substrat ein Stapel erzeugt, wodurch das Verstärkungselement einen Bereich des ersten Substrats abdeckt beziehungsweise bedeckt. Im Folgenden wird dieser Stapel aus erstem Substrat und Verstärkungselement als "Basisstapel" bezeichnet.

Dass eine erste Schicht, ein erster Bereich oder eine erste Vorrichtung "auf" einer zweiten Schicht, einem zweiten Bereich oder einer zweiten Vorrichtung angeordnet oder aufgebracht ist, kann dabei hier und im Folgenden bedeuten, dass die erste Schicht, der erste Bereich oder die erste Vorrichtung unmittelbar in direktem mechanischen und/oder elektrischen Kontakt auf der zweiten Schicht, dem zweiten Bereich oder der zweiten Vorrichtung angeordnet oder aufgebracht ist. Weiterhin kann auch ein mittelbarer Kontakt bezeichnet sein, bei dem weitere Schichten, Bereiche und/oder Vorrichtungen zwischen der ersten Schicht, dem ersten Bereich oder der ersten Vorrichtung und der zweiten Schicht, dem zweiten Bereich oder der zweiten Vorrichtung angeordnet sind.

Die Anordnung des Verstärkungselements auf dem ersten Substrat kann beispielsweise mit einem Vakuumhandler (Vakuumsauger), einem Greifer (Collet) oder einem Pickup-Tool (Kombination aus Vakuumsauger und Greifer) erfolgen, die eine positionsgenaue und präzise Anordnung des Verstärkungselements auf dem ersten Substrat gewährleisten. Dabei wird das Verstärkungselement derart auf dem ersten Substrat angeordnet beziehungsweise aufgebracht, dass eine Verformung des beispielsweise als optisches Fenster fungierenden Bereichs des ersten Substrats reduziert oder verhindert wird. Dies wird insbesondere dadurch erreicht, dass zumindest ein Teil des Verstärkungselements einen Bereich des ersten Substrats, der beispielsweise später als optisches Fenster oder als Teil eines optischen Fensters fungiert, abdeckt beziehungsweise bedeckt.

Dieser abgedeckte Bereich des ersten Substrats erstreckt sich im Rahmen der Erfindung auf den Bereich des ersten Substrats, der zwischen beziehungsweise auf der Kontaktfläche beziehungsweise Grenzfläche, die zwischen dem Verstärkungselement und dem ersten Substrat besteht, und der Parallelprojektion dieser Kontaktfläche auf die gegenüberliegende Substratseite des ersten Substrats liegt, wobei der Verbindungsvektor zwischen einem Punkt der Kontaktfläche und seinem Abbild auf der gegenüberliegenden Substratseite des ersten Substrats parallel zum resultierenden Normalenvektor der Kontaktfläche liegt, wobei der resultierende Normalenvektor der Kontaktfläche durch Vektoraddition der Normaleneinheitsvektoren der infinitesimalen Teilflächen der Kontaktfläche, die in Richtung des ersten Substrats weisen, ermittelt wird. Die Oberflächenbereiche des ersten Substrats, die gemeinsame Punkte mit der Kontaktfläche beziehungsweise deren Abbild haben, gehören mit zum abgedeckten Bereich des ersten Substrats.

Der Definition des abgedeckten Bereichs des ersten Substrats wird ein Stapel (Basisstapel/ weiterer Basisstapel) zugrunde gelegt, wie er vor der Verformung nach dem erfindungsgemäßen Verfahren des ersten Substrats vorliegt.

Das zusätzliche Material des Verstärkungselements stabilisiert und schützt den abgedeckten Bereich des ersten Substrats und wirkt einer Verformung entgegen. Dadurch lassen sich die bevorzugt beim bereitgestellten ersten Substrat vorhandene hohe Ebenheit, Planparallelität und geringe Oberflächenrauigkeit erhalten, was die Basis für qualitativ hochwertige optische Komponenten ist, und zudem Flächen - insbesondere Transmissionsflächen, die einer nachträglichen Bearbeitung (zum Beispiel einem Polierschritt) nicht zugänglich sind, mit einer hohen Oberflächenqualität realisieren.

Beim Anordnen beziehungsweise Aufbringen des mindestens einen Verstärkungselements auf dem ersten Substrat werden das erste Substrat und das Verstärkungselement vorzugsweise formschlüssig und/oder stoffschlüssig, insbesondere durch Kleben, Löten oder Bonden, miteinander verbunden, um eine hohe Lagestabilität des Verstärkungselements gegenüber dem ersten Substrat zu gewährleisten. Zweckmäßig erfolgt das Anordnen des Verstärkungselements auf dem ersten Substrat derart, dass ein Verschieben und/oder Verdrehen des Verstärkungselements gegenüber dem ersten Substrat reduziert oder verhindert wird.

In einer bevorzugten Ausführungsform wird eine formschlüssige Verbindung dadurch realisiert, dass das Verstärkungselement in einer Justiervertiefung des ersten Substrats, die für die Aufnahme des Verstärkungselements ausgebildet ist, angeordnet wird. Bei dieser Art der Anordnung sind keine zusätzlichen Verbindungssubstanzen (z.B. Klebstoff) beziehungsweise spezielle Verbindungsschritte (z.B. Bonden) erforderlich, die die Oberflächenqualität des ersten Substrat beeinträchtigen könnten.

In einer weiteren bevorzugten Ausführungsform wird das mindestens eine Verstärkungselement, zum Beispiel ein Silizium-Chip, durch anodisches Bonden, direktes Bonden, plasma-aktiviertes Bonden und/oder thermisches Bonden auf dem ersten Substrat angeordnet beziehungsweise mit diesem verbunden. Vor allem in der Halbleiterindustrie sind diese Bondverfahren häufig eingesetzte Verbindungstechniken, die zu stabilen Verbindungen führen. Bevorzugt erfolgt ein solcher Verbindungsschritt, wie z.B. das Bonden, im Vakuum, wodurch sich beispielsweise Lufteinschlüsse und/oder eingeschlossene Partikel in den Verbindungsbereichen, insbesondere an der Grenzfläche zwischen Verstärkungselement und erstem Substrat, vermeiden und dadurch entstehende Defekte an der Oberfläche des ersten Substrats und damit an der Oberfläche der optischen Komponente reduzieren lassen.

In einer besonderen Ausführungsform des erfindungsgemäßen Verfahrens nach Anspruch 1 wird das mindestens eine Verstärkungselement vor dem Anordnen auf dem ersten Substrat auf einem Positionierungsmittel angeordnet.

Die Bestückung des Positionierungsmittels mit dem Verstärkungselement, also die Übertragung und Anordnung des Verstärkungselements, kann beispielsweise mit einem Vakuumhandler (Vakuumsauger), einem Greifer (Collet) oder einem Pickup-Tool (Kombination aus Vakuumsauger und Greifer) erfolgen, die eine positionsgenaue und präzise Bestückung auf dem Positionierungsmittel gewährleisten.

Als Positionierungsmittel eignen sich alle Mittel, Vorrichtungen und Werkzeuge, die das Verstärkungselement in seiner Lage stabilisieren bzw. justiert halten. Durch diese Stabilisierung wird die Handhabung des Verstärkungselements in Bezug auf die weiteren Verfahrensschritte wesentlich erleichtert. So kann beispielsweise die Bestückung unter Reinraumbedingungen bei atmosphärischem Luftdruck und ein nachfolgender Verbindungsschritt, z.B. das anodische Bonden, in einem anderen Reimraumbereich im Vakuum erfolgen.

Als Positionierungsmittel geeignet sind beispielsweise haftfähige Unterlagen auf Basis von magnetischer oder elektrostatischer Kraftwirkung oder Substrate, die kraftschlüssige (die Reibung erhöhende Schicht), stoffschlüssige (z.B. aufgebrachte Klebeschicht) oder formschlüssige Verbindungen (z.B. Vertiefungen beziehungsweise Ausnehmungen) gewährleisten können.

Mit Blick auf einen nachfolgenden Verbindungsschritt (z.B. anodisches Bonden) ist das Positionierungsmittel bevorzugt elektrisch leitfähig ausgeführt. Entsprechend enthält oder besteht das Positionierungsmittel bevorzugt aus elektrisch leitfähigen und/oder halbleitenden Materialien wie zum Beispiel Silizium.

Als bevorzugtes Positionierungsmittel kann ein Aufnahmesubstrat Verwendung finden. Ein solches Aufnahmesubstrat verfügt über mindestens eine Ausnehmung beziehungsweise Vertiefung (Aufnahmevertiefung), die für die Aufnahme des Verstärkungselements ausgelegt ist und dieses insbesondere lateral fixiert beziehungsweise justiert hält. Da die Justage des Verstärkungselements in diesem Fall hauptsächlich durch eine formschlüssige Verbindung zwischen Aufnahmesubstrat und Verstärkungselement gewährleistete wird, kann das Aufnahmesubstrat nach dem Anordnen des Verstärkungselements auf dem ersten Substrat durch Aufhebung des Formschlusses auf einfache Art und Weise entfernt werden, um den so erzeugten Basisstapel aus erstem Substrat und Verstärkungselement für weitere Prozessschritte freizugeben. Das Aufnahmesubstrat lässt sich dann für den nächsten Bestückungsvorgang wieder verwenden und ist so mehrfach einsetzbar, wodurch wiederum eine Reduzierung des Fertigungsaufwandes und der Fertigungskosten gegeben ist.

Um den Kontakt des Aufnahmesubstrats mit dem ersten Substrat beim Anordnen des Verstärkungselements auf dem ersten Substrat zu verhindern und so die Oberflächenqualität des ersten Substrats in den Bereichen, die nicht mit dem Verstärkungselement in Kontakt beziehungsweise in Verbindung gebracht werden sollen, für weitere Verbindungs- und/oder Kontaktierungsschritt zu konservieren beziehungsweise ein möglichst problemloses Entfernen des Aufnahmesubstrats nach dem Anordnen des Verstärkungselements auf dem ersten Substrat gewährleisten zu können, ist die Aufnahmevertiefung bevorzugt derart ausgelegt, dass mindestens eines der Verstärkungselemente nach Anordnung auf dem Aufnahmesubstrat über die Begrenzungsflächen des Aufnahmesubstrats hinausragt. Besonders bevorzugt ragen alle Verstärkungselemente nach Anordnung auf dem Aufnahmesubstrat über die Begrenzungsflächen des Aufnahmesubstrats hinaus.

Vorzugsweise kann das mindestens eine Verstärkungselement mindestens ein Fixierungselement aufweisen beziehungsweise mit mindestens einem Fixierungselement in wechselseitiger Wirkbeziehung (z.B. mechanische, elektrostatische und/oder magnetische Kraftkopplung) stehen. Das Fixierungselement reduziert oder verhindert insbesondere nach dem Inkontaktbringen des Basisstapels mit dem mindestens einen zweiten Substrat ein Verschieben und/oder Verdrehen des Verstärkungselements gegenüber dem ersten Substrat und erhöht damit die Lagestabilität des Verstärkungselements.

Vorzugsweise stehen das Verstärkungselement und das Fixierungselement miteinander mechanisch in Verbindung, um eine möglichst stabile Kraftkopplung gewährleisten zu können.

Bevorzugt wird das Fixierungselement im Verfahrensschritt des Inkontaktbringens des Basisstapels mit dem zweiten Substrat zwischen dem Basisstapel und dem zweiten Substrat eingeklemmt. Durch geeignete Aufnahmenuten - zum Beispiel in dem zweiten Substrat, lässt sich trotz des zwischengelagerten beziehungsweise eingeklemmten Fixierungselements ein zweckmäßiger Kontakt zwischen Basisstapel und zweiten Substrat gewährleisten.

In einer weiteren bevorzugten Ausführungsform wird das Fixierungselement beim Verfahrensschritt des Anordnens des Verstärkungselements auf dem ersten Substrat mit dem ersten Substrat stoffschlüssig, insbesondere mittels thermischen oder anodischen Bondens, verbunden, wodurch eine besonders stabile Verbindung und damit eine besonders gute Lagestabilität des Verstärkungselements gewährleistet werden kann.

In einer besonderen Ausgestaltung der Erfindung steht zumindest ein Teil des Fixierungselements mit einem Bereich des ersten Substrats in Kontakt beziehungsweise in Verbindung, der nach dem Inkontaktbringen des Basisstapels mit dem zweiten Substrat außerhalb des Auslenkungsbereichs beziehungsweise im Auflagebereich liegt. Da dieser Bereich des ersten Substrats keiner Auslenkung beziehungsweise Verformung unterworfen ist, begünstigt er eine verbesserte Kraftaufnahme und damit eine erhöhte Lagestabilität des Verstärkungselements.

Bevorzugt wird das Fixierungselement bei der Herstellung des Verstärkungselements erzeugt, wodurch sich zusätzliche Fertigungsschritte einsparen lassen.

In einer weiteren bevorzugten Ausführungsform werden ein oder mehrere Auflagestrukturen erzeugt, wobei die Erzeugung der Auflagestruktur derart erfolgt, dass die Auflagestruktur den Auflagebereich, insbesondere die Auflagefläche, des ersten Substrats schützt und/oder als Abstandshalter zwischen dem ersten Substrat und dem zweiten Substrat fungiert.

Der Auflagebereich ist der Bereich des ersten Substrats, der während des Verfahrens keine Auslenkung, insbesondere nicht durch Verformung, erfährt beziehungsweise durch das zweite Substrat direkt oder indirekt gestützt wird. Eine direkte Stützung liegt vor, wenn das erste Substrat und das zweite Substrat miteinander in Kontakt gebracht werden. Bei einer indirekten Stützung sind beispielsweise zwischen dem ersten Substrat und dem zweiten Substrat ein oder mehrere Schichten oder Schichtfolgen angeordnet. Die Auflagefläche ist die Oberfläche des Auflagebereichs, die dem zweiten Substrat zugewandt ist. Bei einem herzustellenden Deckel beispielsweise bildet vorzugsweise die Auflagefläche des ersten Substrats die Kontaktfläche des Deckels und damit die Fläche des Deckels, die für den Kontakt beziehungsweise die Verbindung des Deckels mit dem Trägersubstrat vorgesehen ist. Die Kontaktfläche des Deckels und/oder die der Kontaktfläche auf der anderen Substratseite gegenüberliegenden Oberfläche des ersten Substrats liegen bevorzugt in mindestens einer der Substratebenen des ersten Substrats. Entsprechend sind nach dem Verbinden des Deckels mit dem Trägersubstrat die Trägersubstratebene und die Substratebenen des ersten Substrats vorzugsweise parallel angeordnet.

Durch die Anordnung der Auflagestruktur auf dem ersten Substrat kann die vorzugsweise hohe Oberflächenqualität des ersten Substrats konserviert werden beziehungsweise können ein oder mehrere hochqualitative Oberflächenbereiche der Auflagestruktur während des Verfahrensschritt des Erwärmen und Verformens auf das erste Substrat abgeformt und so ein oder mehrere Auflagebereiche, insbesondere Auflageflächen und damit potenzielle Kontaktflächen der herzustellenden optischen Komponente, mit hoher Oberflächenqualität realisiert werden. Solche hochqualitativen Oberflächenbereiche mit beispielsweise geringer Rauigkeit und hoher Ebenheit ermöglichen den Einsatz ausgereifter Verbindungstechniken, wie z.B. anodisches Bonden, mit denen sich stabile Verbindungen zwischen der optischen Komponente, z.B. einem Deckel, und dem Trägersubstrat herstellen lassen.

Die Auflagestruktur wird bevorzugt durch mindestens eine Schicht oder Schichtfolge, die auf dem ersten Substrat aufgebracht beziehungsweise angeordnet wird, realisiert. Durch die Variation der Schichtdicke der Schicht/en lässt sich der Abstand zwischen dem ersten Substrat und dem zweiten Substrat einstellen, so dass die Auflagestruktur bevorzugt als Abstandshalter fungiert. Dadurch wird eine flexible Anpassung des Verfahrens zur Realisierung unterschiedlicher verformungsbedingter Auslenkungsamplituden des ersten Substrats beziehungsweise unterschiedlich tiefer erster Vertiefungen im ersten Substrat ermöglicht.

Die mindestens eine Auflagestruktur wird bevorzugt wie das mindestens eine Verstärkungselement vor dem Anordnen auf dem ersten Substrat hergestellt, wodurch das Bereitstellen von Auflagestrukturen und Verstärkungselementen mit unterschiedlichen Abmaßen und Formen ermöglicht wird, die beim Anordnen auf dem ersten Substrat in beliebiger Weise kombinierbar sind. Die Herstellung, die Positionierung beziehungsweise Anordnung auf dem ersten Substrat und eine bevorzugte Verbindung mit dem ersten Substrat kann in der Art und Weise durchgeführt werden, wie vorher und im Folgenden in Bezug auf die Verstärkungselemente beschrieben wurde/wird. Dies ermöglicht eine zeit- und kostenoptimierte Fertigung. Alternativ kann die Auflagestruktur beispielsweise durch ein auf dem ersten Substrat aufgebrachte, insbesondere abgeschiedene, und strukturierte Schicht realisiert werden.

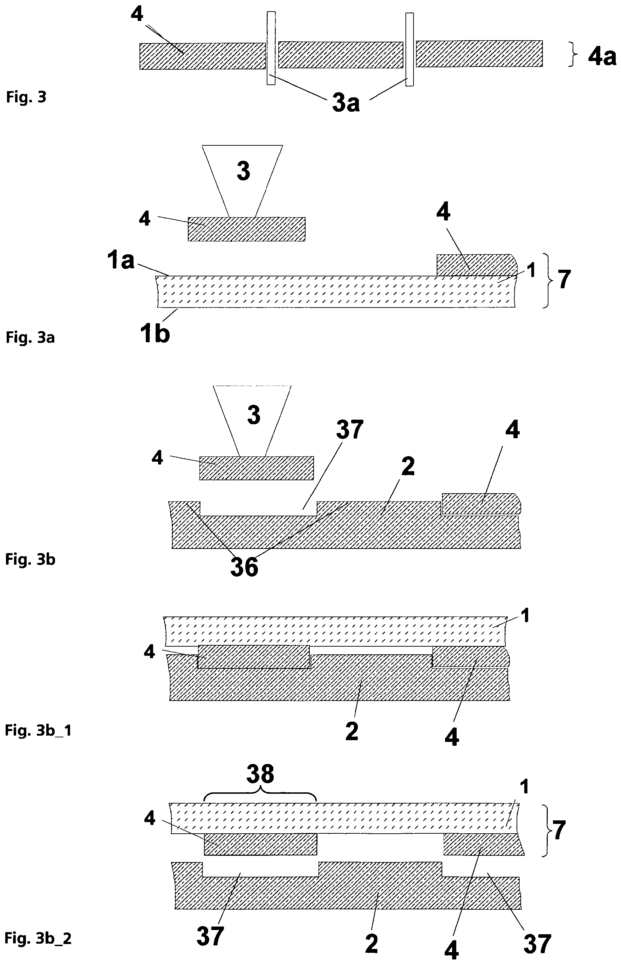

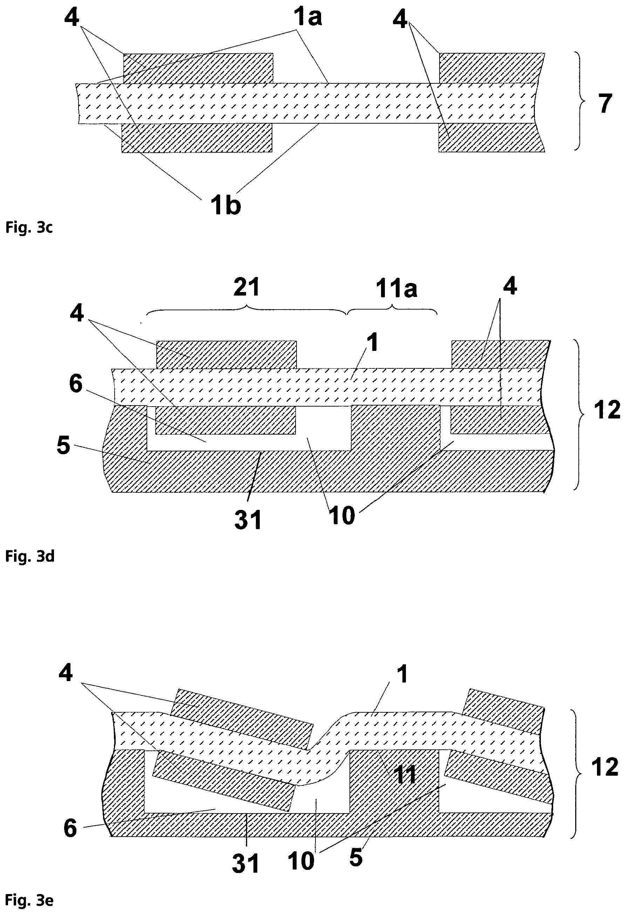

Vorzugsweise wird auf beiden Substratseiten des ersten Substrats jeweils mindestens ein Verstärkungselement angeordnet, wobei sich gegenüberliegende Verstärkungselemente bevorzugt zumindest teilweise überlappen. In einer besonders vorteilhaften Ausführungsform überlappen sich solche Verstärkungselemente komplett (Fig. 3c). Dadurch werden die durch sie abgedeckten Bereiche des ersten Substrats besonders gut stabilisiert und vor Verformung geschützt.

Bevorzugt wird das mindestens eine Verstärkungselement so auf dem ersten Substrat angeordnet, dass ein Neigen des durch dieses Verstärkungselement abgedeckten Bereichs des ersten Substrats beim Erwärmen und Verformen unterstützt wird. Dies wird insbesondere dadurch erreicht, dass mindestens eines der Verstärkungselemente nicht zentrisch im Auslenkungsbereich des ersten Substrats angeordnet wird.

Der Auslenkungsbereich ist der, insbesondere während des Erwärmen und Verformens, nicht, insbesondere nicht durch das zweite Substrat, gestützte Bereich des ersten Substrats, der sich zwischen den Auflagebereichen befindet. Ein Auslenkungsbereich lässt sich aufteilen in den durch das Verstärkungselement abgedeckten Bereich des ersten Substrats und den Verformungsbereich des ersten Substrats. Der Verformungsbereich stellt wiederum den Bereich des ersten Substrats dar, der durch seine Formänderung ein Auslenken, insbesondere ein Verschieben und/oder Neigen, des durch das Verstärkungselement abgedeckten Bereich des ersten Substrats gewährleistet. Durch eine nicht zentrische Anordnung des Verstärkungselements im Auslenkungsbereich lässt sich bei einer Gleichverteilung der Kraft über dem Auslenkungsbereich, insbesondere über dem Verstärkungselement, ein resultierendes Drehmoment erzielen, welches auf den durch das Verstärkungselement abgedeckten Bereich des ersten Substrats wirkt und damit ein Neigen des durch das Verstärkungselement abgedeckten Bereichs des ersten Substrats begünstigt.

Unter einer nicht zentrischen Anordnung eines Verstärkungselements im Auslenkungsbereich wird im Sinne der Erfindung verstanden, dass der Abstand des Verstärkungselements in mindestens einer Richtung nicht zu allen an den Auslenkungsbereich angrenzenden Auflagebereichen gleichgroß ist. Entsprechend gilt für eine nicht zentrische Kraft auf den Auslenkungsbereich, dass der Abstand des Angriffspunkts der resultierenden Kraft in mindestens einer Richtung nicht zu allen an den Auslenkungsbereich angrenzenden Auflagebereichen gleichgroß ist. Bei einer nicht zentrischen resultierenden Kraft auf ein Verstärkungselement ist der Abstand des Angriffspunkts zu den Rändern des Verstärkungselements in mindestens einer Richtung nicht gleichgroß.

In einem weiteren Verfahrensschritt wird der Basisstapel mit dem zweiten Substrat in Kontakt gebracht, um das erste Substrat im Auflagebereich zu stützen und eine stabile Kraftaufnahme in diesem Bereich zu gewährleisten. Zudem kann das zweite Substrat und/oder das Verstärkungselement als Auslenkungsbegrenzung dienen.

Das Inkontaktbringen des Basisstapels mit dem zweiten Substrat erfolgt bevorzugt derart, dass durch eine bevorzugt ausgebildete dritte Vertiefung in dem zweiten Substrat und/oder eine bevorzugt ausgebildete erste Vertiefung im ersten Substrat und/oder durch die Auflagestruktur mindestens ein Hohlraum zwischen dem zweiten Substrat und dem Basisstapel gebildet wird. In einer besonders bevorzugten Ausgestaltung schließt dieser Hohlraum mindestens ein Verstärkungselement ein.

Durch den Hohlraum kann ein direkter oder indirekter (z.B. durch ein oder mehrere zwischengelagerte Verstärkungselemente bedingt) Kontakt zwischen dem Auslenkungsbereich des ersten Substrats und dem zweiten Substrat vor dem Erwärmen und Verformen verhindert werden. Ein solcher Kontakt könnte zum Anhaften des Auslenkungsbereichs des ersten Substrats am zweiten Substrat, z.B. auch indirekt durch Anhaften des auf dem ersten Substrat angeordneten Verstärkungselements am zweiten Substrat, führen und ein verformungsbedingtes Auslenken des ersten Substrats im Auslenkungsbereich, insbesondere ein Verschieben und/oder Neigen des durch das Verstärkungselement abgedeckten Bereichs des ersten Substrats, verhindern oder erschweren.

Des Weiteren kann in dem Hohlraum ein Druck unterhalb oder oberhalb des Umgebungsdrucks, insbesondere des atmosphärischen Luftdrucks, erzeugt werden. Da der Hohlraum zumindest durch einen Teil des Auslenkungsbereichs des ersten Substrats begrenzt wird, lassen sich durch einen in dem Hohlraum erzeugten Druck, der unterhalb oder oberhalb des Umgebungsdrucks liegt, Kraftwirkungen zur Begünstigung des Verformungsprozesses erzeugen.

Vorzugsweise entspricht der Umgebungsdruck dem atmosphärischen Luftdruck, und die Druckwerte in dem Hohlraum liegen dann bevorzugt zwischen etwa 750 mbar und etwa 900 mbar oder zwischen etwa 1200 mbar und etwa 1350 mbar und können beispielsweise mittels Vakuumpumpe bzw. Pumpe erzeugt werden.

Des Weiteren kann es von Vorteil sein, wenn das Inkontaktbringen des zweiten Substrats mit dem Basisstapel zu einer Verbindung, insbesondere einer stoffschlüssigen Verbindung, führt. Dadurch lässt sich bevorzugt ein von der Umgebung hermetisch dicht abschießender Hohlraum zwischen dem Basisstapel und dem zweiten Substrat erzeugen. Indem der Verbindungsprozess bei bestimmten Drücken durchgeführt wird, können bestimmte Druckwerte in den Hohlräumen erzeugt werden. Bevorzugt liegen die Druckwerte während des Verbindungsprozesses, zum Beispiel dem anodischen Bonden bei 400°C, zwischen etwa 500 mbar und etwa 600 mbar oder zwischen etwa 800 mbar und etwa 900 mbar. Da der anschließende Erwärmungsprozess typischerweise bei wesentlich höheren Temperaturen als der Verbindungsprozess erfolgt - bevorzugt wird das erste Substrat während des Verfahrensschritts des Erwärmen und Verformens auf eine Temperatur zwischen etwa 750 °C und etwa 900 °C gebracht - ergeben sich durch die höhere Temperatur aus den angegebenen Druckbereichen im Hohlraum Drücke von etwa 750 mbar bis etwa 900 mbar oder etwa 1200 mbar bis 1350 mbar. Da der Hohlraum bevorzugt hermetisch dicht von der Umgebung abgeschlossen ist, bleiben diese Druckwerte ohne weitere Energiezufuhr, zum Beispiel zum Betrieb einer Vakuumpumpe bzw. Pumpe, über einen längeren Zeitraum und damit insbesondere für die Verformung beziehungsweise Formgebung erhalten.

Bevorzugt wird die Verbindung zwischen Basisstapel und zweitem Substrat durch anodisches Bonden und/oder thermisches Bonden realisiert.

Bei der Formgebung des ersten Substrats werden insbesondere die Fließeigenschaften des ersten Substrats, wie sie insbesondere in der Nähe und oberhalb der Erweichungstemperatur (softening point) und/oder der Schmelztemperatur vorliegen, ausgenutzt. Der Vorteil dieser Art der Formgebung, auch als Glasfließen bezeichnet, gegenüber anderen Formgebungs- oder Prägeverfahren, wie zum Beispiel Glastiefziehen oder Glasprägen (zum Beispiel Blankpressen), besteht vor allem darin, dass sich insbesondere optische Komponenten beispielsweise mit Substrat- beziehungsweise Waferausdehnungen, insbesondere Substrat- beziehungsweise Waferdurchmessern größer gleich 80 mm, insbesondere größer gleich 150mm, besonders bevorzugt größer gleich 300mm, mit hoher Oberflächenqualität, insbesondere geringer Oberflächenrauigkeit, hoher Oberflächenebenheit und hoher Planparallelität der Oberflächen der Substratseiten, realisieren lassen.

Insbesondere wenn das Ausgangssubstrat aus Glas besteht, ist häufig die Oberflächenrauigkeit der optischen Komponenten nicht zufriedenstellend. Die geformten Substrate sind, wie zum Beispiel beim Glastiefziehen, aufgeraut und können die Anforderungen beispielsweise an ein optisches Fenster nicht erfüllen.

Beim Blankpressen sind die maximalen Ausdehnungen beziehungsweise Abmessungen der herstellbaren optischen Komponenten stark limitiert. Des Weiteren sind bei diesem Prägeverfahren sehr hochwertige, beständige und damit teure Prägewerkzeuge erforderlich, was eine flexible Fertigung einschränkt.

Der Verfahrensschritt des Erwärmen und Verformens des ersten Substrats erfolgt derart, dass sich zumindest ein Teil des durch das mindestens eine Verstärkungselement abgedeckten Bereichs des ersten Substrats verschiebt und/oder neigt, und/oder dass ein Bereich des ersten Substrats mit dem mindestens einen Verstärkungselement in Kontakt gebracht wird.

Dabei wird zumindest der Verformungsbereich des ersten Substrats, bevorzugt der Auslenkungsbereich, besonders bevorzugt das gesamte erste Substrat, auf eine Temperatur gebracht, die bevorzugt zwischen der Erweichungstemperatur minus 150°C und der Erweichungstemperatur plus 100°C des Materials des ersten Substrats, bevorzugt des Materials des Auslenkungsbereichs, insbesondere des Materials des Verformungsbereichs, bevorzugt zwischen etwa 750 °C und etwa 900 °C, liegt. Im Bereich der Erweichungstemperatur weist das entsprechende Material besonders günstige Verformungseigenschaften, insbesondere bezüglich Viskosität, auf.

Bei Verwendung von Borsilikatglas, mit einer Erweichungstemperatur von etwa 820 °C, sind beispielsweise Temperaturen zwischen etwa 750 °C und etwa 900 °C zweckmäßig.

Die Erweichungstemperatur oder der Erweichungspunkt (softening point), auch Littletontemperatur oder Littleton-Punkt genannt, wird nach einer Methode von Littleton bestimmt. Dabei wird ein Materialfaden (zum Beispiel ein Glasfaden) mit einem Durchmesser von 0,65 mm bis 1,0 mm und einer Länge von 22,9 cm in einen Ofen bestimmter Konstruktion gehängt. Bei einer Aufheizgeschwindigkeit von 5 bis 10 K/min beobachtet man das aus dem Ofen heraushängende untere Ende des Fadens. Mit steigender Temperatur verlängert sich der Faden unter dem eigenen Gewicht. Die Temperatur, bei der die Verlängerung 1 mm/min beträgt, wird als Littletontempertur bezeichnet. Die meisten Gläser oder glasähnlichen Materialien weisen bei dieser Temperatur eine Viskosität von etwa 10^{-7,6} dPa·s auf (Scholze, Horst "Glas - Natur, Struktur und Eigenschaften", 3. Auflage, Springer Verlag, S. 151).

Beim Erwärmen und Verformen wird das erste Substrat durch eine Kraft beziehungsweise Kraftwirkung auf das erste Substrat, insbesondere den Auslenkungsbereich, im Auslenkungsbereich, insbesondere im Verformungsbereich, verformt.

Insbesondere die Verformung des Verformungsbereichs ermöglicht ein Verschieben und/oder Neigen zumindest eines Teils des beim Erzeugen des Basisstapels gebildeten abgedeckten Bereichs des ersten Substrats, der durch das Verstärkungselement stabilisiert beziehungsweise vor Verformung geschützt wird.

Sollte nicht nur der Verformungsbereich sondern zudem der abgedeckte Bereich des ersten Substrats zumindest teilweise erwärmt werden, so kann ein qualitativ hochwertiger Oberflächenbereich des Verstärkungselements mit beispielsweise geringer Rauigkeit und Ebenheitsabweichung durch den Kontakt zum ersten Substrat im abgedeckten Bereich auf die Oberfläche des ersten Substrats abgeformt werden. Im Ergebnis resultiert daraus ein optisch hochwertiger Oberflächenbereich im ersten Substrat. Dies hat den Vorteil, dass die Anforderungen an die Oberflächenqualität der entsprechenden Substratseite/n des bereitgestellten ersten Substrats geringer sein können und damit ein eventuell notwendiger Bearbeitungsschritt, wie z.B. das Polieren, entfallen kann; wodurch die Fertigungskosten gesenkt werden können.

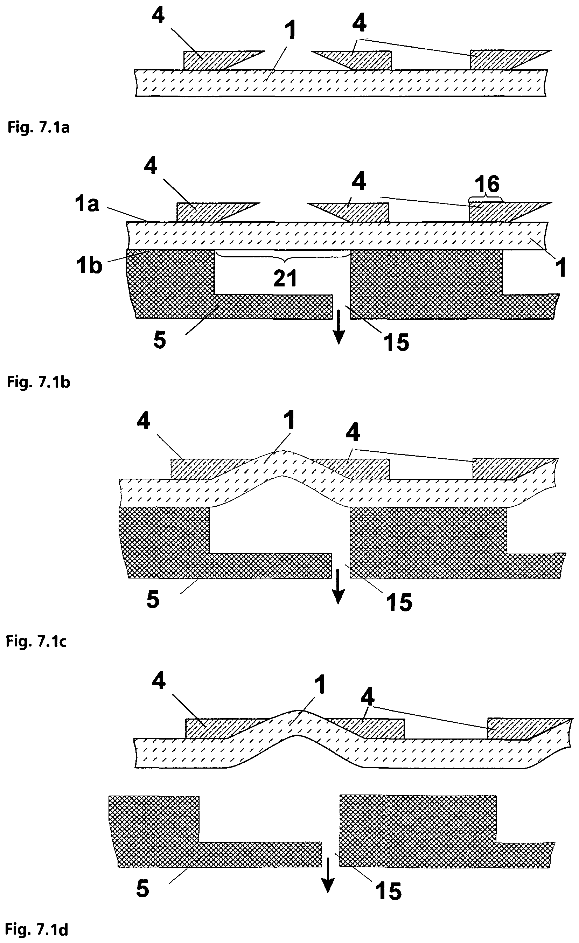

Beim Erwärmen und Verformen des ersten Substrats derart, dass ein Bereich des ersten Substrats mit dem Verstärkungselement in Kontakt gebracht wird, ist zumindest ein Teil des Verstärkungselements beabstandet zum ersten Substrat angeordnet (z.B. Fig. 7.1). Durch das Erwärmen und Verformen wird ein Bereich des ersten Substrats mit dem Verstärkungselement, insbesondere dem beabstandet angeordneten Teil des Verstärkungselements, in Kontakt gebracht. Dabei wird bevorzugt der mit dem ersten Substrat in Kontakt gebrachte Oberflächenbereich des Verstärkungselements, der insbesondere eine geringe Rauigkeit und Ebenheitsabweichung aufweist, auf das erste Substrat abgeformt und so ein qualitativ hochwertiger optischer Bereich im ersten Substrat erzeugt. Dies hat wiederum den Vorteil, dass die Anforderungen an die Oberflächenqualität der entsprechenden Substratseite/n des bereitgestellten ersten Substrats geringer sein können und damit ein eventuell notwendiger Bearbeitungsschritt, wie z.B. das Polieren, entfallen kann. Bevorzugt werden zumindest Teilbereiche der durch das Erwärmen und Verformen miteinander in Kontakt gebrachten Bereiche des ersten Substrats und des Verstärkungselements miteinander verbunden, insbesondere stoffschlüssig verbunden. Eine solche Verbindung wird insbesondere durch thermisches Bonden erreicht. Dadurch wird ein besonders effektives Abformen des Oberflächenbereichs beziehungsweise der Oberflächenstruktur des Verstärkungselements auf das erste Substrat gewährleistet.

Häufig ist in diesem Fall der Auslenkungsbereich mit dem Verformungsbereich des ersten Substrats identisch. In einer besonderen Ausgestaltung kann der Auslenkungsbereich aus dem Verformungsbereich und einem nicht für die Verformung vorgesehenen Bereich des ersten Substrats bestehen. In diesem Fall wird durch lokale Erwärmung des Verformungsbereichs ein Auslenken des nicht für die Verformung vorgesehenen Bereichs des ersten Substrats und damit ein Inkontaktbringen dieses Bereichs des ersten Substrats mit dem Verstärkungselement gewährleistet. Im Ergebnis entsteht ein verschobener und/oder geneigter Bereich im ersten Substrat.

Der Verfahrensschritt des Erwärmen und Verformens wird bevorzugt zeitgesteuert oder bis zum Kontakt des ersten Substrats und/oder des Verstärkungselements mit einer Auslenkungsbegrenzung, die beispielsweise die maximal gewünschte verformungsgedingte Auslenkung begrenzt, durchgeführt. Als Auslenkungsbegrenzung kann zum Beispiel ein Verstärkungselement und/oder das zweite Substrat, insbesondere die Bodenfläche der dritten Vertiefung, dienen.

Die Verformung des ersten Substrats, insbesondere des Verformungsbereichs, kann bevorzugt durch die Eigengewichtskraft des Verstärkungselements und/oder des ersten Substrats, insbesondere des durch das Verstärkungselement abgedeckten Bereichs des ersten Substrats, und/oder durch eine von außen eingebrachte Kraft bedingt werden.

Eine von außen eingebrachte Kraft kann zweckmäßigerweise auf einer mechanischen, z.B. pneumatischen, und/oder magnetischen und/oder elektrischen und/oder piezoelektrischen Wechselwirkung beruhen.

In einer bevorzugten Ausführungsform wird die von außen eingebrachte Kraft durch eine Druckdifferenz zwischen beiden Substratseiten des ersten Substrats, insbesondere im Auslenkungsbereich, bewirkt. Wie bei der Verformung durch die Eigengewichtskraft muss auch bei dieser Methode der Krafteinbringung das erste Substrat beziehungsweise der Basisstapel nicht mit einem weiteren Gegenstand, beispielsweise einem Prägewerkzeug, in Kontakt gebracht werden, wodurch eine Qualitätsminderung der Oberflächen des ersten Substrats oder funktionaler Verstärkungselemente - die z.B. nach Fertigstellung eine Funktion innerhalb der optischen Komponente zu erfüllen haben, verhindert wird.

Zudem kann in diesem Fall das Erwärmen und Verformen so lange durchgeführt werden, bis eine durch die Formgebung des ersten Substrats bedingte Volumenänderung des Hohlraums zu einem Druck in dem Hohlraum führt, der dem Umgebungsdruck entspricht.

Auch speziell gestaltete Formgebungsvorrichtungen eignen sich für das Einbringen einer Kraft.

Die eingebrachte Kraft kann sowohl zentrisch als auch nicht zentrisch in Bezug auf das Verstärkungselement und/oder den Auslenkungsbereich wirken.

Aus einem zum Beispiel über den Auslenkungsbereich gleichverteilten Kraftprofil resultiert eine in Bezug auf den Auslenkungsbereich zentrische Kraft, wodurch bei zentrischer Anordnung des Verstärkungselements im Auslenkungsbereich ein Verschieben des abgedeckten Bereichs des ersten Substrats erreicht werden kann. Ein Neigen des durch das Verstärkungselement abgedeckten Bereichs des ersten Substrats kann in diesem Fall durch eine nicht zentrische Anordnung des Verstärkungselements im Auslenkungsbereich erzielt werden (z.B. Fig. 3d).

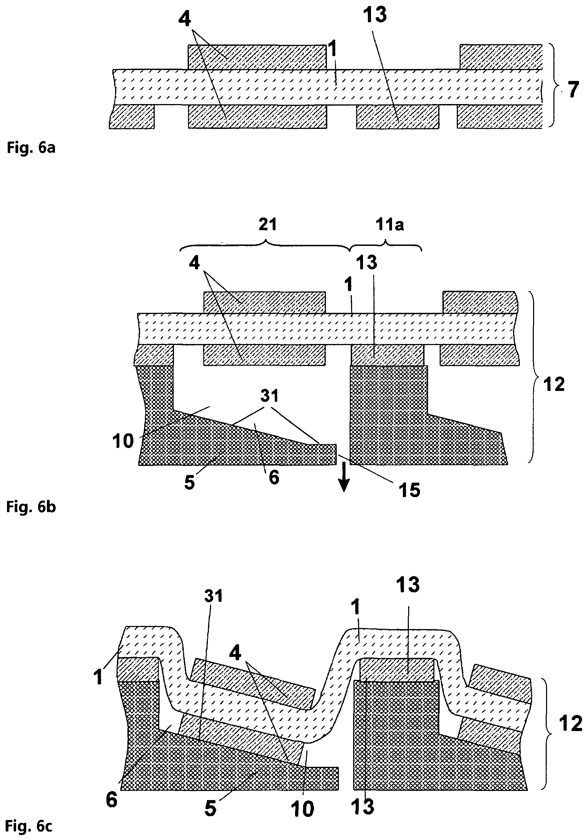

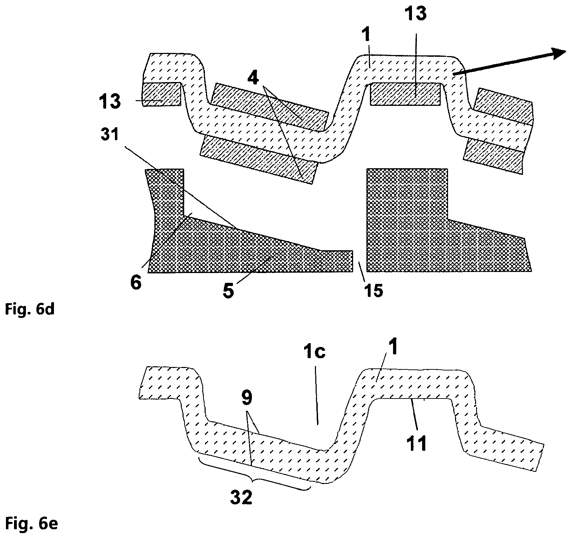

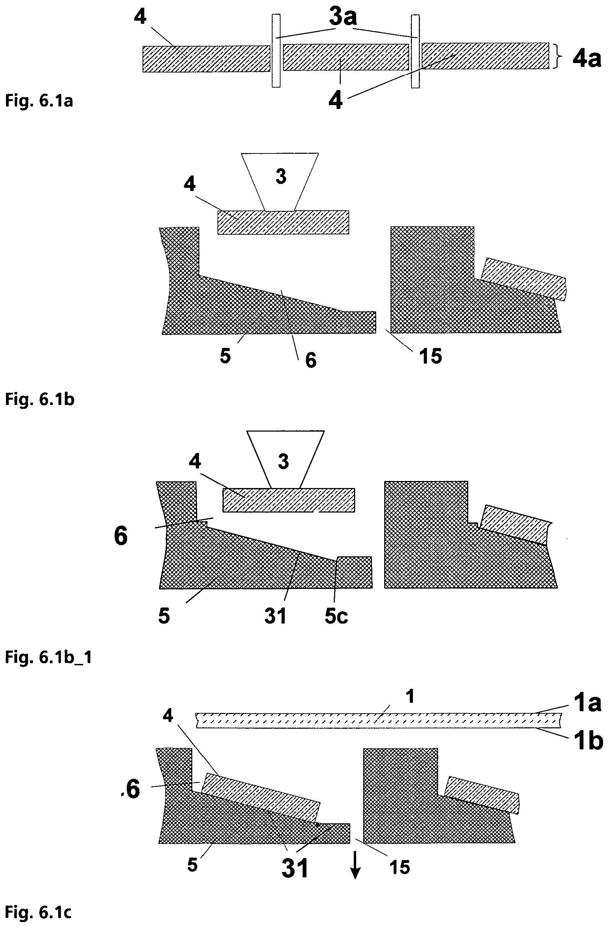

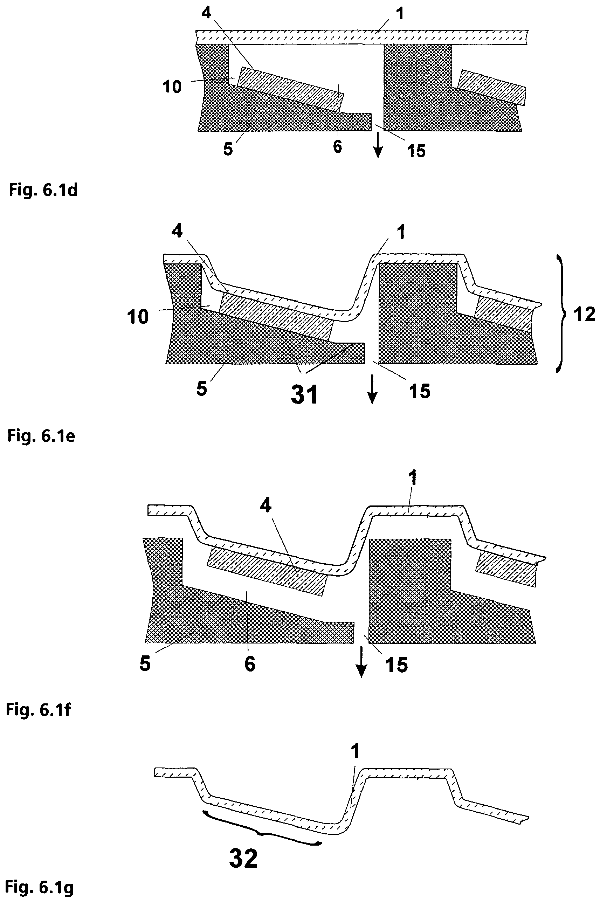

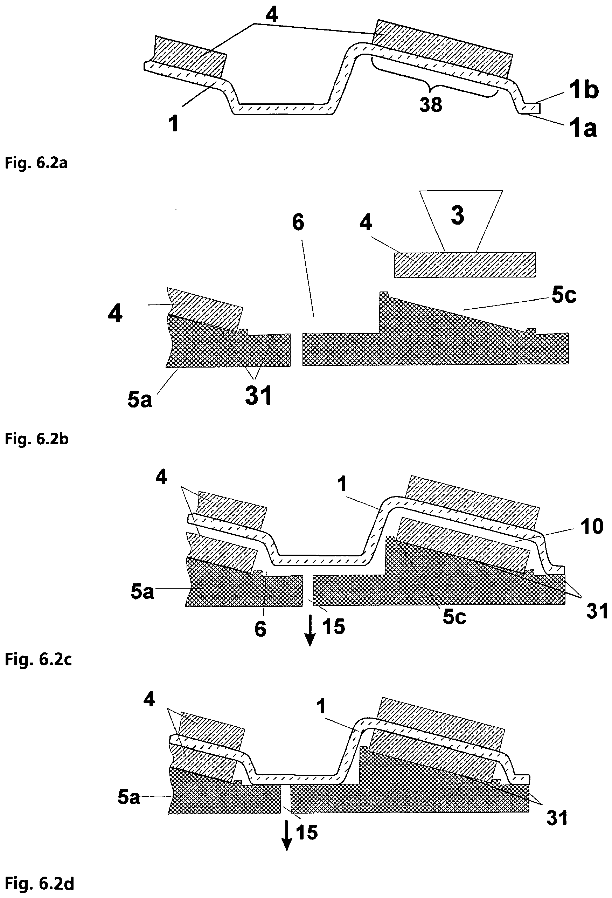

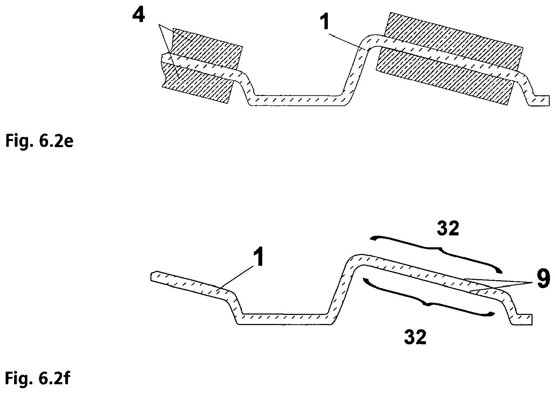

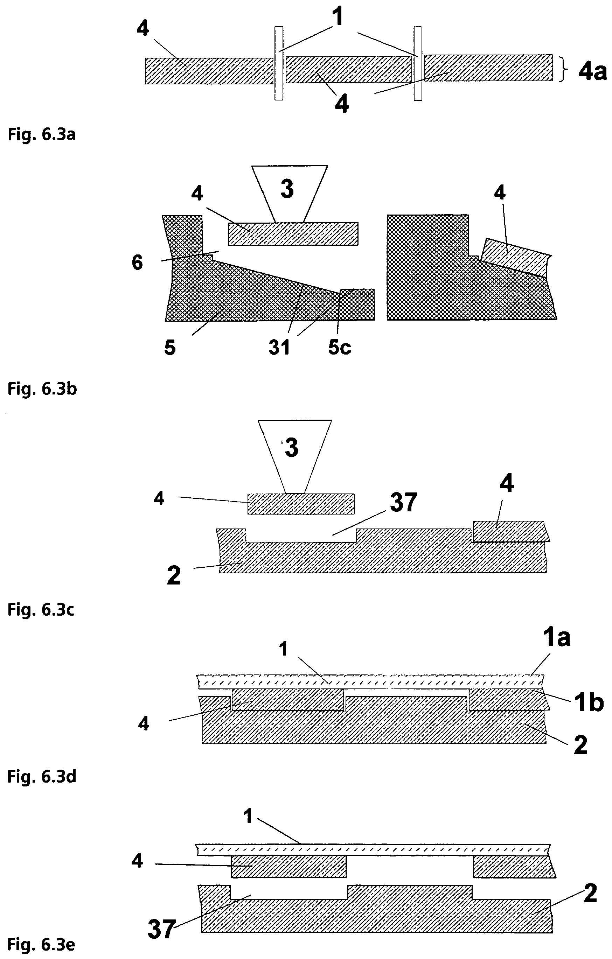

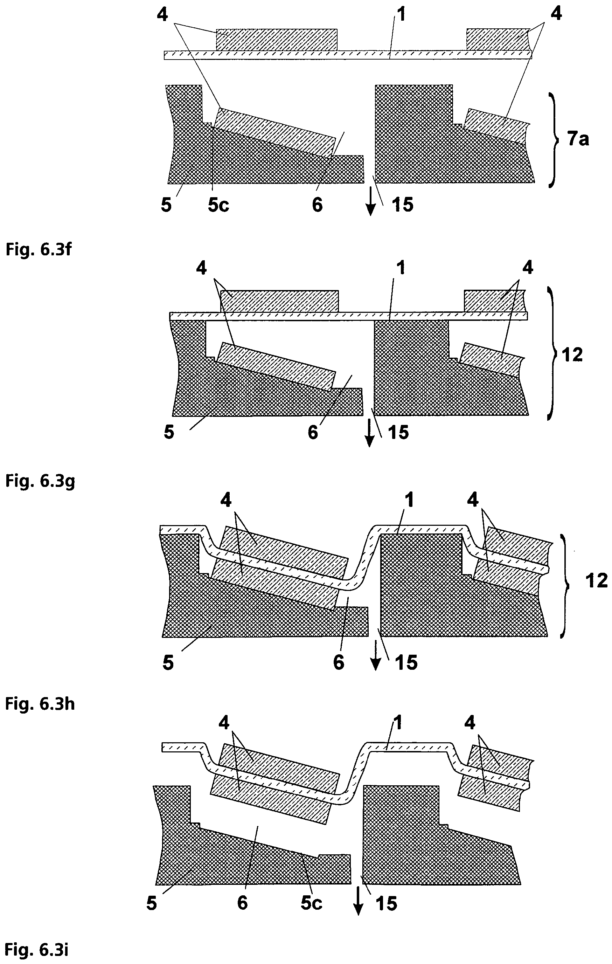

Bei einer zentrischen Anordnung des Verstärkungselements im Auslenkungsbereich kann ein Neigen des durch das Verstärkungselement abgedeckten Bereichs des ersten Substrats durch eine in Bezug auf das Verstärkungselement nicht zentrische Kraft erreicht werden. Besonders vorteilhaft und effektiv zur Gewährleistung einer Neigung ist eine sowohl nicht zentrische Anordnung des Verstärkungselements als auch eine in Bezug auf das Verstärkungselement nicht zentrische Kraft. Zudem kann ein Neigen des ersten Substrats beziehungsweise des durch das Verstärkungselement abgedeckten Bereichs des ersten Substrats durch einen geneigten Bereich im zweiten Substrat bewirkt werden (z.B. Fig. 6-6.1).

Um ein möglichst problemloses verformungsbedingtes Auslenken gewährleisten zu können, sollte zwischen dem Auslenkungsbereich des ersten Substrats und dem zweiten Substrat vor dem Erwärmen und Verformen vorzugsweise ein direkter oder indirekter (z.B. durch ein oder mehrere zwischengelagerte Verstärkungselemente bedingt) Kontakt, der zu einem Anhaften führen könnte, verhindert werden.

Um die Haftkräfte im Falle eines Kontaktes zu verringern, werden bevorzugt die Oberflächen beziehungsweise bestimmte Oberflächenbereiche des Verstärkungselements, des ersten Substrats und/oder des zweiten Substrats derart präpariert, dass eine Verbindung zwischen dem Auslenkungsbereich des ersten Substrats und dem zweiten Substrat verhindert wird. Dies lässt sich durch verschiedene Beschichtungen und/oder Verfahren zur Oberflächenmodifikation realisieren, die zur Reduktion der Kontaktkräfte beitragen. Geeignete Beschichtungsmaterialien sind beispielsweise Platin, NiAI-Legierung (zum Beispiel Legierung aus 50% Ni und 50% Al), Graphit und Bornitrid.

Eine Alternative zum erfindungsgemäßen Verfahren nach Anspruch 1 stellt das erfindungsgemäße Verfahren nach Anspruch 2 dar, welches ebenfalls zur Herstellung optischer Komponenten dient und die folgenden Schritte aufweist:
- Bereitstellen eines ersten Substrats und eines zweiten Substrats,
- Bereitstellen mindestens eines Verstärkungselements durch Abtrennen von einem Verstärkungssubstrat,
- Erzeugen eines Stapels durch Anordnen des mindestens einen Verstärkungselements auf dem zweiten Substrat,
- in Kontakt bringen des ersten Substrats mit dem Stapel derart, dass zumindest ein Teil des Verstärkungselements beabstandet zum ersten Substrat angeordnet wird,
- Erwärmen und Verformen des ersten Substrats derart, dass ein Bereich des ersten Substrats mit dem mindestens einen Verstärkungselement in Kontakt gebracht wird.

Die vorherigen Ausführungen zu den ersten beiden Verfahrensschritten - das Bereitstellen eines ersten und eines zweiten Substrats sowie das Bereitstellen mindestens eines Verstärkungselements - des erfindungsgemäßen Verfahrens nach Anspruch 1 gelten äquivalent für die ersten beiden Verfahrensschritte des erfindungsgemäßen Verfahrens nach Anspruch 2.

Der Stapel aus Verstärkungselement und zweitem Substrat wird im Weiteren als "Grundstapel" bezeichnet.

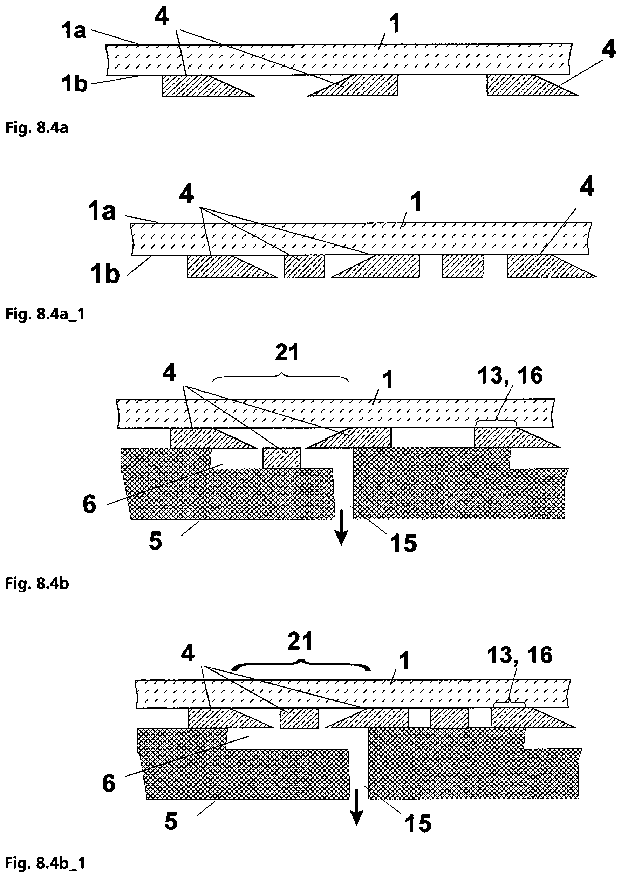

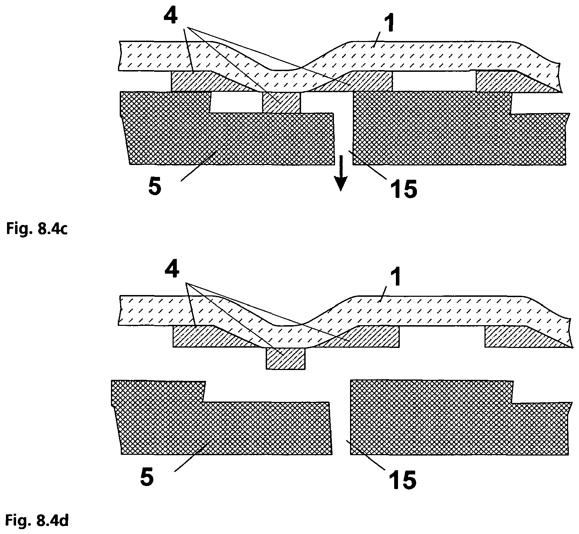

In einer vorteilhaften Ausgestaltung des erfindungsgemäßen Verfahrens nach Anspruch 2 weist das bereitgestellte erste Substrat mindestens ein weiteres Verstärkungselement auf, wobei das weitere Verstärkungselement einen Bereich des ersten Substrats abdeckt (abgedeckter Bereich) und das erste Substrat und das weitere Verstärkungselement einen weiteren Stapel (weiterer Basisstapel) bilden, der beim Schritt des Inkontaktbringens mit dem Grundstapel in Kontakt gebracht wird, und wobei das Erwärmen und Verformen des ersten Substrats zudem derart erfolgt, dass sich zumindest ein Teil des durch das weitere Verstärkungselement abgedeckten Bereichs des ersten Substrats verschiebt und/oder neigt (z.B. Fig. 6.3), und/oder dass ein Bereich des ersten Substrats mit dem weiteren Verstärkungselement in Kontakt gebracht wird (z.B. Fig. 8.4). Ein Vorteil dieser Ausführungsform besteht insbesondere darin, dass das erste Substrat während des Verfahrens nicht gewendet werden muss und trotzdem eine Unterstützung (z.B. Stabilisierung, Abformung) beider Substratseiten des ersten Substrats durch Verstärkungselemente gewährleistet wird. Dies ist beispielsweise von Bedeutung, wenn das Verstärkungselement auf dem ersten Substrat formschlüssig, z.B. in einer Justiervertiefung, angeordnet ist.

Die vorherigen Ausführungen zum Verstärkungselement und zum Basisstapel des erfindungsgemäßen Verfahrens nach Anspruch 1 gelten äquivalent für das weitere Verstärkungselement und den durch dessen Anordnung auf dem ersten Substrat erzeugten weiteren Stapel (weiterer Basisstapel).

Beispielhaft kann das weitere Verstärkungselement auf der nach dem Inkontaktbringen des weiteren Basisstapels mit dem Grundstapel vom zweiten Substrat abgewandten Substratseite des ersten Substrats angeordnet werden und das mindestens eine Verstärkungselement wird auf dem zweiten Substrat angeordnet. Durch den Schritt des Erwärmen und Verformens wird der durch das weitere Verstärkungselement abgedeckte Bereich des ersten Substrats beispielsweise geneigt und/oder verschoben und der Oberflächenbereich des abgedeckten Bereich des ersten Substrats, der dem zweiten Substrat zugewandt ist, wird mit dem mindestens einen Verstärkungselement in Kontakt gebracht, so dass im Ergebnis ein beidseitig von Verstärkungselementen unterstützter Bereich des ersten Substrats erzeugt werden kann (z.B. Fig. 6.3). Dadurch lassen sich qualitativ hochwertige Oberflächen des abgedeckten Bereichs des ersten Substrats auf beiden Substratseiten realisieren.

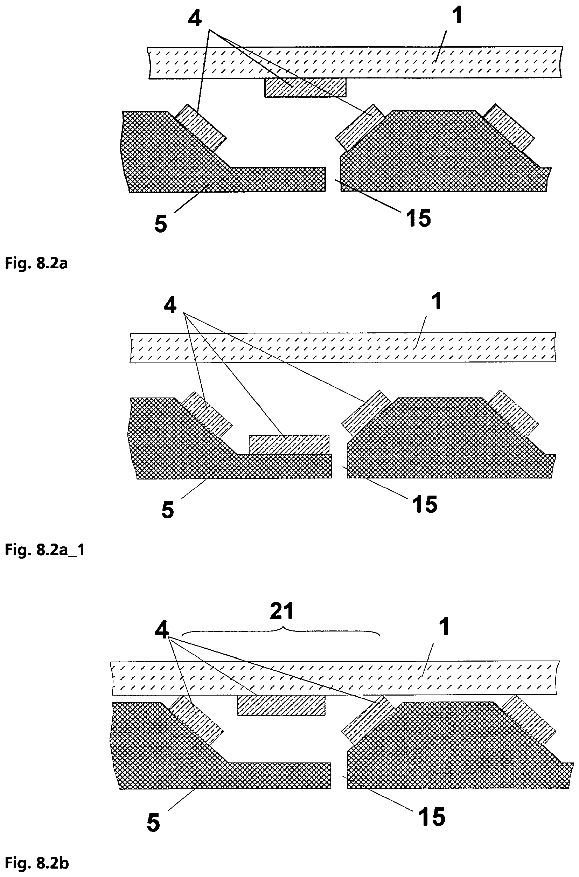

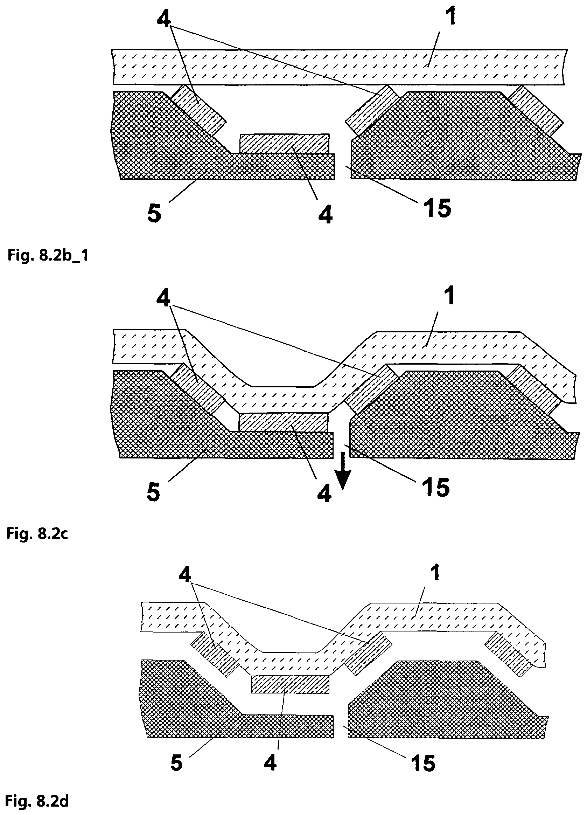

Des Weiteren kann ein Bereich des ersten Substrats, der außerhalb des durch das weitere Verstärkungselement abgedeckten Bereichs des ersten Substrats liegt, durch den Verfahrensschritt des Erwärmen und Verformens in Kontakt mit dem mindestens einen Verstärkungselement gebracht werden, während der durch das weitere Verstärkungselement abgedeckte Bereich des ersten Substrats geneigt und/oder verschoben wird (z.B. Fig. 8.2a). Dadurch lassen sich mehrere optische Bereiche, beispielsweise mehrere optische Fenster, durch denselben Schritt des Erwärmen und Verformens herstellen.

In einer weiteren bevorzugten Ausführungsform des erfindungsgemäßen Verfahrens nach Anspruch 2 erfolgt das Bereitstellen des ersten Substrats mit dem weiteren Verstärkungselement derart, dass das weitere Verstärkungselement durch Abtrennen von einem Verstärkungssubstrat bereitgestellt und auf dem ersten Substrat angeordnet wird und/oder dass auf dem ersten Substrat eine Verstärkungsschicht aufgebracht wird, die zur Erzeugung des weiteren Verstärkungselements strukturiert wird.

Bezüglich des Bereitstellens des weiteren Verstärkungselements durch Abtrennen von einem Verstärkungssubstrat und dessen Anordnen auf dem ersten Substrat wird wiederum auf die Ausführungen zum erfindungsgemäßen Verfahren nach Anspruch 1 verwiesen, die für diese Ausführungsform nach Anspruch 2 äquivalent gelten.

Alternativ kann das erste Substrat mit dem weiteren Verstärkungselement, entsprechend der weitere Basisstapel, durch das Aufbringen mindestens einer Verstärkungsschicht auf das erste Substrat und das Strukturieren dieser Verstärkungsschicht zur Realisierung des weiteren Verstärkungselements erzeugt werden.

Die Verstärkungsschicht kann beispielsweise mittels Abscheideverfahren auf das erste Substrat aufgebracht werden und/oder die Verstärkungsschicht wird durch die Verwendung mindestens eines weiteren Substrats realisiert.

Die Verstärkungsschicht, insbesondere das weitere Verstärkungselement, besteht bevorzugt aus einem halbleitenden Material oder enthält bevorzugt zumindest in Teilbereichen ein halbleitendes Material. Besonders bevorzugt finden Siliziumschichten, insbesondere Polysiliziumschichten, und/oder als weiteres Substrat ein Halbleiterwafer, bevorzugt ein Siliziumwafer, Verwendung, um die ausgereiften und gut beherrschbaren Prozesse der Halbleitertechnologie, insbesondere der Siliziumtechnologie, einsetzen zu können.

Beim Aufbringen der Verstärkungsschicht auf das erste Substrat werden das erste Substrat und die Verstärkungsschicht vorzugsweise stoffschlüssig miteinander verbunden, um eine hohe Lagestabilität der Verstärkungsschicht gegenüber dem ersten Substrat zu gewährleisten. Dafür sind generell alle zweckmäßigen Techniken einsetzbar wie zum Beispiel Abscheiden, Kleben, Löten oder Bonden.

Zweckmäßig erfolgt das Aufbringen der Verstärkungsschicht auf das erste Substrat derart, dass ein Verschieben und/oder Verdrehen der Verstärkungsschicht gegenüber dem ersten Substrat reduziert oder verhindert wird.

Bevorzugt wird als Verstärkungsschicht eine Polysiliziumschicht mittels CVD, insbesondere Hot Wire-CVD oder PECVD, oder PVD (z.B. Sputtern) auf das erste Substrat aufgebracht. Da die Prozesstemperaturen bei diesen Abscheideverfahren unter 600°C, bevorzugt zwischen 400°C und 500°C, liegen, lassen sich damit auch temperaturempfindlichere Substrate beschichten.

Des Weiteren kann die Verstärkungsschicht, zum Beispiel ein Siliziumwafer, durch anodisches Bonden und/oder thermisches Bonden auf das erste Substrat aufgebracht beziehungsweise mit diesem verbunden werden. Vor allem in der Halbleiterindustrie sind diese Bondverfahren häufig eingesetzte Verbindungstechniken, die zu stabilen Verbindungen führen.

Vorzugsweise weist die Verstärkungsschicht zumindest auf der Schichtseite, die mit dem ersten Substrat in Verbindung gebracht wird, mindestens eine zweite Vertiefung auf. Diese zweite Vertiefung soll einen Kontakt zwischen dem ersten Substrat und der Verstärkungsschicht in bestimmten Bereichen des ersten Substrats beim Anordnen/Aufbringen verhindern, um die Oberflächenqualität des ersten Substrats in diesen Bereichen für weitere Verbindungs- und/oder Kontaktierungsschritte zu konservieren. Solche zu konservierenden Bereiche sind insbesondere die Bereiche des ersten Substrats, die nicht mit dem Verstärkungselement versehen beziehungsweise nicht mit dem Verstärkungselement in Kontakt gebracht werden. Die zweiten Vertiefungen in der mindestens einen Verstärkungsschicht weisen bevorzugt Tiefen von etwa 0,5 µm bis etwa 1 µm auf.

Die Strukturierung der Verstärkungsschicht zur Erzeugung von mindestens einem weiteren Verstärkungselement erfolgt derart, dass eine Verformung der beispielsweise als optische Fenster fungierenden Bereiche des ersten Substrats reduziert oder verhindert wird. Dies wird insbesondere dadurch erreicht, dass die Verstärkungsschicht die beispielsweise als optische Fenster fungierenden Bereiche des ersten Substrats zumindest teilweise abdeckt beziehungsweise bedeckt. Die Bereiche der Verstärkungsschicht, die nicht als Verstärkungselemente fungieren, können beispielsweise mittels naß- und/oder trockenchemischen Ätzverfahrens entfernt werden Das zusätzliche Material der weiteren Verstärkungselemente stabilisiert und schützt die abgedeckten Bereiche des ersten Substrats und wirkt einer Verformung entgegen. Dadurch lassen sich die bevorzugt beim bereitgestellten ersten Substrat vorhandene hohe Ebenheit, Planparallelität und geringe Oberflächenrauigkeit erhalten, was die Basis für qualitativ hochwertige optische Fenster ist, und zudem Flächen - insbesondere Transmissionsflächen, die einer nachträglichen Bearbeitung (zum Beispiel einem Polierschritt) nicht zugänglich sind, mit einer hohen Oberflächenqualität realisieren.

In einem weiteren Verfahrensschritt des erfindungsgemäßen Verfahrens nach Anspruch 2 wird durch Anordnen des mindestens einen Verstärkungselements auf dem zweiten Substrat ein Stapel (Grundstapel) erzeugt.

Das Anordnen des Verstärkungselements auf dem zweiten Substrat kann beispielsweise mit einem Vakuumhandler (Vakuumsauger), einem Greifer (Collet) oder einem Pickup-Tool (Kombination aus Vakuumsauger und Greifer) erfolgen, die eine positionsgenaue und präzise Anordnung des Verstärkungselements auf dem zweiten Substrat gewährleisten. Durch eine Anordnung des Verstärkungselements auf dem zweiten Substrat wird das erste Substrat keinen mit der Anordnung verbundenen Prozessschritten (z.B. Abscheide-, Ätz-, Verbindungsprozesse) ausgesetzt, die beispielsweise die Oberflächen- und Materialqualität des ersten Substrats beeinflussen können.

Dabei wird das Verstärkungselement bevorzugt auf einem Oberflächenbereich des zweiten Substrats angeordnet, der nach dem Inkontaktbringen des ersten Substrats mit dem Grundstapel dem Auslenkungsbereich des ersten Substrats zugewandt ist. Das Verstärkungselement wird insbesondere in einer dritten Vertiefung, bevorzugt auf dem Boden der dritten Vertiefung, und/oder in einer Durchführung des zweiten Substrats angeordnet. Durch diese Ausgestaltungen lässt sich das Inkontaktbringen des ersten Substrats mit dem Verstärkungselement im Zuge des Erwärmen und Verformens begünstigen. Durch das Verstärkungselement wird beispielsweise gewährleistet, dass der Auslenkungsbereich des ersten Substrats, insbesondere der Bereich, für den eine hohe optische Oberflächenqualität gefordert wird, nicht mit dem zweiten Substrat in Kontakt gebracht wird. Maßgebend für die erzeugte Oberflächenqualität im Auslenkungsbereich, z.B. in dem Bereich, der als optisches Fenster fungieren soll, ist entsprechend die Oberflächenqualität des Oberflächenbereichs des Verstärkungselements, der durch das Erwärmen und Verformen mit dem ersten Substrat in Kontakt gebracht wird. Dies hat den Vorteil, dass geringere Anforderungen an die Oberflächenqualität des zweiten Substrats gestellt werden können und der Aufwand für die Bereitstellung des zweiten Substrats reduziert werden kann.

Beim Anordnen beziehungsweise Aufbringen des mindestens einen Verstärkungselements auf dem zweiten Substrat werden das zweite Substrat und das Verstärkungselement vorzugsweise formschlüssig und/oder stoffschlüssig, insbesondere durch Kleben, Löten oder Bonden, miteinander verbunden, um eine hohe Lagestabilität des Verstärkungselements gegenüber dem zweiten Substrat zu gewährleisten.

Eine formschlüssige Verbindung kann dadurch realisiert werden, dass das mindestens eine Verstärkungselement in einer bevorzugt ausgebildeten Justiervertiefung des zweiten Substrats, die für die Aufnahme des Verstärkungselements ausgebildet ist, angeordnet wird. Bei dieser Art der Anordnung sind keine zusätzlichen Verbindungssubstanzen (z.B. Klebstoff) beziehungsweise spezielle Verbindungsschritte (z.B. Bonden) erforderlich, die die Oberflächenqualität des Verstärkungselements beeinträchtigen könnten.

In einer besonderen Ausführungsform des erfindungsgemäßen Verfahrens nach Anspruch 2 wird das mindestens eine Verstärkungselement vor dem Anordnen auf dem zweiten Substrat auf einem Positionierungsmittel, insbesondere einem Aufnahmesubstrat, angeordnet.

In Bezug auf die mit diesen Ausführungsformen verbundenen Wirkungen und Vorteile beziehungsweise weiterer Ausgestaltungsdetails wird auf die äquivalent geltenden Ausführungen zum erfindungsgemäßen Verfahren nach Anspruch 1 und der Verwendung eines Positionierungsmittels beziehungsweise Aufnahmesubstrats zur Anordnung des Verstärkungselements auf dem ersten Substrat verwiesen, wobei die dortige Bezugnahme auf das erste Substrat und den Basisstapel durch einen Bezug auf das zweite Substrat und den Grundstapel zu ersetzen ist.

Vorzugsweise kann das mindestens eine Verstärkungselement mindestens ein Fixierungselement aufweisen beziehungsweise mit mindestens einem Fixierungselement in wechselseitiger Wirkbeziehung (z.B. mechanische, elektrostatische und/oder magnetische Kraftkopplung) stehen. Das Fixierungselement reduziert oder verhindert insbesondere nach dem in Kontakt bringen des weiteren Basisstapels oder des ersten Substrats mit dem Grundstapel, insbesondere dem zweiten Substrat, ein Verschieben und/oder Verdrehen des mindestens einen Verstärkungselements gegenüber dem zweiten Substrat und erhöht damit die Lagestabilität des Verstärkungselements. Vorzugsweise stehen das Verstärkungselement und das Fixierungselement miteinander mechanisch in Verbindung, um eine möglichst stabile Kraftkopplung gewährleisten zu können.

Bevorzugt wird das Fixierungselement im Verfahrensschritt des Inkontaktbringens des weiteren Basisstapels oder des ersten Substrats mit dem Grundstapel zwischen dem weiteren Basisstapel oder dem ersten Substrat und dem Grundstapel, insbesondere dem zweiten Substrat, eingeklemmt. Beispielsweise durch Aufnahmenuten - zum Beispiel im ersten Substrat, lässt sich trotz des zwischengelagerten beziehungsweise eingeklemmten Fixierungselements ein zweckmäßiger Kontakt zwischen dem weiteren Basisstapel oder dem ersten Substrat und dem Grundstapel gewährleisten.

In einer weiteren bevorzugten Ausführungsform wird das Fixierungselement beim Verfahrensschritt des Anordnens des Verstärkungselements auf dem zweiten Substrat mit dem zweiten Substrat stoffschlüssig, insbesondere mittels thermischen oder anodischen Bondens, verbunden, wodurch eine besonders stabile Verbindung und damit eine besonders gute Lagestabilität des Verstärkungselements gewährleistet werden kann.

In einer bevorzugten Ausführungsform des erfindungsgemäßen Verfahrens nach Anspruch 2 wird das Verstärkungselement auf einem Oberflächenbereich des zweiten Substrats angeordnet, der geneigt in Bezug auf mindestens eine Substratebene des zweiten Substrats beziehungsweise auf mindestens eine Substratebene des ersten Substrats nach dem Schritt des Inkontaktbringens des Grundstapels mit dem ersten Substrat oder dem weiteren Basisstapel ausgebildet ist. Dadurch lässt sich durch den Schritt des Erwärmen und Verformens ein von dem Verstärkungselement unterstützter geneigter Bereich des ersten Substrats (z.B. Fig. 6.1) erzeugen. Um die Lagestabilität des Verstärkungselements auf dem zweiten Substrat zu erhöhen, weist der geneigte Oberflächenbereich des zweiten Substrats bevorzugt eine Justiervertiefung auf.

In einer weiteren Ausgestaltung ist das Verstärkungselement keilförmig ausgebildet, um auf einem nicht geneigten Oberflächenbereich des zweiten Substrats nach Anordnung des Verstärkungselements eine geneigte Oberfläche zur Unterstützung des ersten Substrats und damit die Erzeugung eines geneigten Bereichs im ersten Substrat zu gewährleisten. Dadurch lässt sich die Flexibilität des Verfahrens erhöhen, weil zur Realisierung unterschiedlich stark geneigter Bereiche im ersten Substrat lediglich verschieden stark keilförmig ausgebildete Verstärkungselemente bereitgestellt und auf dem zweiten Substrat angeordnet werden müssen. Das zweite Substrat kann so unabhängig von den verwendeten Verstärkungselementen eingesetzt werden und muss nicht durch entsprechende an die Anforderungen (geforderte Neigung) angepasste zweite Substrate ersetzt werden.

In einer weiteren vorteilhaften Ausführungsform wird auf beiden Substratseiten des zweiten Substrats mindestens ein Verstärkungselement angeordnet, wodurch das zweite Substrat beziehungsweise der so erzeugte Grundstapel mit jeder seiner Substratseiten ein erstes Substrat oder einen weiteren Basisstapel aufnehmen beziehungsweise damit in Kontakt gebracht werden kann. Dadurch können zwei erste Substrate parallel bearbeitet beziehungsweise erwärmt und verformt werden, wodurch eine Kostenreduzierung erreicht werden kann.

In einem weiteren Verfahrensschritt des erfindungsgemäßen Verfahrens nach Anspruch 2 wird das erste Substrat oder der weitere Basisstapel mit dem Grundstapel in Kontakt gebracht, um wie beschrieben das erste Substrat in den Auflagebereichen zu stützen und eine stabile Kraftaufnahme in diesen Bereichen zu gewährleisten. Zudem kann das zweite Substrat und/oder das Verstärkungselement als Auslenkungsbegrenzung dienen.

Die vorherigen Ausführungen zum erfindungsgemäßen Verfahren nach Anspruch 1 bezüglich des Inkontaktbringens, insbesondere Verbindens, des Basisstapels mit dem zweiten Substrat gelten äquivalent in Bezug auf das Inkontaktbringen, insbesondere Verbinden, des ersten Substrats oder des weiteren Basisstapels mit dem Grundstapel, insbesondere dem zweiten Substrat, gemäß dem erfindungsgemäßen Verfahren nach Anspruch 2, wobei bei dieser äquivalenten Betrachtungsweise der Basisstapel und das zweite Substrat gemäß dem Verfahren nach Anspruch 1 durch den weiteren Basisstapel und den Grundstapel gemäß dem Verfahren nach Anspruch 2 zu ersetzen sind. Entsprechend erfolgt das Inkontaktbringen des weiteren Basisstapels und des Grundstapels vorzugsweise derart, dass ein Hohlraum zwischen dem weiteren Basisstapel, insbesondere dem ersten Substrat, und dem Grundstapel, insbesondere dem zweiten Substrat, gebildet wird.

In einer bevorzugten Ausführungsform erfolgt das Erzeugen des Grundstapels und dessen Inkontaktbringen mit dem ersten Substrat oder dem weiteren Basisstapel derart, dass das mindestens eine Verstärkungselement zumindest teilweise zwischen dem ersten und dem zweiten Substrat, insbesondere zumindest teilweise auf der dem ersten Substrat zugewandten Substratseite des zweiten Substrats, angeordnet wird.

Die Anordnung des Verstärkungselements zwischen dem ersten und zweiten Substrat bedeutet erfindungsgemäß, dass das Verstärkungselement zumindest teilweise auf der dem ersten Substrat zugewandten Substratseite des zweiten Substrats und/oder zumindest teilweise in einer Durchführung beziehungsweise Ausnehmung des zweiten Substrats angeordnet wird.

Durch eine solche Anordnung lässt sich das Verstärkungselement in Bezug auf das erste Substrat besonders vorteilhaft positionieren, wodurch das Verfahren flexibler und weniger aufwendig wird.

Bevorzugt ist das Verstärkungselement nicht auf der dem ersten Substrat abgewandten Substratseite des zweiten Substrats angeordnet, was in Verbindung mit einer Anordnung des Verstärkungselements auf der dem ersten Substrat zugewandten Substratseite des zweiten Substrats und/oder in einer Durchführung beziehungsweise Ausnehmung des zweiten Substrats den Vorteil hat, dass bei einer bevorzugt vorliegenden Verbindung des Verstärkungselements mit dem ersten Substrat nach dem Erwärmen und Verformen ein Abheben des ersten Substrats und des mit ihm verbundenen Verstärkungselements vom zweiten Substrat möglich ist und so keine aufwendigen Prozesse zur Entfernung des zweiten Substrats gefahren werden müssen. Das zweite Substrat kann dann zum Beispiel ohne regenerative Maßnahmen wiederverwendet werden.

Eine Anordnung des Verstärkungselements zwischen dem ersten und zweiten Substrat kann alternativ während des Verfahrensschritts des Erwärmen und Verformens erfolgen.

Die vorherigen Ausführungen zum erfindungsgemäßen Verfahren nach Anspruch 1 bezüglich des Erwärmen und Verformens des ersten Substrats gelten äquivalent in Bezug auf das Erwärmen und Verformen des ersten Substrats gemäß dem erfindungsgemäßen Verfahren nach Anspruch 2, wobei bei dieser äquivalenten Betrachtungsweise der Basisstapel beziehungsweise das Verstärkungselement gemäß dem Verfahren nach Anspruch 1 durch den weiteren Basisstapel beziehungsweise das weitere Verstärkungselement gemäß dem Verfahren nach Anspruch 3 zu ersetzen sind.

Der Verfahrensschritt des Erwärmen und Verformens des ersten Substrats erfolgt derart, dass ein Bereich des ersten Substrats mit dem mindestens einen Verstärkungselement in Kontakt gebracht wird, wobei zumindest ein Teil des Verstärkungselements beabstandet zum ersten Substrat angeordnet ist. Durch das Erwärmen und Verformen wird ein Bereich des ersten Substrats mit dem Verstärkungselement, insbesondere dem beabstandet angeordneten Teil des Verstärkungselements, in Kontakt gebracht. Dabei wird bevorzugt der mit dem ersten Substrat in Kontakt gebrachte Oberflächenbereich des Verstärkungselements, der beispielsweise eine hohe Oberflächenqualität mit geringer Rauigkeit und geringer Ebenheitsabweichung aufweist, auf das erste Substrat abgeformt und so ein qualitativ hochwertiger optischer Bereich im ersten Substrat erzeugt. Dies hat wiederum den Vorteil, dass die Anforderungen an die Oberflächenqualität der entsprechenden Substratseite/n des bereitgestellten ersten Substrats geringer sein können und damit ein eventuell notwendiger Bearbeitungsschritt, wie z.B. das Polieren, entfallen kann.

Häufig ist in diesem Fall der Auslenkungsbereich mit dem Verformungsbereich des ersten Substrats identisch. In einer besonderen Ausgestaltung kann der Auslenkungsbereich aus dem Verformungsbereich und einem nicht für die Verformung vorgesehenen Bereich des ersten Substrats bestehen. In diesem Fall wird durch lokale Erwärmung des Verformungsbereichs ein Auslenken des nicht für die Verformung vorgesehenen Bereichs des ersten Substrats und damit ein Inkontaktbringen dieses Bereichs des ersten Substrats mit dem Verstärkungselement gewährleistet. Im Ergebnis entsteht ein verschobener und/oder geneigter Bereich im ersten Substrat.

In einer bevorzugten Ausführungsform werden zumindest Teilbereiche der durch das Erwärmen und Verformen miteinander in Kontakt gebrachten Bereiche des ersten Substrats und des Verstärkungselements miteinander verbunden, insbesondere stoffschlüssig verbunden. Eine solche Verbindung wird bevorzugt durch thermisches Bonden erreicht. Dadurch wird ein besonders effektives Abformen des Oberflächenbereichs beziehungsweise der Oberflächenstruktur des Verstärkungselements auf das erste Substrat gewährleistet und das Verstärkungselement kann nach dem Erwärmen und Verformen zusammen mit dem ersten Substrat vom zweiten Substrat entfernt werden. Nach dem Entfernen des Verstärkungselements vom ersten Substrat können das Verstärkungselement und das zweite Substrat dann vorzugsweise wiederverwendet werden.

Insbesondere wenn das mindestens eine Verstärkungselement, das mindestens eine weitere Verstärkungselement, die mindestens eine Auflagestruktur und/oder das mindestens eine Fixierungselement, die im Weiteren unter der Bezeichnung "Hilfselemente" zusammengefasst werden, keine weiteren Funktionen zu erfüllen haben, werden diese bevorzugt in einem weiteren Verfahrensschritt zumindest teilweise, bevorzugt komplett, entfernt.

Besonders bevorzugt erfolgt das Entfernen derart, dass mindestens eines der Hilfselemente wiederverwendet und mehrfach eingesetzt werden kann, wodurch die Effizienz des Verfahrens erhöht und der Fertigungsaufwand beziehungsweise die Fertigungskosten reduzieren werden können.

Dies lässt sich insbesondere dadurch realisieren, dass mindestens eines der Hilfselemente zumindest in dem Bereich/en, der mit dem ersten Substrat in Verbindung gebracht wird, eine Opferschicht aufweist, die nach dem Verformen des ersten Substrats zur Freigabe des Hilfselements entfernt wird. Alternativ kann die Opferschicht erst auf dem ersten Substrat aufgebracht und strukturiert werden, wobei die Hilfselemente dann in einem nachfolgenden Verfahrensschritt auf der Opferschicht und damit auf dem ersten Substrat angeordnet werden.

Eine bevorzugte Opferschicht enthält oder besteht aus Silizium, Germanium, Zinkoxid, Molybdän und/oder Wolfram. Für solche über eine Opferschicht mit dem ersten Substrat in Verbindung stehende Hilfselemente können Materialien, wie z.B. hochschmelzende bzw. hochtemperaturfeste Gläser (z.B. Corning Eagle XG®, Corning Lotus Glass®, Schott AF32®), einsetzt werden, die sich bei einer direkten Verbindung mit dem ersten Substrat unter der Maßgabe, dass das erste Substrat beziehungsweise die fertiggestellte Komponente nicht beschädigt werden soll, nur mit hohen Aufwand entfernen lassen.

Für bestimmte Anwendungen kann es allerdings von Vorteil sein, dass Teile des Verstärkungselements beziehungsweise des weiteren Verstärkungselements, zum Beispiel als rahmenförmige Stabilisierungsstruktur oder Blendenstruktur, auf dem ersten Substrat beziehungsweise der fertigen optischen Komponente verbleibt.

Auch das mindestens eine zweite Substrat wird nach dem Verformen bevorzugt komplett entfernt. In manchen Fällen sind auf dem zweiten Substrat allerdings die zu verkapselnden Mikro-Systeme angeordnet, so dass ein Bestehen bleiben der Verbindung zwischen Basisstapel beziehungsweise weiteren Basisstapel und dem Grundstapel beziehungsweise dem zweiten Substrat durchaus sinnvoll sein kann.

In einer vorteilhaften Ausgestaltung werden zumindest Teilbereiche des ersten Substrats mit mindestens einer Veredlungsbeschichtung - insbesondere mit einer Entspiegelungsbeschichtung, einer Antistatik-Beschichtung, einer Reflexionsbeschichtung und/oder einer Absorbtionsbeschichtung, und/oder funktionalen Oberflächenstrukturen versehen, wodurch sich die Funktionalität der optischen Komponente verbessern lässt.

Bevorzugt eingesetzte Veredlungsbeschichtungen sind Entspiegelungsbeschichtungen, die z.B. Reflexionen an einem Deckel, insbesondere an dessen optischen Fenstern, und damit Strahlungsverluste weiter verringern. Solche Entspiegelungsbeschichtungen lassen sich zum Beispiel durch Schichtsysteme aus Magnesiumfluorid und Titanoxid, oder Siliziumdioxid und Titanoxid realisieren.

Des Weiteren finden bevorzugt Antistatik-Beschichtungen, die ein elektrisches Aufladen der optischen Komponente minimieren, Verwendung.

Ein für Antistatik-Beschichtungen in optischen Anwendungen besonders geeignetes Material ist ITO (Indiumzinnoxid), da es dotiert eine hohe elektrische Leitfähigkeit aufweist und über einen breiten Wellenlängenbereich eine hohe Transparenz aufweist.

Weiterhin kann es vorteilhaft sein, wenn Reflexionsbeschichtungen, zum Beispiel Metallschichten, als Veredlungsbeschichtungen aufgebracht werden, die nach Strukturierung lokal reflektierende Bereiche bilden, zum Beispiel um einen einfallenden Lichtstrahl räumlich zu begrenzen (Blendenfunktion) oder um in Nachbarschaft zu den optischen Fenstern einen statischen Umlenkspiegel zu bilden.

Bevorzugt eingesetzte Veredlungsbeschichtungen sind des Weiteren Absorptionsbeschichtungen, die elektromagnetische Strahlung bestimmter Wellenlängen oder ganzer Wellenlängenbereiche absorbieren.

Funktionale Oberflächenstrukturen sind im Sinne der Erfindung geometrische Modifikationen der Oberfläche im Mikro- und/oder Nanometerbereich, wodurch bestimmte Oberflächeneigenschaften gezielt beeinflusst werden können. So kann durch den bevorzugten Einsatz von Mottenaugenstrukturen (siehe Druckschrift D.G. Stavenga, S. Foletti, G. Palasantzas, K. Arikawa "Light on the moth-eye corneal nipple array of butterflies", Proceedings of the Royal Society B (2006) 273, 661-667, doi: 10.1098/rspb.2005.3369, Published online 6 December 2005), deren strukturellen Abmaße unterhalb der Wellenlänge der in der Anwendung eingesetzten Strahlung liegen, der Brechungsindex einer Grenzschicht -wie sie zum Beispiel zwischen einer Glasoberfläche und der sie umgebenden Luft besteht - verringert werden, weshalb sich Mottenaugenstrukturen zur Entspiegelung von Oberflächen eignen. Eine solche Entspiegelung ist insbesondere dann von Vorteil, wenn sich eine Beschichtung aus Haftungsgründen als ungeeignet erweist.

Mottenaugenstrukturen lassen sich beispielsweise mit Hilfe von Prägeverfahren nach der Formgebung des ersten Substrats auf den Oberflächen des ersten Substrats erzeugen. Das Einprägen solcher Strukturen in geneigte und/oder verschobene Oberflächen ist allerdings äußerst problematisch. Insbesondere auf geneigten Oberflächen lassen sich Mottenaugenstrukturen durch die Ausnutzung der Fließeigenschaften des ersten Substrats herstellen.

Entsprechend werden in einer bevorzugten Ausführungsform Mottenaugenstrukturen als funktionale Oberflächenstrukturen derart erzeugt, dass vor dem Anordnen und/oder dem Inkontaktbringen des mindestens einen Verstärkungselements und/oder des weiteren Verstärkungselements auf/mit dem ersten Substrat zumindest der Bereich des mindestens einen Verstärkungselements und/oder des weiteren Verstärkungselements, der mit dem ersten Substrat in Kontakt gebracht wird, mit einer Negativform der Mottenaugenstrukturen versehen wird und nach dem Anordnen und/oder dem Inkontaktbringen des mindestens einen Verstärkungselements und/oder des weiteren Verstärkungselements auf/mit dem ersten Substrat während der Formgebung des ersten Substrats die Mottenaugenstrukturen auf der ersten und/oder zweiten Substratseite des ersten Substrats erzeugt werden, indem die Negativform in dem mindestens einen Verstärkungselement und/oder dem weiteren Verstärkungselement auf die erste und/oder zweite Substratseite des ersten Substrats, insbesondere auf die Transmissionsflächen der optischen Fenster, abgeformt wird. Dabei fließt das erste Substrat in die durch die Negativform in dem mindestens einen Verstärkungselement und/oder dem weiteren Verstärkungselement vorgegebenen Hohlformen, wodurch die entsprechende Oberflächengeometrie entsteht. Die Formgebung des ersten Substrats und die Erzeugung der Mottenaugenstrukturen können auch zeitlich separiert beziehungsweise nacheinander in unabhängigen Schritten erfolgen.

In einer weiteren bevorzugten Ausführungsform wird die Veredlungsbeschichtung derart erzeugt, dass vor dem Anordnen und/oder dem Inkontaktbringen des mindestens einen Verstärkungselements und/oder des weiteren Verstärkungselements auf/mit dem ersten Substrat zumindest der Bereich des mindestens einen Verstärkungselements und/oder des weiteren Verstärkungselements, der mit dem ersten Substrat in Kontakt gebracht wird, mit der Veredlungsbeschichtung versehen wird und anschließend eine Verbindung zwischen dem ersten Substrat und dem mindestens einen Verstärkungselements und/oder dem weiteren Verstärkungselements durch eine Verbindung zwischen der Veredlungsbeschichtung und dem ersten Substrat hergestellt wird oder dass vor dem Anordnen und/oder dem Inkontaktbringen des mindestens einen Verstärkungselements und/oder des weiteren Verstärkungselements auf/mit dem ersten Substrat die Veredlungsbeschichtung auf das erste Substrat aufgebracht wird und anschließend das mindestens eine Verstärkungselement und/oder das weitere Verstärkungselement auf/mit der Veredlungsbeschichtung angeordnet und/oder in Kontakt gebracht wird, wobei nach dem Verformungsschritt das mindestens eine Verstärkungselement und/oder das weitere Verstärkungselement zumindest teilweise entfernt wird und die Veredlungsbeschichtung auf dem ersten Substrat, insbesondere auf den optischen Fenstern, verbleibt. Mit dem Aufbringen der Veredlungsbeschichtung auf das erste Substrat vor der Verformung des ersten Substrats lässt sich insbesondere auf geneigten optischen Bereichen, wie zum Beispiel geneigten optischen Fenstern, eine homogene Veredlungsbeschichtung mit geringen Toleranzen in der Dicke der einzelnen Schichten der Veredlungsbeschichtung realisieren. Beim Aufbringen der Veredlungsbeschichtung nach der Verformung des ersten Substrats muss die Abscheidung und eine eventuelle Strukturierung der einzelnen Schichten zum Beispiel auf geneigten Bereichen beziehungsweise Oberflächen erfolgen, woraus insbesondere bei der Verwendung von anisotropen Abscheideverfahren Unterschiede in den Dicken der einzelnen Schichten und damit ortsabhängige Differenzen in den Eigenschaften beziehungsweise in der optischen Funktionalität der Veredlungsbeschichtung und damit der optischen Komponente resultieren können.

Eine nach dieser Ausführungsform hergestellte Breitbandentspiegelungsbeschichtung könnte beispielsweise auf einer Schichtfolge aus Siliziumoxid und Siliziumnitrid basieren. In diesem Fall wird zuerst die Siliziumoxidschicht auf das Verstärkungselement, zum Beispiel aus Silizium, aufgebracht. Anschließend wird auf die Siliziumoxidschicht die Siliziumnitridschicht aufgebracht. Danach wird die Schichtfolge aus Verstärkungselement, Siliziumoxidschicht und Siliziumnitridschicht mit dem ersten Substrat verbunden, indem die Siliziumnitridschicht mit dem ersten Substrat in Verbindung gebracht wird. Nach selektiver Entfernung des Verstärkungselements bleibt eine Schichtfolge aus erstem Substrat, Siliziumnitridschicht und Siliziumoxidschicht und damit ein mit einer Entspiegelungsbeschichtung versehenes erstes Substrat bestehen. Statt Siliziumnitrid kann alternativ auch Titandioxid verwendet werden.

Auch Kombinationen aus Veredlungsbeschichtung und funktionalen Oberflächenstrukturen, zum Beispiel einer Kombination aus Antistatik-Beschichtung und Mottenaugenstrukturen, können Verbesserungen der Funktionalität der optischen Komponente bewirken.

### Beispiele

Ohne Einschränkung der Allgemeinheit wird die Erfindung anhand von Beispielen nachfolgend näher beschrieben.
Fig. 2 zeigt einen mit den erfindungsgemäßen Verfahren hergestellten Deckel 22 mit geneigten optischen Fenstern 8 und verschobenen optischen Fenstern 30 und deren Verwendung zur Verkapselung eines Mikrospiegels 25.
Fig. 3 zeigt die Schrittfolge einer Prozessvariante zur Herstellung eines Deckels 22 mit geneigten optischen Fenstern 8 nach dem erfindungsgemäßen Verfahren nach Anspruch 1.
Fig. 4 zeigt die Schrittfolge einer Prozessvariante zur Herstellung eines Deckels 22 mit geneigten optischen Fenstern 8 nach dem erfindungsgemäßen Verfahren nach Anspruch 1 unter Verwendung von Auflagestrukturen 13.
Fig. 5-5.4 zeigt die Schrittfolge weiterer Prozessvarianten zur Herstellung eines Deckels 22 mit verschobenen optischen Fenstern 30 nach dem erfindungsgemäßen Verfahren nach Anspruch 1 (Fig. 5-5.1), Anspruch 2 (Fig. 5.2-5.3) und Anspruch 3 bzw. 4 (Fig. 5.4).
Fig. 6-6.3 zeigt die Schrittfolge weiterer Prozessvarianten zur Herstellung eines Deckels 22 mit verschoben und geneigt ausgeführten optischen Fenstern 32 nach dem erfindungsgemäßen Verfahren nach Anspruch 1 (Fig. 6), Anspruch 2 (Fig. 6.1-6.2) und Anspruch 3 bzw. 4 (Fig. 6.2-6.3).
Fig. 7-7.3 zeigt die Schrittfolge weiterer Prozessvarianten zur Herstellung eines Deckels 22 mit zwei geneigten optischen Fenstern 8 in einem Auslenkungsbereich 21 nach dem erfindungsgemäßen Verfahren nach Anspruch 1 (Fig. 7-7.2) und Anspruch 2 bzw. 3 (Fig. 7.3).
Fig. 8-8.4 zeigt die Schrittfolge weiterer Prozessvarianten zur Herstellung eines Deckels 22 mit zwei geneigten 8 und einem verschobenen optischen Fenster 30 in einem Auslenkungsbereich 21 nach den erfindungsgemäßen Verfahren nach Anspruch 1 (Fig. 8, 8.4) und Anspruch 2 bzw. 3 (Fig. 8.1-8.4).
Fig. 9-9.1 zeigt den Einsatz von Fixierungselementen 16.
Fig. 10 zeigt das Einbringen einer durch eine mechanische Wechselwirkung bedingten Kraft mittels Formgebungsvorrichtungen 18.
Fig. 11 zeigt die Schrittfolge einer Prozessvariante zur Herstellung eines Deckels 22 mit verschoben und geneigt ausgeführten optischen Fenstern 32 mit Mottenaugenstrukturen als funktionale Oberflächenstruktur.
Fig. 12 zeigt die Schrittfolge einer Prozessvariante zur Herstellung eines nicht einstückig ausgeführten Deckels 22 mit geneigten optischen Fenstern 8.

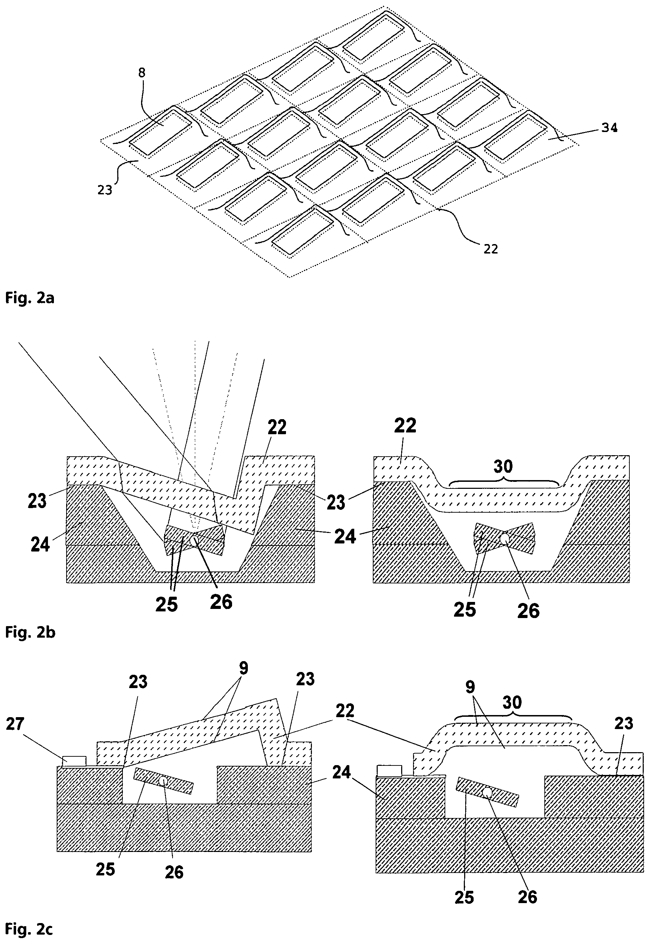

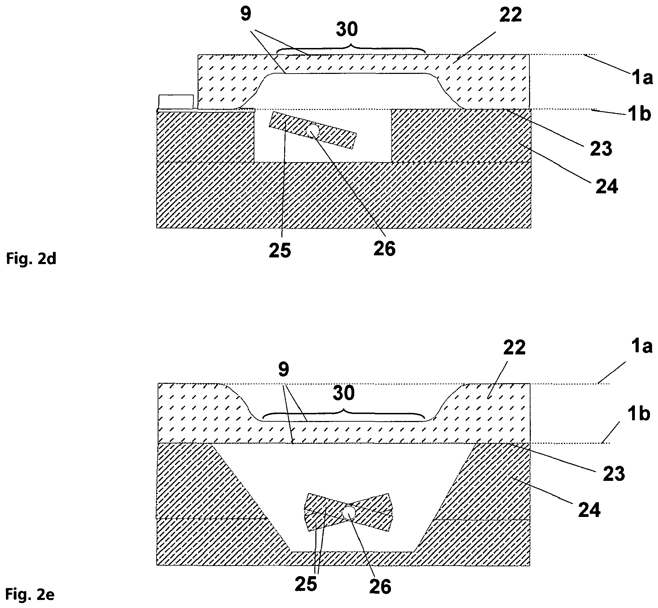

Fig. 2a zeigt einen mit dem erfindungsgemäßen Verfahren hergestellten Deckel 22 mit geneigten optischen Fenstern 8 beziehungsweise den Ausschnitt eines nach dem erfindungsgemäßen Verfahren strukturierten beziehungsweise geformten Glaswafers, der zum Verkapseln eines gesamten Siliziumwafers verwendet werden kann. Den Ausgang bildet ein beidseitig ebener, planparallele Substratebenen 1a, 1b aufweisender Glaswafer 1 aus Borsilikatglas. Beide Waferseiten beziehungsweise Waferebenen 1a, 1b sind poliert ausgeführt, um eine geringe Oberflächenrauigkeit und damit eine hohe Qualität der geneigten optischen Fenster 8 zu gewährleisten. Die geneigten optischen Fenster 8 sind in einem zweidimensionalen Array angeordnet und weisen in Bezug auf die umlaufenden Kontaktflächen 23 üblicherweise eine Neigung zwischen etwa 5° und etwa 20°, bevorzugt etwa 15° auf. Die umlaufenden Kontaktflächen 23 sind um jedes geneigte optische Fenster 8 rahmenförmig geschlossen angeordnet und eben ausgeführt. Entsprechend dimensionierte rahmenförmig geschlossene ebene Flächen sind auf dem Trägersubstrat beziehungsweise Trägerwafer 24 als Gegenkontaktflächen vorgesehen, so dass eine zur Umgebung hermetisch dicht abschließende Verbindung ermöglicht wird.

Die geneigten optischen Fenster 8 sind beidseitig mit einer Entspiegelungsbeschichtung aus einem Schichtsystem aus Siliziumdioxid und Titanoxid versehen.

Die Fig. 2b-2e zeigen jeweils zwei Verwendungsvarianten eines Deckels 22 mit geneigtem optischen Fenster 8 und verschobenem optischen Fenster 30 zur Verkapselung eines Mikrospiegels 25.

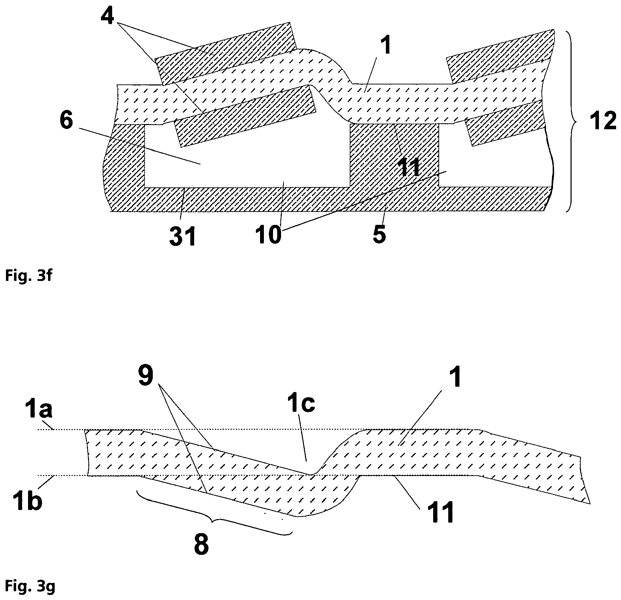

Fig. 3-3g zeigen die Schrittfolge einer Prozessvariante zur Herstellung eines Deckels 22 mit geneigten optischen Fenstern 8 nach dem erfindungsgemäßen Verfahren nach Anspruch 1. Das zum Prozessbeginn bereitgestellte erste Substrat 1 ist ein beidseitig ebener, planparallele Substratebenen 1a, 1b aufweisender Glaswafer aus Borsilikatglas, der vorzugsweise eine Dicke zwischen etwa 500 µm und etwa 1000 µm, in diesem Fall 725 µm, aufweist. Beide Waferseiten beziehungsweise Waferebenen 1a, 1b des Glaswafers 1 sind poliert und weisen damit eine hohe Oberflächenqualität mit einer quadratischen Oberflächenrauigkeit von etwa 25 nm auf.

Des Weiteren werden Verstärkungselemente 4 aus Silizium, die aus einem Siliziumwafer 4a gesägt wurden (Fig. 3), bereitgestellt. Die Verstärkungselemente 4 weisen bevorzugt eine Dicke zwischen etwa 100 µm und etwa 300 µm, in diesem Fall 200 µm, auf und werden mittels Vakuumhandler 3 auf eine der Substratseiten 1a, 1b des Glaswafers 1 angeordnet beziehungsweise positioniert, wodurch der Basisstapel 7 entsteht (Fig. 3a).

Zur Erhöhung der Lagestabilität der Verstärkungselemente 4 werden die Verstärkungselemente 4 mittels anodischen Bondens mit dem Glaswafer 1 verbunden. Mit der anderen Substratseite 1a, 1b des Glaswafers 1 wird äquivalent verfahren, so dass auf beiden Substratseiten 1a, 1b des Glaswafers 1 Verstärkungselemente 4 angeordnet sind, die mit dem Glaswafer 1 in Verbindung stehen.

Um eine stabilere Anordnung der Verstärkungselemente 4 auf dem Glaswafer 1 vor dem Verbinden zu gewährleisten, können in einer weiteren Variante die Verstärkungselemente 4 mittels Vakuumhandler 3 in ein Aufnahmesubstrat 2 auf Basis eines Siliziumwafers, der Aufnahmevertiefungen 37 zur Aufnahme der Verstärkungselemente 4 aufweist, übertragen werden. Die Aufnahmevertiefungen 37 im Aufnahmesubstrat 2 werden vorher mittels trockenchemischen Ätzverfahrens erzeugt und sind derart ausgespart, dass die Verstärkungselemente 4 in ihrer Endposition auf dem Aufnahmesubstrat 2 über die Begrenzungsflächen 36 des Aufnahmesubstrats 2 hinausragen (Fig. 3b). Auch in diesem Fall wird erst die eine Substratseite 1a, 1b des Glaswafers 1 prozessiert, also die Verstärkungselemente 4 im Aufnahmesubstrat 2 angeordnet und dann mit dem Glaswafer 1 verbunden (Fig. 3b_1), und dann wird die zweite Substratseite 1a, 1b des Glaswafers 1 in äquivalenter Weise prozessiert. Dabei wird der durch die Prozessierung der ersten Substratseite 1a, 1b des Glaswafers 1 entstandene Basisstapel 7 durch lösen der formschlüssigen Verbindung zwischen Basisstapel 7 und Aufnahmesubstrat 2 freigeben (Fig. 3b_2); anschließend wird das Aufnahmesubstrat 2 erneut mit Verstärkungselementen 4 bestückt und diese werden dann mit der zweiten Substratseite 1a, 1b des Glaswafers 1 verbunden.

Im Ergebnis sind auch bei dieser Variante auf beiden Substratseiten 1a, 1b des Glaswafers 1 Verstärkungselemente 4 angeordnet, die mit dem Glaswafer 1 verbunden sind (Fig. 3c). Die Verstärkungselemente 4 sind in den Bereichen des Glaswafers 1 angeordnet, die als geneigte optische Fenster 8 fungieren.

Im nächsten Verfahrensschritt wird als mindestens zweites Substrat 5 ein weiterer Siliziumwafer mit dritten Vertiefungen 6 bereitgestellt und mit dem Basisstapel 7, insbesondere mit dem Glaswafer 1, durch anodisches Bonden zu einem Schichtsystem 12 verbunden. Dabei werden der Basisstapel 7 und der Siliziumwafer 5 so zueinander angeordnet, dass die dritten Vertiefungen 6 im Siliziumwafer 5 nach dem Verbinden mit dem Basisstapel 7 zur Umgebung hermetisch dicht abschließende Hohlräume 10 zwischen dem Silizumwafer 5 und dem Basisstapel 7 bilden, die die dem Siliziumwafer 5 zugewandten Verstärkungselemente 4 einschließen. Zudem sind die Verstärkungselemente 4 nicht zentrisch im Auslenkungsbereich 21 und damit zwischen den Auflageflächen 11 beziehungsweise Auflagebereichen 11a angeordnet. Ein Kontakt zwischen den Verstärkungselementen 4 und dem Siliziumwafer 5 besteht vor dem Erwärmen und Verformen nicht, wie Fig. 3d zeigt.

Das anodische Bonden erfolgt bei Temperaturen von etwa 400°C und einem Druck von etwa 600 mbar oder etwa 800 mbar.

Beim folgenden Prozessschritt wird das Schichtsystem 12 aus Siliziumwafer 5 und Basisstapel 7 zuerst erwärmt. Bei Verwendung eines Glaswafers 1 aus Borsilikatglas, mit einer Erweichungstemperatur von etwa 820 °C, wird das Schichtsystem 12 aus Siliziumwafer 5 und Basisstapel 7 auf etwa 800 °C erwärmt. Durch die im Vergleich zum Bondprozess erhöhte Temperatur steigt der Druck in den .Hohlräumen 10 von etwa 600 mbar auf etwa 900 mbar oder von etwa 800 mbar auf etwa 1200 mbar. Der entsprechend herrschende Unterdruck oder Überdruck in Bezug auf den atmosphärischen Luftdruck der Umgebung führt zu einer das Glassubstrat 1 in die dritten Vertiefungen 6 des Siliziumwafers 5 hineinziehenden oder herausdrückenden Kraftwirkung, wodurch die durch die Verstärkungselemente 4 abgedeckten Bereiche 38 des Glaswafer 1 geneigt werden, wie die Fig. 3e und 3f zeigen. Der Verformungsschritt wird bei Kontakt der Verstärkungselemente 4 am Boden 31 der dritten Vertiefungen 6 oder nachdem der Druck in den Hohlräumen 10 verformungsgedingt den Wert des Umgebungsdrucks erreicht hat abgebrochen.

Im letzten Schritt werden die Verstärkungselemente 4 und der Siliziumwafer 5 vom Glaswafer 1 nasschemisch selektiv entfernt (Fig. 3g).

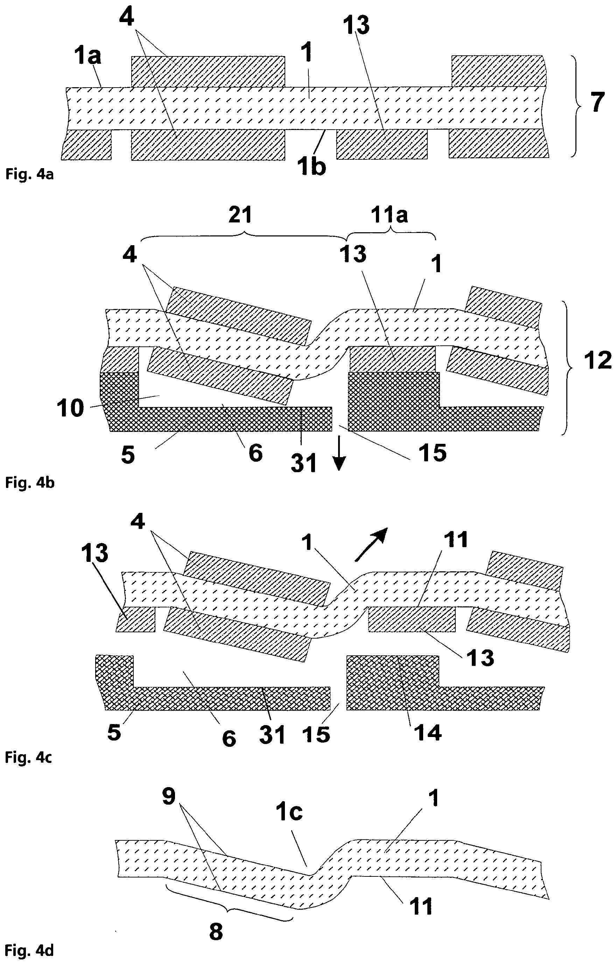

Fig. 4 zeigt eine weitere Prozessvariante zur Herstellung eines Deckels 22 mit geneigten optischen Fenstern 8 nach dem erfindungsgemäßen Verfahren nach Anspruch 1 unter Verwendung von Auflagestrukturen 13. Nach Bereitstellung eines Glaswafers 1 aus Borsilikatglas, Verstärkungselementen 4 aus Silizium und Auflagestrukturen 13 aus Silizium werden, wie bei der vorher beschriebenen Prozessvariante, die Verstärkungselemente 4 auf beiden Substratseiten 1a, 1b des Glaswafers 1 angeordnet und mittels anodischen Bondens mit dem Glaswafer 1 verbunden, um einen Basisstapel 7 zu erzeugen. Die Auflagestrukturen 13 werden in denselben Prozessschritten wie die Verstärkungselemente 4 angeordnet und mit dem Glaswafer 1 verbunden. In diesem Fall sind nur auf einer Substratseite 1b des Glaswafers 1 Auflagestrukturen 13 vorgesehen. Die Verstärkungselemente 4 werden in den Bereichen des Glaswafers 1, die als geneigte optische Fenster 8 fungieren, angeordnet. Die Auflagestrukturen 13 werden in den Bereichen des Glaswafers 1, die als Auflageflächen 11 beziehungsweise Auflagebereiche 11a vorgesehen sind, angeordnet (Fig. 4a). Die Auflagestrukturen 13 bilden dabei einen geschlossenen Rahmen um ein auf derselben Substratseite 1b des Glaswafers 1 angeordnetes Verstärkungselement 4 und dienen als Schutz der Auflageflächen 11 des Glaswafers 1 beim Kontakt des Basisstapels 7 mit dem zweiten Substrat 5. Durch diesen Schutz wird ein direkter Kontakt zwischen dem Glaswafer 1 und dem zweiten Substrat 5 vermieden, wodurch die hohe Ebenheit und die geringe Rauigkeit der Auflageflächen 11 unabhängig von der Oberflächenqualität des zweiten Substrats 5 erhalten werden kann.

Die Verstärkungselemente 4 sind wiederum nicht zentrisch zwischen den Auflageflächen 11 beziehungsweise Auflagestrukturen 13 angeordnet.

Als zweites Substrat 5 wird ein Substrat beziehungsweise Werkzeug eingesetzt, das dritte Vertiefungen 6 aufweist. Zudem besteht das zweite Substrat 5 aus Graphit oder zumindest die Gegenkontaktflächen 14 des zweiten Substrats, die für den Kontakt mit dem Basisstapel 7 vorgesehen sind, sind mit Graphit beschichtet. Des Weiteren weist dieses Graphit aufweisende zweite Substrat 5 mindestens einen Kanal 15 auf, der den Anschluss einer externen Vakuumpumpe gewährleistet.

Im nächsten Verfahrensschritt werden die Auflagestrukturen 13 des Basisstapels 7 und das Graphit aufweisende zweite Substrat 5 derart miteinander in Kontakt gebracht, dass die dritten Vertiefungen 6 im zweiten Substrat 5 nach dem in Kontakt bringen mit dem Basisstapel 7 zur Umgebung abschließende Hohlräume 10 zwischen dem zweiten Substrat 5 und dem Basisstapel 7 bilden, wobei die Hohlräume 10 die Verstärkungselemente 4, die dem zweiten Substrat 5 zugewandt sind, einschließen und nicht zur Umgebung hermetisch dicht abgeschlossen sein müssen. Über die Kanäle 15 wird mittels externer Vakuumpumpe ein Unterdruck in den Hohlräumen 10 erzeugt (Fig. 4b).

Der nachfolgende Erwärmungs- und Verformungsschritt wird, wie bei der vorherigen Prozessvariante beschrieben, durchgeführt.

Im Anschluss wird in den Hohlräumen 10 wieder Umgebungsdruck (z.B. atmosphärischer Luftdruck) eingestellt. Dadurch lässt sich der Basisstapel 7 vom zweiten Substrat 5 abheben beziehungsweise trennen, wie in Fig. 4c dargestellt.

Im abschließenden Prozessschritt werden die Verstärkungselemente 4 und die Auflagestrukturen 13 durch nasschemisches selektives Ätzen vom Glaswafer 1 entfernt (Fig. 4d).

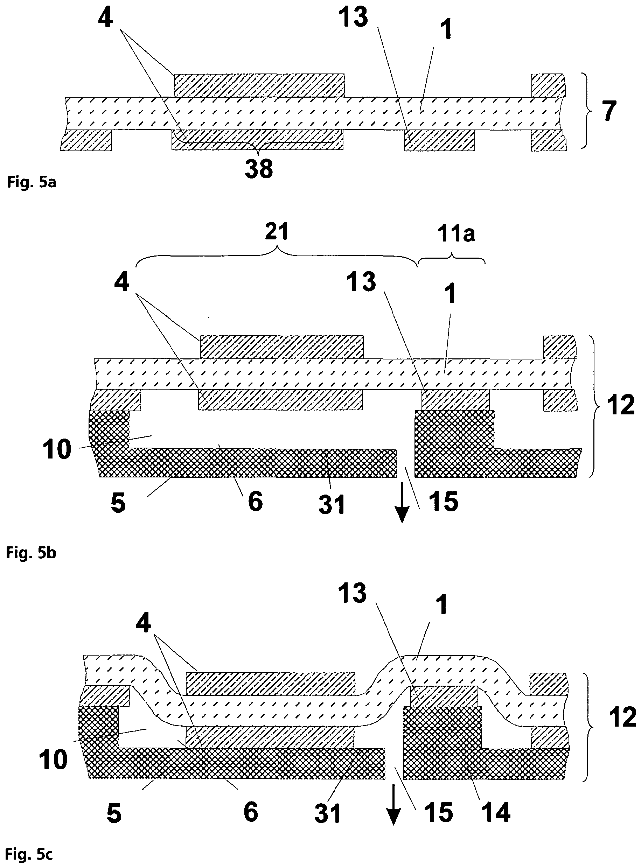

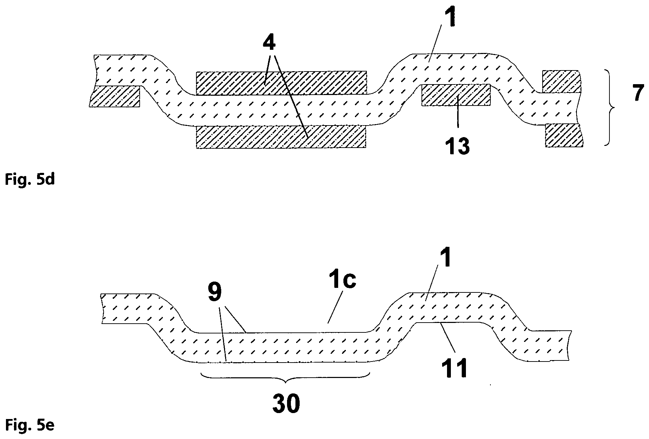

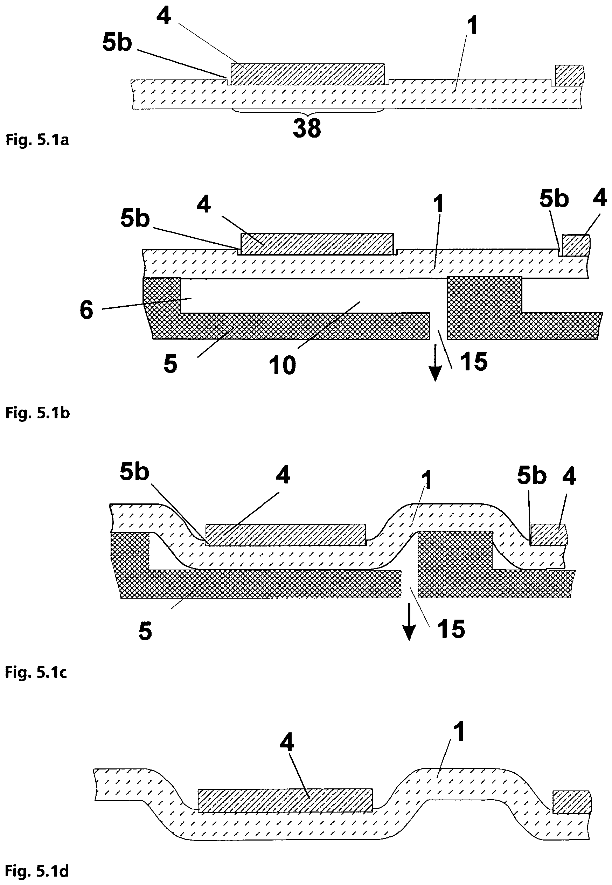

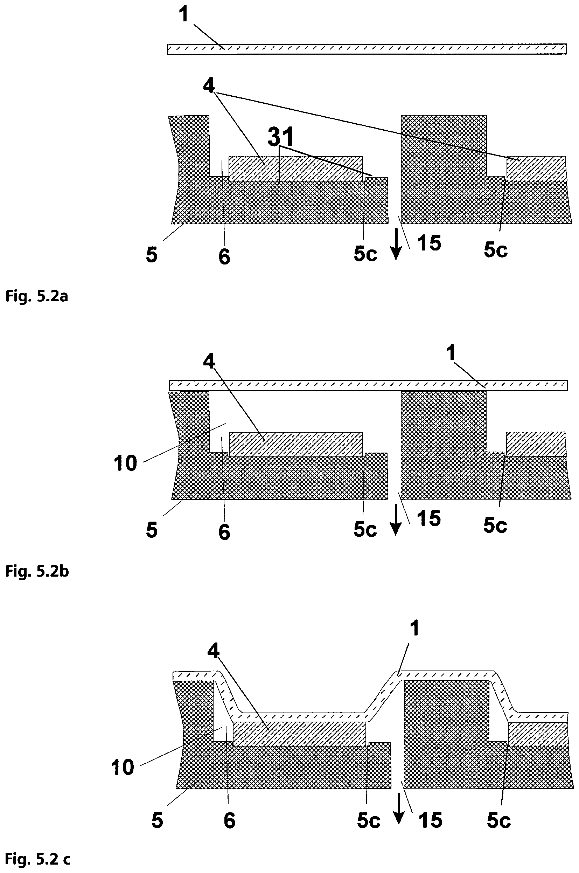

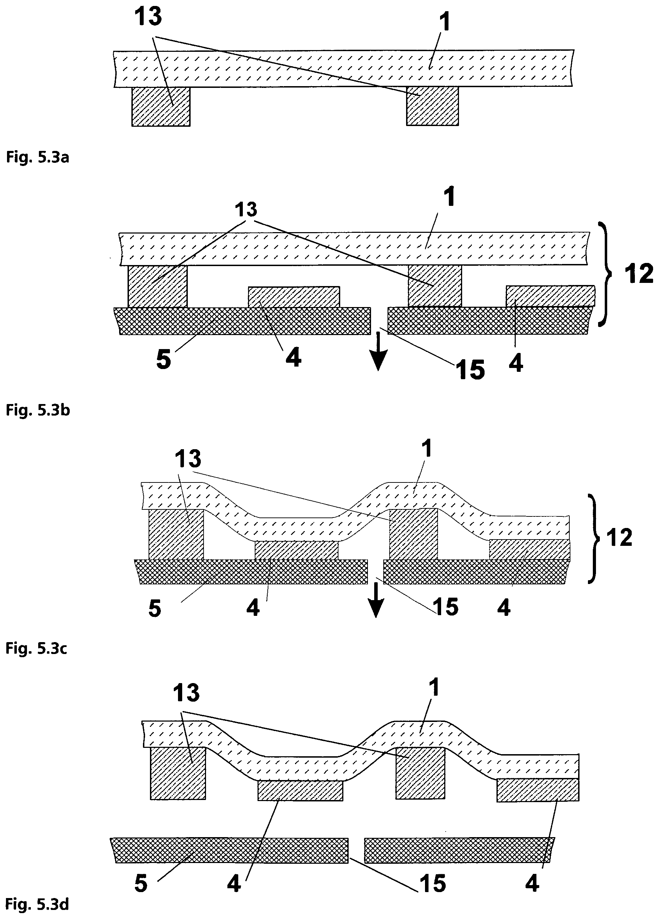

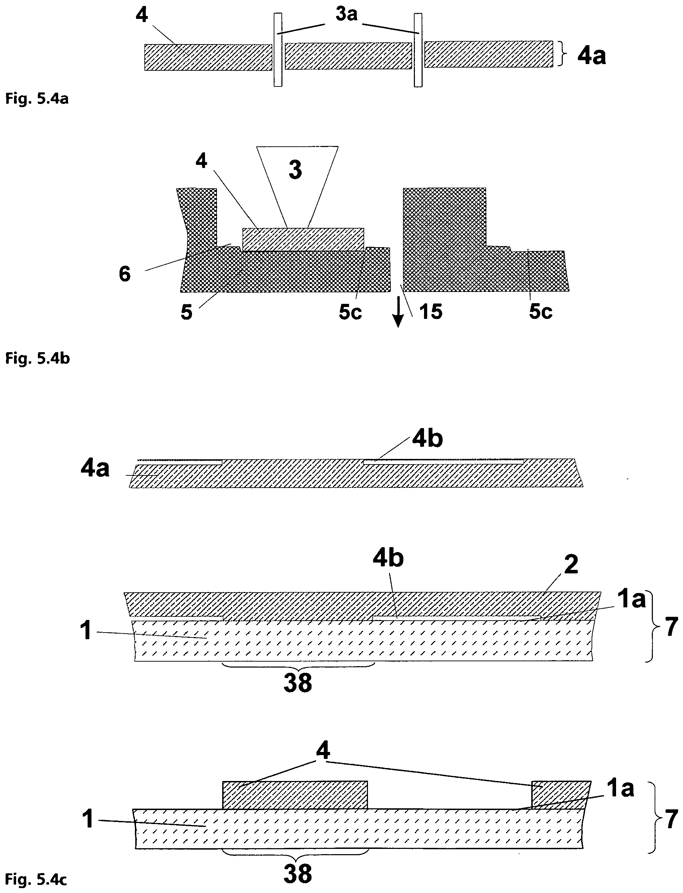

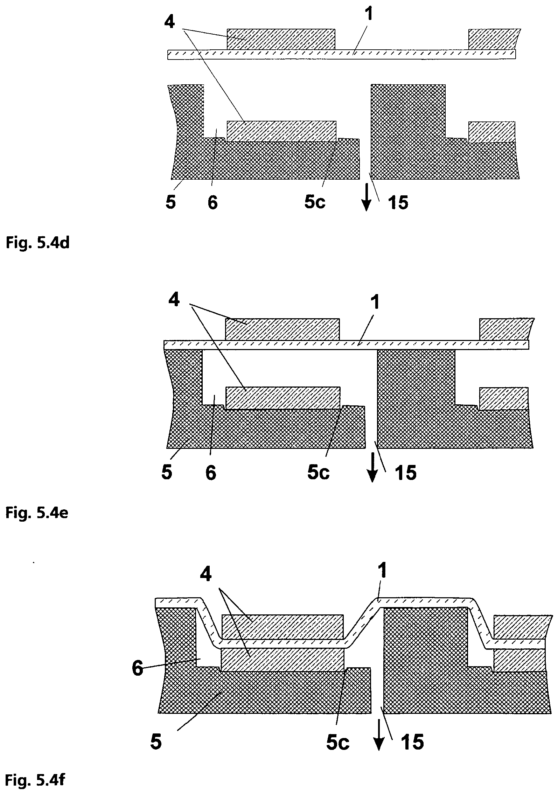

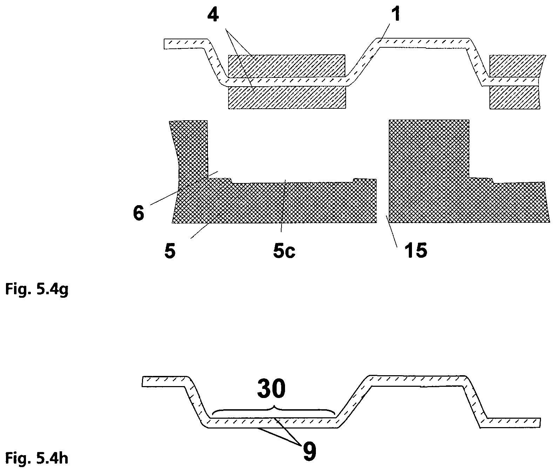

In Fig. 5-5.4 ist dargestellt, wie sich mit den erfindungsgemäßen Verfahren ein Deckel 22 mit verschoben ausgeführten optischen Fenstern (verschobenen optischen Fenstern) 30 herstellen lässt. Diese und die im Folgenden dargestellten Prozesse basieren auf den zuvor beschriebenen Prozessvarianten.

Bei den Prozessvarianten Fig. 5.2, 5.3 und 5.4 werden die Verstärkungselemente in der bereits beschriebenen Art und Weise bereitgestellt und zumindest auf das zweite Substrat übertragen beziehungsweise auf diesem angeordnet.

Gemäß Fig. 5-5.2 und Fig. 5.4 wird, wie oben beschrieben, für das zweite Substrat 5 ein Substrat beziehungsweise Werkzeug verwendet, das dritte Vertiefungen 6 aufweist. Nach dem Verfahren nach Fig. 5.3 dienen Auflagestrukturen 13 als Abstandshalter zwischen dem ersten 1 und dem zweiten Substrat 5, so dass ein ebenes zweites Substrat 5 Verwendung finden kann.

Um die Lagestabilität der Verstärkungselemente 4 auf dem Glaswafer 1 und/oder dem zweiten Substrat 5 zu erhöhen, weist der Glaswafer 1 (Fig. 5.1) und/oder das zweite Substrat 5 (Fig. 5.2 und 5.4) Justiervertiefungen 5b, 5c auf. Dadurch kann das Risiko für ein laterales Verschieben der Verstärkungselemente 4 reduziert werden.

Ein Verschieben beziehungsweise ein aus den Substratebenen 1a, 1b Parallelverschieben der durch die Verstärkungselemente 4 abgedeckten Bereiche 38 des Glaswafers 1 kann durch eine zentrische Anordnung der Verstärkungselemente 4 in den Auslenkungsbereichen 21 (Fig. 5-5.1 und Fig. 5.4) beziehungsweise durch eine, insbesondere zentrische, Anordnung der Verstärkungselemente 4 in den den Auslenkungsbereichen 21 zugewandten Bereichen des zweiten Substrats 5, wie z.B. den Bereichen zwischen den Auflagestrukturen 13 (Fig. 5.3) oder auf dem Boden 31 der dritten Vertiefungen 6 (Fig. 5.2), unterstützt werden.

Der Verformungsschritt kann so lange erfolgen, bis die Verstärkungselemente 4 oder der Glaswafer 1 auf dem Boden 31 der dritten Vertiefungen 6 des zweiten Substrats 5 beziehungsweise den dort angeordneten Verstärkungselementen 4 aufliegen.

Gemäß dem Verfahren nach Fig. 5.4 werden aus einem Verstärkungssubstrat 4a gesägte Verstärkungselemente 4 aus Silizium auf dem zweiten Substrat 5 angeordnet. Zudem wird ein Glaswafer 1 bereitgestellt, der Verstärkungselemente 4 aus Silizium aufweist. Die Prozessierung dieser Anordnung kann beispielsweise derart erfolgen, dass ein Siliziumwafer als Verstärkungsschicht 4a bereitgestellt wird, der auf der mit dem Glaswafer 1 in Verbindung zu bringenden Waferseite zweite Vertiefungen 4b aufweist.

Die zweiten Vertiefungen 4b sollen beim Verbinden von Glaswafer 1 und Siliziumwafer 4a in den Bereichen des Glaswafers 1, in denen keine Verstärkungselemente 4 vorgesehen sind, einen Kontakt zwischen Glaswafer 1 und Siliziumwafern 4a vermeiden, um diese Bereiche des Glaswafers 1 für weitere Verbindungs- und/oder Kontaktierungsschritte, zum Beispiel anodisches Bonden des Glaswafers 1 mit dem zweiten Substrat 5, zu konservieren. Die zweiten Vertiefungen 4b weisen Tiefen von etwa 0,7 µm auf.

Mittels anodischen Bondens wird der Siliziumwafer 4a mit einer der Substratseiten 1a, 1b des Glaswafers 1 zu einem weiteren Basisstapel 7 verbunden.

Im anschließenden Strukturierungsprozess wird der Siliziumwafer 4a des weiteren Basisstapels 7 durch nasschemische Ätzverfahren und/oder Trockenätzverfahren derart strukturiert, dass in den Bereichen des Glaswafers 1, die als optische Fenster 30 fungieren, Silizium als Verstärkungselemente 4 verbleibt (Fig. 5.4c). Im Ergebnis sind die einzelnen Verstärkungselemente 4 vollständig durch von Silizium befreite Bereiche des Glaswafers 1 umgeben beziehungsweise voneinander getrennt.

Durch eine zumindest in Teilbereichen geneigte Ausführung der Böden 31 der dritten Vertiefungen 6 und/oder eine nicht zentrische Anordnung der Verstärkungselemente 4 in den Auslenkungsbereichen 21 lässt sich ein Deckel 22 mit verschoben und geneigt ausgeführten optischen Fenstern 32 herstellen, wie in Fig. 6-6.3 gezeigt wird.

Bei der Prozessvariante nach Fig. 6.1 wird die Lagestabilität der Verstärkungselemente 4 wiederum durch Justiervertiefungen 5c im zweiten Substrat 5 (Fig. 6.1b_1) verbessert.

Im Zuge des Erwärmen und Verformens wird der Glaswafer 1 mit den Verstärkungselementen 4 in Kontakt gebracht. Das Inkontaktbringen führt auf Grund der hohen Erwärmungstemperatur von z.B. 800°C durch einen thermischen Bondvorgang zu einer stoffschlüssigen Verbindung zwischen dem Glaswafer 1 und den Verstärkungselementen 4. Nachdem in den dritten Vertiefungen 6 des zweiten Substrats 5 Umgebungsdruck hergestellt wurde, kann der Glaswafer 1 mit den Verstärkungselementen 4 vom zweiten Substrat 5 abgehoben werden. Auf Grund dieser materialschonenden Trennmethode lässt sich das zweite Substrat 5 wiederverwenden. Nach dem Abheben des Glaswafers 1 mit den Verstärkungselementen 4 vom zweiten Substrat 5 können die Verstärkungselemente 4 mittels naßchemischen selektiven Ätzens vom Glaswafer 1 entfernt werden.

Alternativ können, wie in Fig. 6.2 dargestellt, die Oberflächenbereiche der abgedeckten Bereiche 38 des Glaswafers 1, auf denen keine Verstärkungselemente 4 angeordnet und die z.B. als Transmissionsflächen 9 der optischen Fenster 32 vorgesehen sind, einem weiteren Formgebungsprozess unterzogen werden, um die z.B. durch den ersten Formgebungsprozess beeinträchtigte Oberflächenqualität, insbesondere Ebenheitsabweichungen wie z.B. Durchwölbungen, zu verbessern, insbesondere zu planarisieren.

Dazu werden auf einem weiteren zweiten Substrat 5a Verstärkungselemente 4, die insbesondere als Abformelemente fungieren, angeordnet und die Substratseite 1a des Glaswafers 1, die keine Verstärkungselemente 4 aufweist, wird mit dem weiteren zweiten Substrat 5a beziehungsweise den darauf angeordneten Verstärkungselementen 4 in Kontakt gebracht. Im Beispiel nach Fig. 6.2c werden nur die später als Kontaktbereiche bzw. Kontaktflächen fungierenden Bereiche des Glaswafers 1 oder nur der Waferrand des Glaswafers 1 mit dem weiteren zweiten Substrat 5a in Kontakt gebracht. Alternativ können, insbesondere zusätzlich, zumindest Teilbereiche der abgedeckten Bereiche 38 des Glaswafers 1 mit den auf dem weiteren zweiten Substrat 5a angeordneten Verstärkungselementen 4 in Kontakt gebracht werden.

Ein folgender Erwärmungs- und Verformungsschritt des Glaswafers 1 führt zu einem Abformen der Oberflächenbereiche der Verstärkungselemente 4, die auf dem weiteren zweiten Substrat 5a angeordnet und dem Glaswafer 1 zugewandt sind, auf den Glaswafer 1. Da die entsprechenden Oberflächenbereiche der Verstärkungselemente 4 poliert ausgeführt sind, wird ihre hohe Oberflächenqualität, insbesondere die geringe Rauigkeit und die hohe Ebenheit, auf den Glaswafer 1 übertragen. Im Ergebnis weisen die optischen Fenster 32 (beziehungsweise deren Transmissionsflächen 9) des hergestellten Deckels 22 eine beidseitig hohe Oberflächenqualität auf.

Alternativ zur Kombination der Prozessvarianten nach Fig. 6.1 und 6.2 kann, wie in Fig. 6.3 dargestellt, eine Substratseite 1b des Glaswafers 1 vor dem Erwärmen und Verformen mit Verstärkungselementen 4 versehen werden, und die andere Substratseite 1a des Glaswafers 1 wird im Zuge des Erwärmen und Verformens mit auf dem zweiten Substrat 5 angeordneten Verstärkungselementen 4 in Kontakt gebracht. Dadurch entstehen ebenfalls beidseitig durch Verstärkungselemente 4 unterstützte Bereiche des Glaswafers 1, die nach dem Entfernen der Verstärkungselemente 4 eine hohe Oberflächenqualität aufweisen.

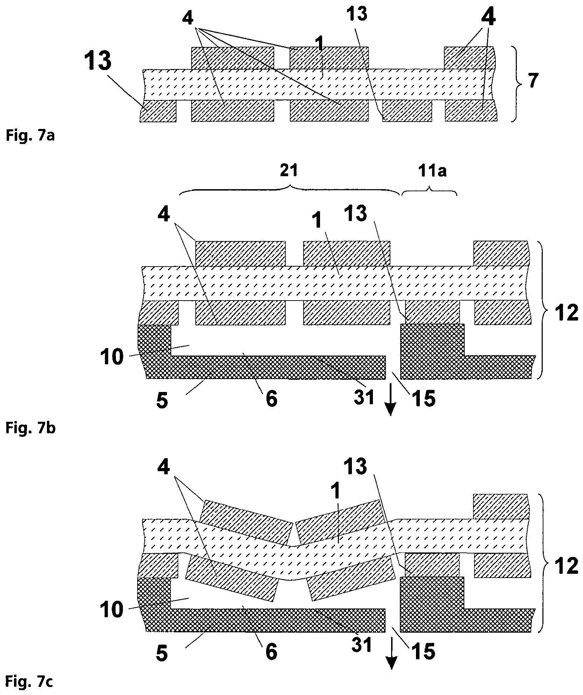

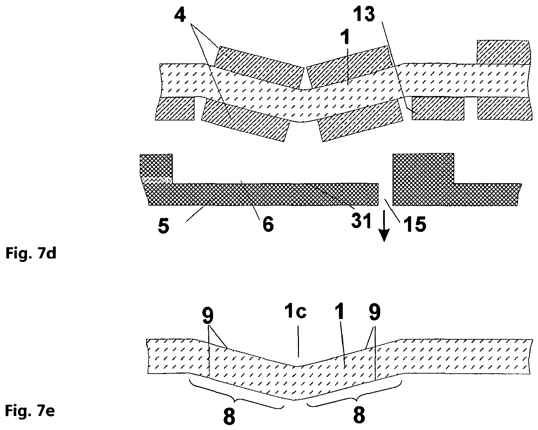

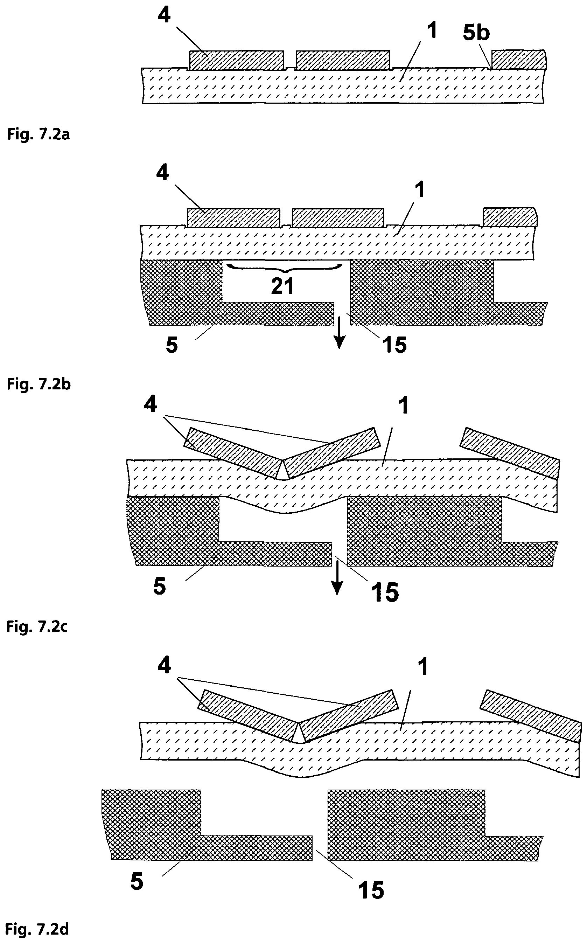

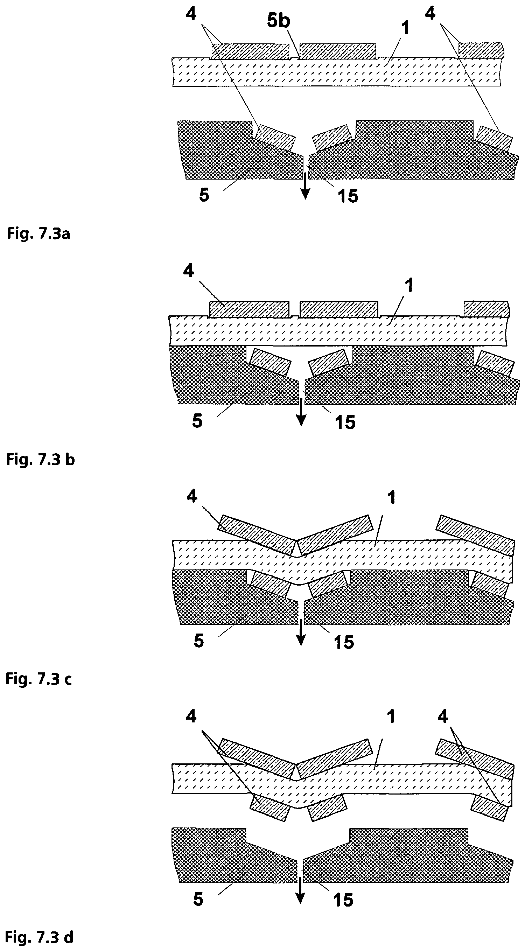

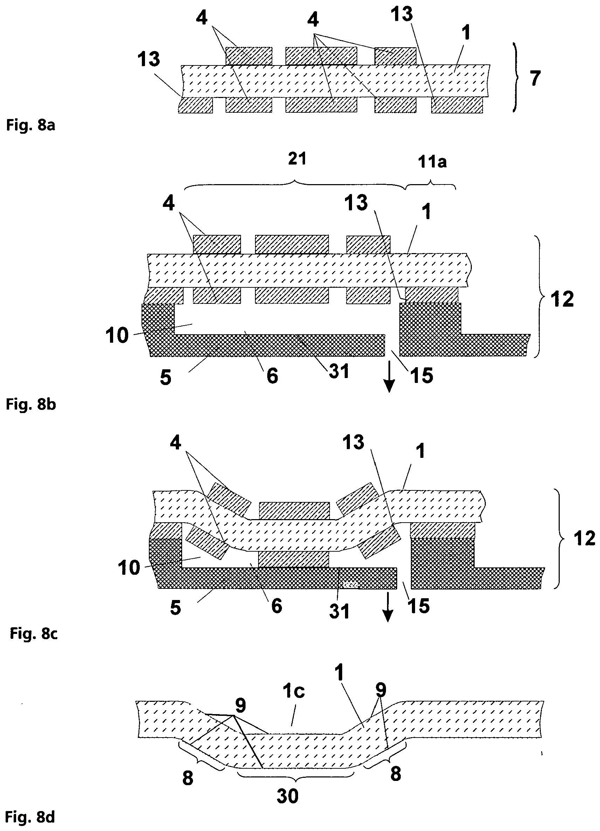

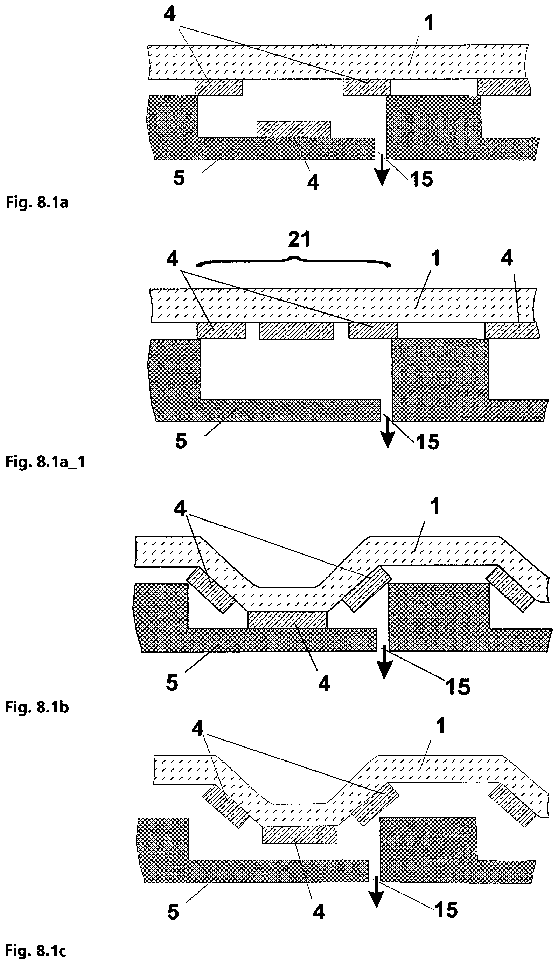

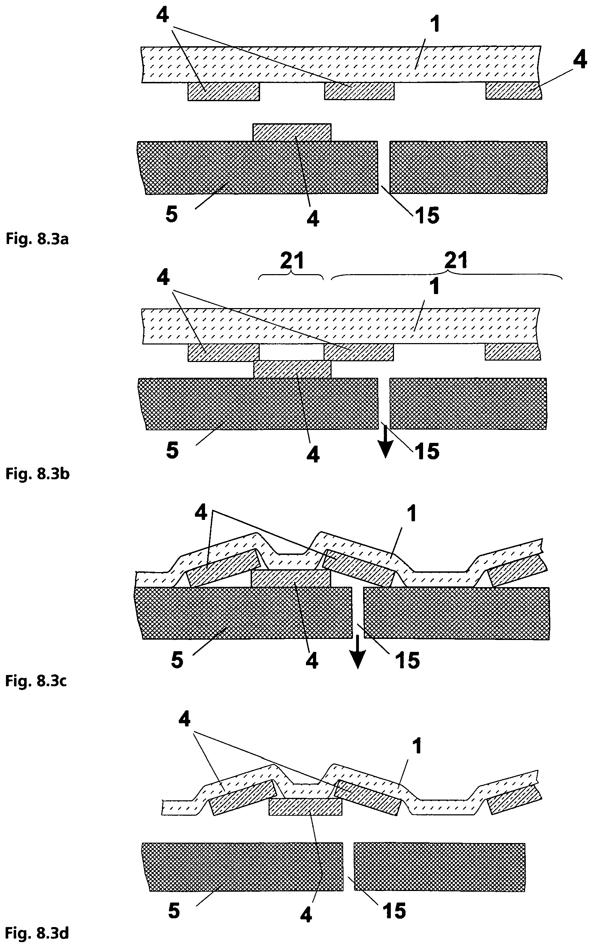

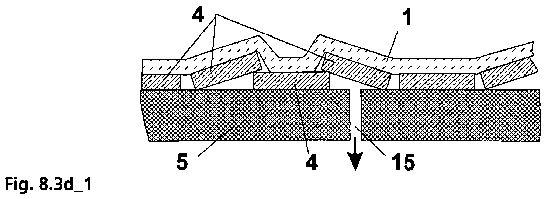

Weitere Modifikationen der beschriebenen Prozessvarianten zur Herstellung eines Deckels 22 nach den erfindungsgemäßen Verfahren sind in den Fig. 7-7.3 und Fig. 8-8.4 dargestellt.

Durch Anordnung mehrerer Verstärkungselemente 4 in einem Auslenkungsbereich 21 (z.B. Fig. 7, 7.2-7.3, Fig. 8-8.1, 8.3) und/oder in einem dem Auslenkungsbereich 21 zugewandten Bereich des zweiten Substrats 5 (z.B. Fig. 7.3, Fig. 8.1-8.3) beziehungsweise durch den Einsatz speziell strukturierter Verstärkungselemente 4 (z.B. Fig. 7.1, Fig. 8.4) lassen sich durch das Erwärmen und Verformen mehrere verschobene und/oder geneigte Bereiche des Glaswafers 1 beziehungsweise optische Fenster 8, 30, 32 in einem Auslenkungsbereich 21 realisieren.

Durch das Erwärmen und Verformen und das damit verbundene Glasfließen können die Justiervertiefungen 5b im Glaswafer 1 (siehe Fig. 7.2c) reduziert werden oder komplett verschwinden.

Abschließend werden die Verstärkungselemente 4 und die Auflagestrukturen 13 durch nasschemisches selektives Ätzen vom Glaswafer 1 entfernt.

Bei den Prozessvarianten nach Fig. 7.1 und Fig. 8.4 kommen speziell strukturierte Verstärkungselemente 4 zum Einsatz, die Oberflächenbereiche aufweisen, die vor dem Erwärmen und Verformen geneigt zu den Substratebene/n 1a, 1b beziehungsweise zu Teilen der Oberflächenbereiche der Auslenkungsbereiche des Glaswafers 1 ausgebildet und im weiteren Prozessverlauf mit Bereichen des Glaswafers 1 in Kontakt gebracht werden. Durch die durch die Verstärkungselemente 4 bedingte Führung der Verformung des Glaswafers 1 und/oder das Abformen der geneigten Oberflächenbereiche der Verstärkungselemente 4 auf den Glaswafer 1 wird eine Unterstützung der Formgebung des Glaswafers 1 durch die Verstärkungselemente 4 gewährleistet. Die Verstärkungselemente 4 weisen zudem noch einen als Fixierungselement 16 und/oder einen als Auflagestruktur 13 (z.B. als Abstandshalter) fungierenden Bereich auf.

Solche geneigten Oberflächenbereiche der Verstärkungselemente 4 mit hoher Oberflächenqualität können beispielsweise durch einen KOH-Ätzprozess in <111>-Silizium erzeugt werden.

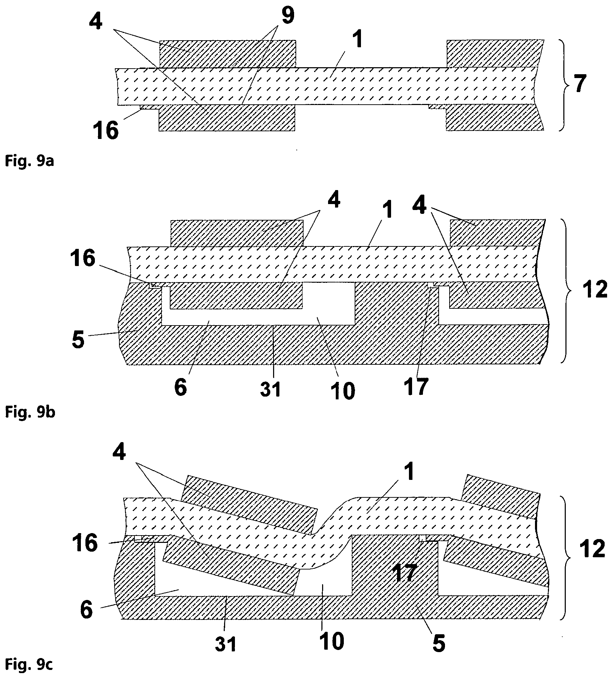

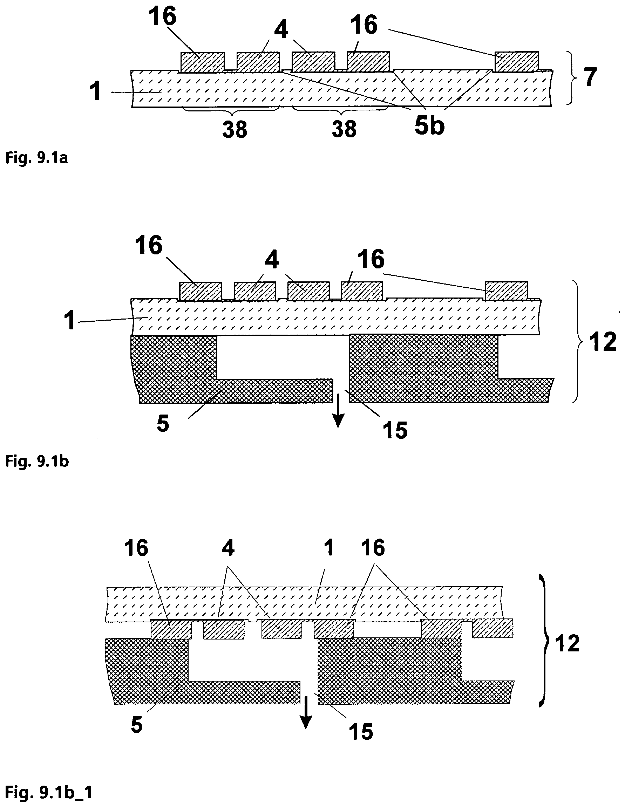

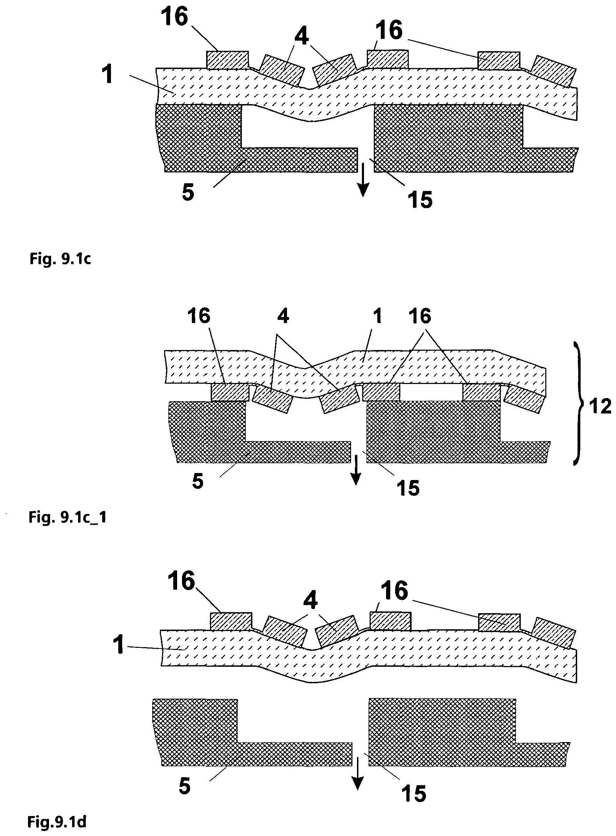

Fig. 9-9.1 zeigt den Einsatz von Fixierungselementen 16 bei der Herstellung eines Deckels 22 nach dem erfindungsgemäßen Verfahren nach Anspruch 1. Die Fixierungselemente 16 können bei der Herstellung der Verstärkungselemente 4 erzeugt werden.

Beim folgenden anodischen Bonden von Basisstapel 7 und dem zweiten Substrat 5, z.B. einem Siliziumwafer, werden die Fixierungselemente 16 nach Fig. 9 zwischen den zu verbindenden Flächen geklemmt und damit fixiert. Um trotz der Fixierungselemente 16 eine stabile Verbindung zwischen dem Basisstapel 7 und dem zweiten Substrat 5 gewährleisten zu können, ist das zweite Substrat 5 mit Aufnahmenuten 17 für die Fixierungselemente 16 ausgelegt (Fig. 9b).

Alternativ können die Verstärkungselemente 4 über die Fixierungselemente 16 mit starren beziehungsweise im weiteren Prozessverlauf formstabilen Bereichen des ersten Substrats 1 (Fig. 9.1b) und/oder des zweiten Substrats 5 (Fig. 9.1b_1) verbunden sein. Eine solche stabile Verbindung kann durch anodisches oder thermisches Bonden gewährleistet werden.

Beim anschließenden Erwärmen und Verformen verhindern die geklemmten beziehungsweise gebondeten Fixierungselemente 16 ein Verschieben und/oder Verdrehen der Verstärkungselemente 4. Zudem reduzieren die Fixierungselemente 16 unerwünschte Verformungen, zum Beispiel Durchwölbungen, in den durch die Fixierungselemente 16 abgedeckten Bereichen 38 des Glaswafers 1 (Fig. 9c, 9.1c_1).

In der Prozessvariante nach Fig. 9.1b_1 fungieren die Fixierungselemente 16 zudem als Auflagestrukturen 13, die als Abstandshalter eingesetzt werden.

Bei den vorher genannten Prozessvarianten wird die Verformung des Glaswafers 1 durch eine Kraft, die aus einer Druckdifferenz zwischen Umgebungsdruck und dem in den durch den (weiteren) Basisstapel 7 oder dem Glaswafer 1 und dem zweiten Substrat 5 oder dem Grundstapel 7a eingeschlossenen Hohlräumen 10 vorherrschenden Druck resultiert, unterstützt.

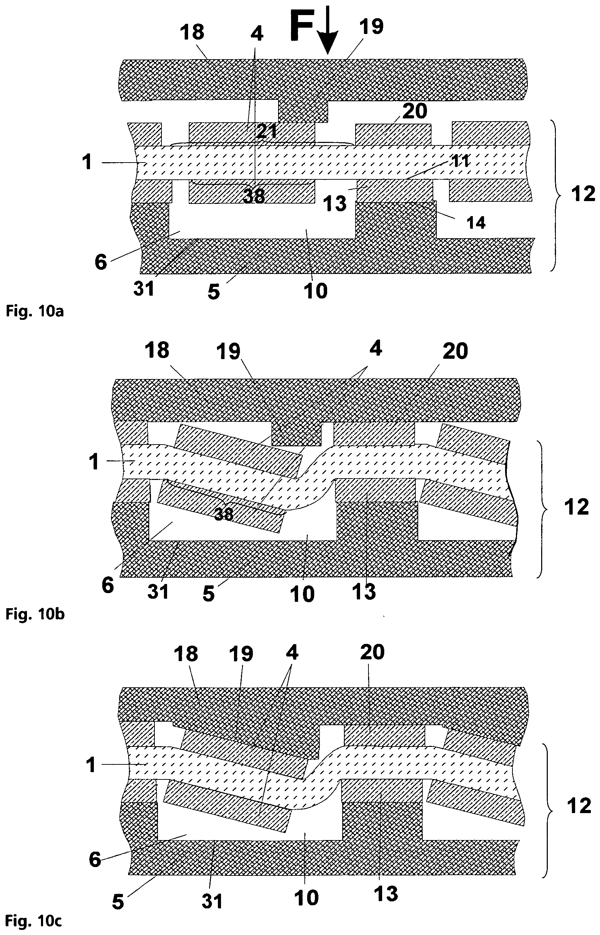

In einer weiteren Prozessvariante nach Fig. 10 wird diese Kraft durch eine Formgebungsvorrichtung 18 mit einem Stempelelement 19 eingebracht. Dabei wird das Stempelelement 19 so ausgerichtet, dass die Kraft nicht zentrisch in Bezug auf die Verstärkungselemente 4 beziehungsweise auf den Auslenkungsbereich 21 wirkt (Fig. 10a). Dadurch wird ein Neigen der Verstärkungselemente 4 und der von ihnen abgedeckten Bereiche 38 des Glaswafers 1 begünstigt. Die Kraft wird aufrechterhalten, bis die gewünschte Neigung der durch die Verstärkungselemente 4 abgedeckten Bereiche 38 des Glaswafers 1 erreicht ist.

Zur Erhöhung der Genauigkeit der Neigung der geneigten optischen Fenster 8 werden spezielle Anschlagstrukturen 20, die die maximale Auslenkung des Stempelelements 19 begrenzen, auf dem Glaswafer 1 aufgebracht beziehungsweise angeordnet. Diese Anschlagstrukturen 20 können in Form von ein oder mehreren Schichten oder Schichtfolgen auf dem Glaswafer 1 aufgebracht werden. Durch die Variation der Dicke der Schichten oder Schichtfolgen lässt sich die maximale Auslenkung des Stempelelements 19 und damit die gewünschte Neigung einstellen. Der Formgebungsprozess ist abgeschlossen, sobald die Formgebungsvorrichtung 18 in Kontakt mit den Anschlagstrukturen 20 kommt, wie in Fig. 10b dargestellt ist.

Die Anschlagstrukturen 20 lassen sich, wie für die Verstärkungselemente 4 und/oder Auflagestrukturen 13 beschrieben, auf dem Glaswafer 1 anordnen und mit dem Glaswafer 1 verbinden.

Eine weitere Erhöhung der Genauigkeit des Formgebungsprozesses lässt sich durch ein Stempelelement 19 erreichen, das über eine geneigte Stempelfläche (Fig. 10c), die die für die optischen Fenster 8 gewünschte Neigung aufweist, verfügt.

Die Formgebungsvorrichtung 18 kann so ausgelegt sein, dass sie mehrfach eingesetzt werden kann; indem zum Beispiel ein direkter Kontakt der Formgebungsvorrichtung 18 mit dem Glaswafer 1 vermieden wird (Fig. 10).

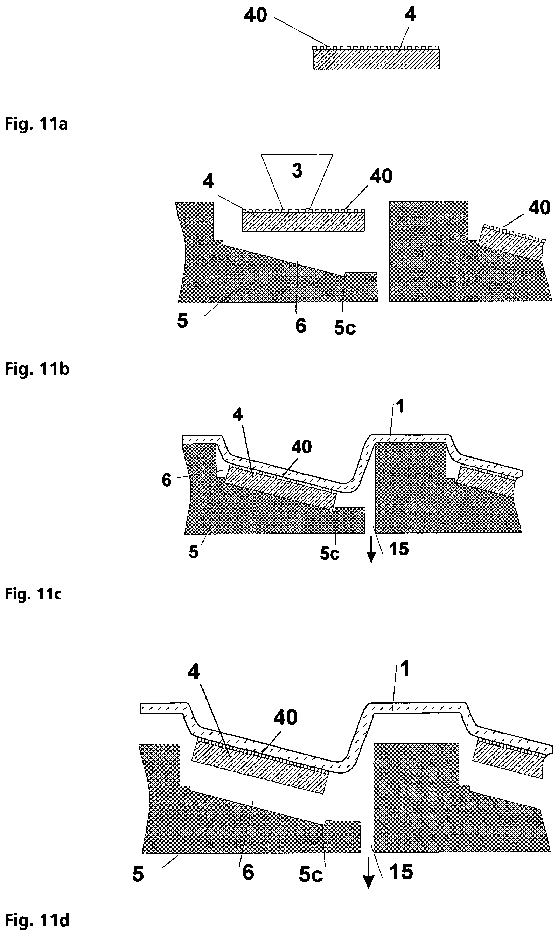

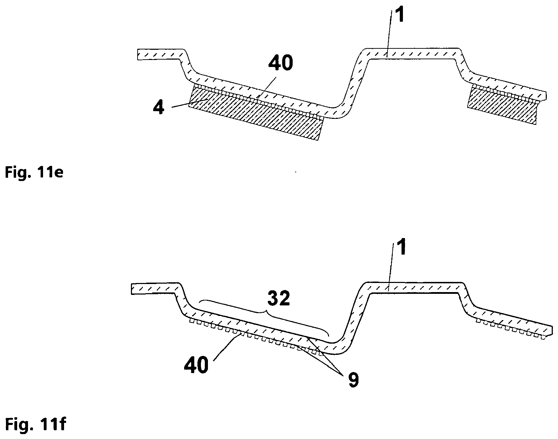

Die Prozessvariante nach Fig. 11 zeigt die Herstellung eines Deckels 22 mit verschoben und geneigt ausgeführten optischen Fenstern 32, die einseitig mit Mottenaugenstrukturen 40 als funktionale Oberflächenstruktur versehen sind.

Dabei werden die Verstärkungselemente 4 aus Silizium vor dem Anordnen auf dem zweiten Substrat 5 auf der Seite, die beim Erwärmen und Verformen mit dem Glaswafer 1 in Kontakt gebracht wird, mit einer Siliziumdioxidschicht versehen. Die Siliziumdioxidschicht wird derart strukturiert, dass im Ergebnis die Verstärkungselemente 4 Mottenaugenstrukturen 40 aus Siliziumdioxid aufweisen (Fig. 11a).

Die Verstärkungselemente 4 werden im Weiteren mittels Vakuumhandler 3 auf dem zweiten Substrat 5 angeordnet (Fig. 11b), so dass die Seite der Verstärkungselemente 4, die mit den Mottenaugenstrukturen 40 versehen ist, nach dem Anordnen des Glaswafers 1 auf dem zweiten Substrat 5 dem Glaswafer 1 zugewandt ist.

Durch das Erwärmen und Verformen wird der Glaswafer 1 mit den Verstärkungselementen 4 beziehungsweise den Mottenaugenstrukturen 40 in Kontakt gebracht (Fig. 11c), wobei auf Grund der Prozesstemperaturen ein thermischer Bondprozess eine stoffschlüssige Verbindung zwischen Mottenaugenstrukturen 40 und Glaswafer 1 bedingt.

Nach Trennen des strukturierten Glaswafers 1 vom zweiten Substrat 5 (Fig. 11d) wird das Silizium der Verstärkungselemente 4 entfernt, wodurch ein Deckel 22 entsteht, dessen verschoben und geneigt ausgeführte Fenster 32 zumindest auf einer der Transmissionsflächen 9 mit Mottenaugenstrukturen 40 versehenen sind (Fig. 11f). In Anlehnung an die vorher beschriebenen Prozessvarianten können auch Fenster 8, 30, 32 hergestellt werden, bei denen beide Transmissionsflächen 9 mit Mottenaugenstrukturen versehen sind.

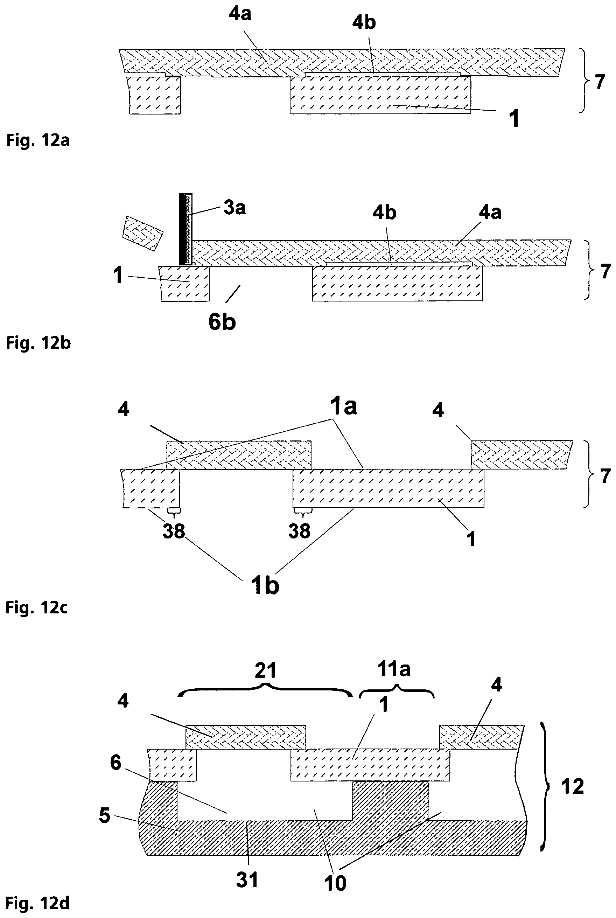

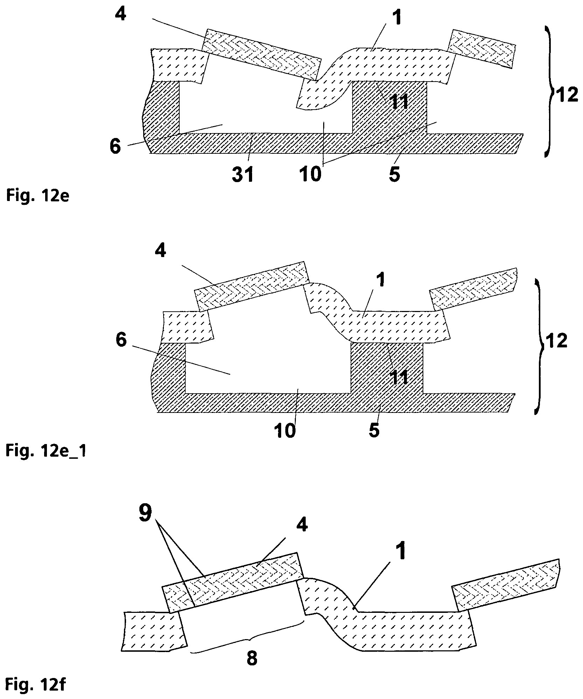

Die Prozessvariante nach Fig. 12 zeigt die Herstellung eines nicht einstückig ausgeführten Deckels 22 mit geneigten optischen Fenstern 8.

Ausgangspunkt bildet ein Glaswafer 1 aus Borsilikatglas, der mit Durchführungen 6b versehen wird. Die Durchführungen 6b können mittels Bohrens (z.B. Ultraschall-, Laserbohren) erzeugt werden. Im Weiteren wird der Glaswafer 1 mit einem Verstärkungssubstrat 4a aus hochtemperaturfestem bzw. höher schmelzenden Glas (z.B. Corning Eagle XG®, Corning Lotus Glas®, Schott AF32®) durch einen thermischen Bondprozess verbunden. Alternativ kann die Verbindung auch durch einen anodischen Bondprozess hergestellt werden, wobei in diesem Fall auf der mit dem Glaswafer 1 zu verbindenden Seite des Verstärkungssubstrats 4a vor dem Verbindungsschritt eine Siliziumschicht abgeschieden wird. Nach dem anodischen Bonden wird diese Siliziumschicht in den Bereichen des Verstärkungssubstrats 4a, die als optische Fenster fungieren sollen, entfernt (z.B. mittels naßchemischen Ätzens).

Beide Substratseiten des Verstärkungssubstrats 4a sind poliert und planparallel ausgeführt. Zudem weist das Verstärkungssubstrat 4a zweite Vertiefungen 4b auf, die beim folgenden Sägeschritt zur Erzeugung der Verstärkungselemente 4 einen Kontakt der Säge 3a mit dem Glaswafer 1 verhindern (Fig. 12b). Alternativ können die Verstärkungselemente 4 vor dem Anordnen auf dem Glaswafer 1 erzeugt (z.B. durch Sägen) und dann auf dem Glaswafer 1 mittels Vakuumhandler 3 angeordnet werden. Der Basisstapel 7 aus Glaswafer 1 und Verstärkungselementen 4 wird auf einem zweiten Substrat 5 aus Graphit, welches dritte Vertiefungen 6 aufweist, angeordnet (Fig. 12d). Beim Erwärmen und Verformen werden auf Grund der Druckdifferenz zwischen dem Druck in den Hohlräumen 10 und dem Umgebungsdruck ein Verschieben und/oder Neigen der abgedeckten Bereiche 38 des Glaswafers 1 begünstigt.

Da die Verstärkungselemente 4 aus einem höherschmelzenden Glas bestehen als der Glaswafer 1, bleibt ihre Form und ihre Struktur während des Erwärmen und Verformens erhalten. Da die Substratseiten des Verstärkungssubstrats 4a planparallel und poliert ausgeführt sind, verbleiben die Verstärkungselemente 4 auf dem Glaswafer 1 und fungieren als geneigte optische Fenster 8, deren Transmissionsflächen 9 eine hohe Oberflächenqualität, insbesondere eine geringe Ebenheitsabweichung und Rauigkeit, aufweisen.

### Bezugszeichenliste

- 1: erstes Substrat z.B. Glaswafer
- 1a: erste Substratebene bzw. Substratseite des ersten Substrats
- 1b: zweite Substratebene bzw. Substratseite des ersten Substrats
- 1c: erste Vertiefung im ersten Substrat
- 2: Aufnahmesubstrat
- 3: Vakuumhandler
- 3a: Säge
- 4: Verstärkungselement bzw. weiteres Verstärkungselement
- 4a: Verstärkungssubstrat bzw. Verstärkungsschicht
- 4b: zweite Vertiefung im Verstärkungssubstrat bzw. in der Verstärkungsschicht
- 5: zweites Substrat z.B. Siliziumwafer
- 5a: weiteres zweites Substrat
- 5b: Justiervertiefung im ersten Substrat
- 5c: Justiervertiefung im zweiten Substrat
- 6: dritte Vertiefung im zweiten Substrat
- 6b: Durchführung im ersten Substrat
- 7: Basisstapel bzw. weiterer Basisstapel
- 7a: Grundstapel
- 8: geneigtes optisches Fenster
- 9: Transmissionsfläche des optischen Fensters
- 10: Hohlraum zwischen Basisstapel und zweiten Substrat oder ersten Substrat/weiterer Basisstapel und Grundstapel
- 11: Auflagefläche
- 11a: Auflagebereich
- 12: Schichtsystem aus Basisstapel und zweiten Substrat oder ersten Substrat/weiterer Basisstapel und Grundstapel
- 13: Auflagestruktur
- 14: Gegenkontaktfläche des zweiten Substrats
- 15: Kanal im zweiten Substrat z.B. als Anschluss für eine Vakuumpumpe
- 16: Fixierungselement
- 17: Aufnahmenut im zweiten Substrat
- 18: Formgebungsvorrichtung
- 19: Stempelelement z.B. mit gerader oder schräger Stempelfläche
- 20: Anschlagstruktur
- 21: Auslenkungsbereich
- 22: Deckel
- 23: Kontaktfläche des Deckels
- 24: Trägersubstrat
- 25: Mikrospiegel
- 26: Aufhängung des Mikrospiegels
- 27: Kontaktpad
- 28: einfallende Strahlung
- 29: abgelenkte Strahlung
- 30: verschobenes optisches Fenster
- 31: Boden der dritten Vertiefung im zweiten Substrat
- 32: verschoben und geneigt ausgeführtes optisches Fenster
- 34: Deckeleinheit
- 36: Begrenzungsfläche des Aufnahmesubstrats
- 37: Aufnahmevertiefung
- 38: abgedeckter Bereich des ersten Substrats
- 40: Mottenaugenstruktur

## Patentansprüche

1. Verfahren zur Herstellung optischer Komponenten mit den folgenden Schritten:
- Bereitstellen eines ersten Substrats (1) und eines zweiten Substrats (5),
- Bereitstellen mehrerer Verstärkungselemente (4) durch Abtrennen von einem oder mehreren Verstärkungssubstraten (4a),
- Erzeugen eines Stapels (7) durch Anordnen der Verstärkungselemente (4) auf dem ersten Substrat (1), wodurch jedes Verstärkungselement (4) einen Bereich des ersten Substrats (1) abdeckt, wobei das Anordnen eines Verstärkungselements (4) nach dem Bereitstellen des jeweiligen Verstärkungselements (4) erfolgt,
- in Kontakt bringen des zweiten Substrats (5) mit dem Stapel (7),
- Erwärmen und Verformen des ersten Substrats (1) derart, dass sich zumindest ein Teil des durch das jeweilige Verstärkungselement (4) abgedeckten Bereichs des ersten Substrats (1) verschiebt und/oder neigt.

2. Verfahren zur Herstellung optischer Komponenten mit den folgenden Schritten:
- Bereitstellen eines ersten Substrats (1) und eines zweiten Substrats (5),
- Bereitstellen mindestens eines Verstärkungselements (4) durch Abtrennen von einem Verstärkungssubstrat (4a),
- Erzeugen eines Stapels (7a) durch Anordnen des mindestens einen Verstärkungselements (4) auf dem zweiten Substrat (5),
- in Kontakt bringen des ersten Substrats (1) mit dem Stapel (7a) derart, dass zumindest ein Teil des Verstärkungselements beabstandet zum ersten Substrat angeordnet wird,
- Erwärmen und Verformen des ersten Substrats (1) derart, dass ein Bereich des ersten Substrats (1) mit dem mindestens einen Verstärkungselement (4) in Kontakt gebracht wird.

3. Verfahren nach Anspruch 2, **dadurch gekennzeichnet, dass** das bereitgestellte erste Substrat (1) ein weiteres Verstärkungselement (4) aufweist, wobei das weitere Verstärkungselement (4) einen Bereich des ersten Substrats (1) abdeckt und das erste Substrat (1) und das weitere Verstärkungselement (4) einen weiteren Stapel (7) bilden, der beim Schritt des Inkontaktbringens mit dem Stapel (7a) aus Verstärkungselement (4) und zweitem Substrat (5) in Kontakt gebracht wird,
und wobei das Erwärmen und Verformen des ersten Substrats (1) zudem derart erfolgt, dass sich zumindest ein Teil des durch das weitere Verstärkungselement (4) abgedeckten Bereichs des ersten Substrats (1) verschiebt und/oder neigt,
und/oder dass ein Bereich des ersten Substrats (1) mit dem weiteren Verstärkungselement (4) in Kontakt gebracht wird.

4. Verfahren nach Anspruch 3, **dadurch gekennzeichnet, dass** das Bereitstellen des ersten Substrats (1) mit dem weiteren Verstärkungselement (4) derart erfolgt, dass das weitere Verstärkungselement (4) durch Abtrennen von einem Verstärkungssubstrat (4a) bereitgestellt und auf dem ersten Substrat (1) angeordnet wird und/oder dass auf dem ersten Substrat (1) eine Verstärkungsschicht (4a) aufgebracht wird, die zur Erzeugung des weiteren Verstärkungselements (4) strukturiert wird.

5. Verfahren nach einem der Ansprüche 2 bis 4, **dadurch gekennzeichnet, dass** das Erzeugen des Stapels (7a) und dessen Inkontaktbringen mit dem weiteren Stapel (7) beziehungsweise dem ersten Substrat (1) derart erfolgt, dass das mindestens eine Verstärkungselement (4) zumindest teilweise zwischen dem ersten (1) und dem zweiten Substrat (5), insbesondere zumindest teilweise auf der dem ersten Substrat (1) zugewandten Substratseite des zweiten Substrats (5), angeordnet wird.

6. Verfahren nach einem der vorhergehenden Ansprüche, **dadurch gekennzeichnet, dass** das erste Substrat (1) zumindest in Teilbereichen Glas, bevorzugt ein Silikatglas, besonders bevorzugt Borsilikatglas, und/oder ein glasähnliches Material enthält oder daraus besteht.

7. Verfahren nach einem der vorhergehenden Ansprüche, **dadurch gekennzeichnet, dass** das Verstärkungssubstrat (4a), das mindestens eine Verstärkungselement (4) und/oder das weitere Verstärkungselement (4) zumindest in Teilbereichen ein halbleitendes Material, insbesondere Silizium, enthält oder daraus besteht.

8. Verfahren nach einem der vorhergehenden Ansprüche, **dadurch gekennzeichnet, dass** das mindestens eine Verstärkungselement (4) und/oder das weitere Verstärkungselement (4), insbesondere ein Oberflächenbereich des mindestens einen Verstärkungselements (4) und/oder des weiteren Verstärkungselements (4), der mit dem ersten Substrat in Kontakt gebracht wird, eine quadratische Oberflächenrauigkeit kleiner gleich 25 nm, bevorzugt kleiner gleich 15 nm, besonders bevorzugt kleiner gleich 5 nm, und/oder eine Ebenheitsabweichung kleiner gleich 180 nm, insbesondere kleiner gleich 110 nm, aufweist.

9. Verfahren nach einem der vorhergehenden Ansprüche, **dadurch gekennzeichnet, dass** das mindestens eine Verstärkungselement (4) und/oder das weitere Verstärkungselement (4) vor dem Anordnen auf dem ersten (1) und/oder zweiten Substrat (5) auf einem Positionierungsmittel (2), insbesondere einem Aufnahmesubstrat (2), angeordnet wird.

10. Verfahren nach einem der vorhergehenden Ansprüche, **dadurch gekennzeichnet, dass** das mindestens eine Verstärkungselement (4) und/oder das weitere Verstärkungselement (4) mindestens ein Fixierungselement (16) aufweist, das, insbesondere nach dem Inkontaktbringen des Stapels (7a) mit dem weiteren Stapel (7) oder des Stapels (7, 7a) mit dem nicht vom Stapel (7, 7a) umfassten Substrat (1, 5), ein Verschieben und/oder Verdrehen des mindestens einen Verstärkungselements (4) und/oder des weiteren Verstärkungselements (4) gegenüber dem ersten Substrat (1) und/oder gegenüber dem zweiten Substrat (5) reduziert oder verhindert.

11. Verfahren nach einem der vorhergehenden Ansprüche, **dadurch gekennzeichnet, dass** ein oder mehrere Auflagestrukturen (13) erzeugt werden, wobei die Erzeugung der Auflagestruktur (13) derart erfolgt, dass die Auflagestruktur (13) den Auflagebereich (11a) des ersten Substrats (1) schützt und/oder als Abstandshalter zwischen dem ersten Substrat (1) und dem zweiten Substrat (5) fungiert.

12. Verfahren nach einem der vorhergehenden Ansprüche, **dadurch gekennzeichnet, dass** auf jeder der beiden Substratseiten (1a, 1b) des ersten Substrats (1) mindestens ein Verstärkungselement (4) angeordnet wird.

13. Verfahren nacheinem der vorhergehenden Ansprüche, **dadurch gekennzeichnet, dass** das Anordnen des mindestens einen Verstärkungselements (4) auf dem ersten (1) und/oder dem zweiten Substrat (5) und/oder das Anordnen des weiteren Verstärkungselements (4) auf dem ersten Substrat (1) durch anodisches Bonden, direktes Bondes, plasma-aktiviertes Bonden und/oder thermisches Bonden erfolgt und/oder dass zumindest Teilbereiche der durch das Erwärmen und Verformen miteinander in Kontakt gebrachten Bereiche des ersten Substrats (1) und des Verstärkungselements (4) und/oder des weiteren Verstärkungselements (4) durch thermisches Bonden miteinander verbunden werden.

14. Verfahren nach einem der vorhergehenden Ansprüche, **dadurch gekennzeichnet, dass** das mindestens eine Verstärkungselement (4) und/oder das weitere Verstärkungselement (4) nach dem Verformen zumindest teilweise entfernt wird, insbesondere dass das Entfernen des mindestens einen Verstärkungselements (4) und/oder des weiteren Verstärkungselements (4) derart erfolgt, dass das mindestens eine Verstärkungselement (4) und/oder das weitere Verstärkungselement (4) wiederverwendbar ist.

15. Verfahren nach Anspruch 14, **dadurch gekennzeichnet, dass** das mindestens eine Verstärkungselement (4) und/oder das weitere Verstärkungselement (4) zumindest in dem Bereich, der mit dem ersten Substrat (1) in Kontakt gebracht wird, eine Opferschicht aufweist, die nach dem Verformen des ersten Substrats (1) zur Freigabe des Verstärkungselements (4) und/oder des weiteren Verstärkungselements (4) entfernt wird.

16. Verfahren nach einem der vorhergehenden Ansprüche, **dadurch gekennzeichnet, dass** das erste Substrat (1) zumindest in Teilbereichen mit mindestens einer Veredlungsbeschichtung, insbesondere mit einer Entspiegelungsbeschichtung, einer Antistatik-Beschichtung, einer Reflexionsbeschichtung und/oder einer Absorbtionsbeschichtung, und/oder funktionalen Oberflächenstrukturen, insbesondere Mottenaugenstrukturen (40), versehen wird.

17. Verfahren nach Anspruch 16, **dadurch gekennzeichnet, dass** als funktionale Oberflächenstruktur Mottenaugenstrukturen (40) derart erzeugt werden, dass vor dem Anordnen und/oder dem Inkontaktbringen des mindestens einen Verstärkungselements (4) und/oder des weiteren Verstärkungselements (4) auf/mit dem ersten Substrat (1) zumindest der Bereich des mindestens einen Verstärkungselements (4) und/oder des weiteren Verstärkungselements (4), der mit dem ersten Substrat (1) in Kontakt gebracht wird, mit einer Negativform der Mottenaugenstrukturen (40) versehen wird und nach dem Anordnen und/oder dem Inkontaktbringen des mindestens einen Verstärkungselements (4) und/oder des weiteren Verstärkungselements (4) auf/mit dem ersten Substrat (1) während der Formgebung des ersten Substrats (1) die Mottenaugenstrukturen (40) auf der ersten und/oder zweiten Substratseite (1a, 1b) des ersten Substrats (1) erzeugt werden, indem die Negativform in dem mindestens einen Verstärkungselement (4) und/oder dem weiteren Verstärkungselement (4) auf die erste und/oder zweite Substratseite (1a, 1b) des ersten Substrats (1), insbesondere auf die Transmissionsflächen (9) der optischen Fenster (8, 30, 32), abgeformt wird.

18. Verfahren nach einem der Ansprüche 16 bis 17, **dadurch gekennzeichnet, dass** die Veredlungsbeschichtung derart erzeugt wird, dass vor dem Anordnen und/oder dem Inkontaktbringen des mindestens einen Verstärkungselements (4) und/oder des weiteren Verstärkungselements (4) auf/mit dem ersten Substrat (1) zumindest der Bereich des mindestens einen Verstärkungselements (4) und/oder des weiteren Verstärkungselements (4), der mit dem ersten Substrat (1) in Kontakt gebracht wird, mit der Veredlungsbeschichtung versehen wird und anschließend eine Verbindung zwischen dem ersten Substrat (1) und dem mindestens einen Verstärkungselements (4) und/oder dem weiteren Verstärkungselements (4) durch eine Verbindung zwischen der Veredlungsbeschichtung und dem ersten Substrat (1) hergestellt wird oder dass vor dem Anordnen und/oder dem Inkontaktbringen des mindestens einen Verstärkungselements (4) und/oder des weiteren Verstärkungselements (4) auf/mit dem ersten Substrat (1) die Veredlungsbeschichtung auf das erste Substrat (1) aufgebracht wird und anschließend das mindestens eine Verstärkungselement (4) und/oder das weitere Verstärkungselement (4) auf/mit der Veredlungsbeschichtung angeordnet und/oder in Kontakt gebracht wird, wobei nach dem Verformungsschritt das mindestens eine Verstärkungselement (4) und/oder das weitere Verstärkungselement (4) zumindest teilweise entfernt wird und die Veredlungsbeschichtung auf dem ersten Substrat (1), insbesondere auf den optischen Fenstern (8, 30, 32), verbleibt.

19. Verfahren zur Herstellung optischer Komponenten mit den folgenden Schritten:
- Bereitstellen eines ersten Substrats (1) und eines zweiten Substrats (5),
- Bereitstellen mindestens eines Verstärkungselements (4) durch Abtrennen von einem Verstärkungssubstrat (4a),
- Erzeugen eines Stapels (7) durch Anordnen des mindestens einen Verstärkungselements (4) auf dem ersten Substrat (1) derart, dass das Verstärkungselement (4) einen Bereich des ersten Substrats (1) abdeckt und dass zumindest ein Teil des Verstärkungselements beabstandet zum ersten Substrat angeordnet wird,
- in Kontakt bringen des zweiten Substrats (5) mit dem Stapel (7),
- Erwärmen und Verformen des ersten Substrats (1) derart, dass ein Bereich des ersten Substrats (1) mit dem beabstandet angeordneten Teil des mindestens einen Verstärkungselements (4) in Kontakt gebracht wird.

## Claims

1. Method for producing optical components having the following steps:
- providing a first substrate (1) and a second substrate (5),
- providing a plurality of reinforcing elements (4) by detaching them from one or more reinforcing substrates (4a),
- generating a stack (7) by arranging the reinforcing elements (4) on the first substrate (1), whereby each reinforcing element (4) covers a region of the first substrate (1), a reinforcing element (4) being arranged following the provision of the respective reinforcing element (4),
- bringing the second substrate (5) into contact with the stack (7),
- heating and deforming the first substrate (1) such that at least a part of the region of the first substrate (1) covered by the respective reinforcing element (4) is displaced and/or inclined.

2. Method for producing optical components having the following steps:
- providing a first substrate (1) and a second substrate (5),
- providing at least one reinforcing element (4) by detaching it from a reinforcing substrate (4a),
- generating a stack (7a) by arranging the at least one reinforcing element (4) on the second substrate (5),
- bringing the first substrate (1) into contact with the stack (7a) such that at least a part of the reinforcing element is arranged at a distance from the first substrate,
- heating and deforming the first substrate (1) such that a region of the first substrate (1) is brought into contact with the at least one reinforcing element (4).

3. Method according to Claim 2, **characterized in that** the provided first substrate (1) has a further reinforcing element (4), wherein the further reinforcing element (4) covers a region of the first substrate (1) and the first substrate (1) and the further reinforcing element (4) form a further stack (7), which is brought into contact with the stack (7a) made of reinforcing element (4) and second substrate (5) during the step of bringing into contact,
and wherein the heating and deforming of the first substrate (1) are additionally performed such that at least a part of the region of the first substrate (1) covered by the further reinforcing element (4) is displaced and/or inclined,
and/or that a region of the first substrate (1) is brought into contact with the further reinforcing element (4).

4. Method according to Claim 3, **characterized in that** the provision of the first substrate (1) with the further reinforcing element (4) is performed such that the further reinforcing element (4) is provided by detaching it from a reinforcing substrate (4a) and is arranged on the first substrate (1) and/or that a reinforcing layer (4a) is applied to the first substrate (1), which is structured to generate the further reinforcing element (4) .

5. Method according to any one of Claims 2 to 4, **characterized in that** the generation of the stack (7a) and its bringing into contact with the further stack (7) and the first substrate (1), respectively, are performed such that the at least one reinforcing element (4) is at least partially arranged between the first substrate (1) and the second substrate (5), in particular at least partially on the substrate side of the second substrate (5) facing toward the first substrate (1).

6. Method according to any one of the preceding claims, **characterized in that** the first substrate (1) contains or consists at least in partial regions of glass, preferably a silicate glass, particularly preferably borosilicate glass, and/or a glasslike material.

7. Method according to any one of the preceding claims, **characterized in that** the reinforcing substrate (4a), the at least one reinforcing element (4) and/or the further reinforcing element (4) contain or consist at least in partial regions of a semiconductive material, in particular silicon.

8. Method according to any one of the preceding claims, **characterized in that** the at least one reinforcing element (4) and/or the further reinforcing element (4), in particular a surface region of the at least one reinforcing element (4) and/or the further reinforcing element (4), which is brought into contact with the first substrate, has an RMS surface roughness less than or equal to 25 nm, preferably less than or equal to 15 nm, particularly preferably less than or equal to 5 nm, and/or a flatness deviation less than or equal to 180 nm, in particular less than or equal to 110 nm.

9. Method according to any one of the preceding claims, **characterized in that** the at least one reinforcing element (4) and/or the further reinforcing element (4) is arranged on a positioning means (2), in particular a receptacle substrate (2), before the arrangement on the first substrate (1) and/or second substrate (5).

10. Method according to any one of the preceding claims, **characterized in that** the at least one reinforcing element (4) and/or the further reinforcing element (4) has at least one fixing element (16) which, in particular after the stack (7a) is brought into contact with the further stack (7) or the stack (7, 7a) is brought into contact with the substrate (1, 5) not comprised by the stack (7, 7a), reduces or prevents displacement and/or twisting of the at least one reinforcing element (4) and/or the further reinforcing element (4) in relation to the first substrate (1) and/or in relation to the second substrate (5).

11. Method according to any one of the preceding claims, **characterized in that** one or more support structures (13) are generated, wherein the generation of the support structure (13) is performed such that the support structure (13) protects the support region (11a) of the first substrate (1) and/or functions as a spacer between the first substrate (1) and the second substrate (5).

12. Method according to any one of the preceding claims, **characterized in that** at least one reinforcing element (4) is arranged on each of the two substrate sides (1a, 1b) of the first substrate (1).

13. Method according to any one of the preceding claims, **characterized in that** the arrangement of the at least one reinforcing element (4) on the first substrate (1) and/or the second substrate (5) and/or the arrangement of the further reinforcing element (4) on the first substrate (1) is performed by anodic bonding, direct bonding, plasma-activated bonding and/or thermal bonding, and/or in that at least partial regions of the regions of the first substrate (1) and the reinforcing element (4) and/or the further reinforcing element (4) brought into contact with one another by the heating and deforming are connected to one another by thermal bonding.

14. Method according to any one of the preceding claims, **characterized in that** the at least one reinforcing element (4) and/or the further reinforcing element (4) is at least partially removed after the deforming, in particular **in that** the removal of the at least one reinforcing element (4) and/or the further reinforcing element (4) is performed such that the at least one reinforcing element (4) and/or the further reinforcing element (4) is reusable.

15. Method according to Claim 14, **characterized in that** the at least one reinforcing element (4) and/or the further reinforcing element (4), at least in the region which is brought into contact with the first substrate (1), has a sacrificial layer, which is removed after the deformation of the first substrate (1) to release the reinforcing element (4) and/or the further reinforcing element (4).

16. Method according to any one of the preceding claims, **characterized in that** the first substrate (1) is provided at least in partial regions with at least one finishing coating, in particular with an antireflective coating, an antistatic coating, a reflective coating and/or an absorption coating, and/or functional surface structures, in particular moth-eye structures (40).

17. Method according to Claim 16, **characterized in that** moth-eye structures (40) are generated as the functional surface structure such that, before the arrangement and/or the bringing into contact of the at least one reinforcing element (4) and/or the further reinforcing element (4) on/with the first substrate (1), at least the region of the at least one reinforcing element (4) and/or the further reinforcing element (4), which is brought into contact with the first substrate (1), is provided with a negative mould of the moth-eye structures (40) and, after the arrangement and/or the bringing into contact of the at least one reinforcing element (4) and/or the further reinforcing element (4) on/with the first substrate (1) during the shaping of the first substrate (1), the moth-eye structures (40) are generated on the first and/or second substrate side (1a, 1b) of the first substrate (1), **in that** the negative mould in the at least one reinforcing element (4) and/or the further reinforcing element (4) is moulded on the first and/or second substrate side (1a, 1b) of the first substrate (1), in particular on the transmission surfaces (9) of the optical windows (8, 30, 32).

18. Method according to either one of Claims 16 and 17, **characterized in that** the finishing coating is generated such that, before the arrangement and/or the bringing into contact of the at least one reinforcing element (4) and/or the further reinforcing element (4) on/with the first substrate (1), at least the region of the at least one reinforcing element (4) and/or the further reinforcing element (4), which is brought into contact with the first substrate (1), is provided with the finishing coating and subsequently a connection is produced between the first substrate (1) and the at least one reinforcing element (4) and/or the further reinforcing element (4) by a connection between the finishing coating and the first substrate (1), or that, before the arrangement and/or the bringing into contact of the at least one reinforcing element (4) and/or the further reinforcing element (4) on/with the first substrate (1), the finishing coating is applied to the first substrate (1) and subsequently the at least one reinforcing element (4) and/or the further reinforcing element (4) is arranged and/or brought into contact on/with the finishing coating, wherein, after the deformation step, the at least one reinforcing element (4) and/or the further reinforcing element (4) is at least partially removed and the finishing coating remains on the first substrate (1), in particular on the optical windows (8, 30, 32).

19. Method for producing optical components having the following steps:
- providing a first substrate (1) and a second substrate (5),
- providing at least one reinforcing element (4) by detaching it from a reinforcing substrate (4a),
- generating a stack (7) by arranging the at least one reinforcing element (4) on the first substrate (1) such that the reinforcing element (4) covers a region of the first substrate (1) and that at least a part of the reinforcing element is arranged at a distance from the first substrate,
- bringing the second substrate (5) into contact with the stack (7),
- heating and deforming the first substrate (1) such that a region of the first substrate (1) is brought into contact with the part of the at least one reinforcing element (4) arranged at a distance.

## Revendications

1. Procédé de fabrication de composants optiques, ledit procédé comprenant les étapes suivantes :
- fournir un premier substrat (1) et un deuxième substrat (5),
- fournir une pluralité d'éléments de renfort (4) par séparation d'un ou plusieurs substrats de renfort (4a),
- générer un empilement (7) par disposition des éléments de renfort (4) sur le premier substrat (1), chaque élément de renfort (4) recouvrant une zone du premier substrat (1), la disposition d'un élément de renfort (4) étant effectuée après fourniture de l'élément de renfort respectif (4),
- mettre le deuxième substrat (5) en contact avec l'empilement (7),
- chauffer et/ou déformer le premier substrat (1) de manière à déplacer ou incliner au moins une partie de la zone du premier substrat (1) recouverte par l'élément de renfort respectif (4).

2. Procédé de fabrication de composants optiques, ledit procédé comprenant les étapes suivantes :
- fournir un premier substrat (1) et un deuxième substrat (5),
- fournir au moins un élément de renfort (4) par séparation d'un substrat de renfort (4a),
- générer un empilement (7a) par disposition de l'au moins un élément de renfort (4) sur le deuxième substrat (5),
- mettre le premier substrat (1) en contact avec l'empilement (7a) de manière à disposer au moins une partie de l'élément de renfort à distance du premier substrat,
- chauffer et déformer le premier substrat (1) de manière à mettre une région du premier substrat (1) en contact avec l'au moins un élément de renfort (4).

3. Procédé selon la revendication 2, **caractérisé en ce que** le premier substrat fourni (1) comporte un autre élément de renfort (4), l'autre élément de renfort (4) recouvrant une zone du premier substrat (1) et le premier substrat (1) et l'autre élément de renfort (4) formant un autre empilement (7) qui, pendant l'étape de mise en contact, est mis en contact avec l'empilement (7a) formé de l'élément de renfort (4) et du deuxième substrat (5),
et le chauffage et la déformation du premier substrat (1) étant également effectués de manière à déplacer et/ou incliner au moins une partie de la zone du premier substrat (1) qui est recouverte par l'autre élément de renfort (4),
et/ou **en ce qu'**une zone du premier substrat (1) est mise en contact avec l'autre élément de renfort (4).

4. Procédé selon la revendication 3, **caractérisé en ce que** la fourniture du premier substrat (1) pourvu de l'autre élément de renfort (4) est effectuée de manière à fournir l'autre élément de renfort (4) par séparation d'un substrat de renfort (4a) et à le disposer sur le premier substrat (1) et/ou **en ce qu'**une couche de renfort (4a), qui est structurée de manière à générer l'autre élément de renfort (4), est appliquée sur le premier substrat (1).

5. Procédé selon l'une des revendications 2 à 4, **caractérisé en ce que** la génération de l'empilement (7a) et la mise en contact de celui-ci avec l'autre empilement (7) ou le premier substrat (1) sont effectuées de manière à disposer l'au moins un élément de renfort (4) au moins partiellement entre le premier substrat (1) et le deuxième substrat (5), en particulier au moins partiellement du côté substrat du deuxième substrat (5) dirigé vers le premier substrat (1) .

6. Procédé selon l'une des revendications précédentes, **caractérisé en ce que** le premier substrat (1) contient du verre, ou est en verre, de préférence un verre au silicate, de manière particulièrement préférée un verre borosilicaté, et/ou un matériau semblable au verre, au moins dans des zones partielles.

7. Procédé selon l'une des revendications précédentes, **caractérisé en ce que** le substrat de renfort (4a), l'au moins un élément de renfort (4) et/ou l'autre élément de renfort (4), contiennent un matériau semi-conducteur, ou sont en matériau semi-conducteur, en particulier du silicium, au moins dans des zones partielles.

8. Procédé selon l'une des revendications précédentes, **caractérisé en ce que** l'au moins un élément de renfort (4) et/ou l'autre élément de renfort (4), en particulier une zone de surface de l'au moins un élément de renfort (4) et/ou de l'autre élément de renfort (4), qui est mise en contact avec le premier substrat, présentent une rugosité de surface moyenne quadratique inférieure ou égale à 25 nm, de préférence inférieure ou égale à 15 nm, de manière particulièrement préférée inférieure ou égale à 5 nm, et/ou un écart de planéité inférieur ou égal à 180 nm, notamment inférieur ou égal à 110 nm.

9. Procédé selon l'une des revendications précédentes, **caractérisé en ce que** l'au moins un élément de renfort (4) et/ou l'autre élément de renfort (4) est disposé sur un moyen de positionnement (2), en particulier un substrat de réception (2), avant d'être disposé sur le premier deuxième substrat (1) et/ou le deuxième substrat (5).

10. Procédé selon l'une des revendications précédentes, **caractérisé en ce que** l'au moins un élément de renfort (4) et/ou l'autre élément de renfort (4) comporte au moins un élément de fixation (16) qui réduit ou empêche une translation et/ou une rotation de l'au moins un élément de renfort (4) et/ou de l'autre élément de renfort (4) par rapport au premier substrat (1) et/ou par rapport au deuxième substrat (5), en particulier après la mise en contact de l'empilement (7a) avec l'autre empilement (7) ou de l'empilement (7, 7a) avec le substrat (1, 5) non inclus dans l'empilement (7, 7a).

11. Procédé selon l'une des revendications précédentes, **caractérisé en ce qu'**une ou plusieurs structures de support (13) sont générées, la génération de la structure de support (13) étant effectuée de manière à ce que la structure de support (13) protège la zone de support (11a) du premier substrat (1) et/ou serve d'élément d'espacement entre le premier substrat (1) et le deuxième substrat (5).

12. Procédé selon l'une des revendications précédentes, **caractérisé en ce qu'**au moins un élément de renfort (4) est disposé sur chacun des deux côtés de substrat (1a, 1b) du premier substrat (1).

13. Procédé selon l'une des revendications précédentes, **caractérisé en ce que** la disposition de l'au moins un élément de renfort (4) sur le premier substrat (1) et/ou le deuxième substrat (5) et/ou la disposition de l'autre élément de renfort (4) sur le premier substrat (1) sont effectuées par liaison anodique, liaison directe, liaison activée par plasma et/ou liaison thermique et/ou **en ce qu'**au moins des parties des régions du premier substrat (1) et de l'élément de renfort (4) et/ou de l'autre élément de renfort (4), mises en contact les unes avec les autres par chauffage et déformation, sont reliées entre elles par liaison thermique.

14. Procédé selon l'une des revendications précédentes, **caractérisé en ce que** l'au moins un élément de renfort (4) et/ou l'autre élément de renfort (4) est au moins partiellement retiré après la déformation, en particulier **en ce que** le retrait de l'au moins un élément de renfort (4) et/ou de l'autre élément de renfort (4) est effectué de telle sorte que l'au moins un élément de renfort (4) et/ou l'autre élément de renfort (4) peuvent être réutilisés.

15. Procédé selon la revendication 14, **caractérisé en ce que** l'au moins un élément de renfort (4) et/ou l'autre élément de renfort (4) comporte, au moins dans la zone qui est mise en contact avec le premier substrat (1), une couche sacrificielle qui est éliminée après la déformation du premier substrat (1) pour libérer l'élément de renfort (4) et/ou l'autre élément de renfort (4).

16. Procédé selon l'une des revendications précédentes, **caractérisé en ce que** le premier substrat (1) est prévu au moins dans des zones partielles comportant au moins un revêtement de finition, notamment un revêtement antireflet, un revêtement antistatique, un revêtement réfléchissant et/ou un revêtement absorbant, et/ou des structures de surface fonctionnelles, en particulier des structures en œil de mite (40).

17. Procédé selon la revendication 16, **caractérisé en ce que** des structures en œil de mite (40) sont générées comme structure de surface fonctionnelle de manière à ce que, avant la disposition et/ou la mise en contact de l'au moins un élément de renfort (4) et/ou de l'autre élément de renfort (4) sur/avec le premier substrat (1), au moins la zone de l'au moins un élément de renfort (4) et/ou de l'autre élément de renfort (4) qui est mise en contact avec le premier substrat (1) soit pourvue d'une forme négative des structures en œil de mite (40) et, après la disposition et/ou la mise en contact de l'au moins un élément de renfort (4) et/ou de l'autre élément de renfort (4) sur/avec le premier substrat (1) lors de la mise en forme du premier substrat (1), les structures en œil de mite (40) soient générées sur le premier et/ou le deuxième côté (1a, 1b) du premier substrat (1) par modelage de la forme négative dans l'au moins un élément de renfort (4) et/ou l'autre élément de renfort (4) sur le premier et/ou le deuxième côté (1a, 1b) du premier substrat (1), notamment sur les surfaces de transmission (9) des fenêtres optiques (8, 30, 32).

18. Procédé selon l'une des revendications 16 à 17, **caractérisé en ce que** le revêtement de finition est généré de manière à ce que, avant la disposition et/ou la mise en contact de l'au moins un élément de renfort (4) et/ou de l'autre élément de renfort (4) sur/avec le premier substrat (1), au moins la zone de l'au moins un élément de renfort (4) et/ou de l'autre élément de renfort (4) qui est mise en contact avec le premier substrat (1) soit pourvue du revêtement de finition, puis une liaison entre le premier substrat (1) et l'au moins un élément de renfort (4) et/ou l'autre élément de renfort (4) est réalisée par une liaison entre le revêtement de finition et le premier substrat (1) ou **en ce que**, avant la disposition et/ou la mise en contact de l'au moins un élément de renfort (4) et/ou de l'autre élément de renfort (4) sur/avec le premier substrat (1), le revêtement de finition soit appliqué sur le premier substrat (1) puis l'au moins un élément de renfort (4) et/ou l'autre élément de renfort (4) soient disposés et/ou mis en contact sur/avec le revêtement de finition, après l'étape de déformation l'au moins un élément de renfort (4) et/ou l'autre élément de renfort (4) étant au moins partiellement retiré et le revêtement de finition restant sur le premier substrat (1), en particulier sur les fenêtres optiques (8, 30, 32).

19. Procédé de fabrication de composants optiques, ledit procédé comprenant les étapes suivantes :
- fournir un premier substrat (1) et un deuxième substrat (5),
- fournir au moins un élément de renfort (4) par séparation d'un substrat de renfort (4a),
- générer un empilement (7) par disposition de l'au moins un élément de renfort (4) sur le premier substrat (1) de manière à ce que l'élément de renfort (4) recouvre une zone du premier substrat (1) et en ce qu'au moins une partie de l'élément de renfort soit disposée à distance du premier substrat,
- mettre le deuxième substrat (5) en contact avec l'empilement (7),
- chauffer et déformer le premier substrat (1) de manière à ce qu'une zone du premier substrat (1) soit mise en contact avec la partie de l'au moins un élément de renfort (4) qui est disposée à distance.
